# EUROPEAN PATENT SPECIFICATION

(11) **EP 3 642 262 B1**
(45) Date of publication and mention of the grant of the patent: **25.12.2024**
(21) Application number: 18819573.9
(22) Date of filing: 25.06.2018
(51) Int. Cl.: B32B 5/02, B32B 5/26, B32B 7/06, B32B 15/08, B32B 15/14, B32B 15/20, B32B 27/28, C08G 73/10, C08L 79/08, C09D 179/08, H01L 23/00, C09J 179/08

(54) **CURABLE POLYIMIDES**
HÄRTBARE POLYIMIDE
POLYIMIDES DURCISSABLES

(30) Priority: 24.06.2017 US 201762524517 P; 25.06.2017 US 201762524581 P; 25.06.2017 US 201762524584 P; 27.06.2017 US 201762525279 P
(43) Date of publication of application: 29.04.2020
(73) Proprietor: Designer Molecules, Inc., San Diego, CA 92131 (US)
(72) Inventor: MIZORI, Farhad G, San Diego California 92127 (US)
(74) Representative: Murgitroyd & Company
(86) International application number: PCT/US2018/039232
(87) International publication number: WO 2018/237377

(56) References cited:
- JP-A- 2005 316 131
- US-A- 5 612 448
- US-A1- 2004 235 992
- US-A1- 2008 075 961
- US-A1- 2013 035 419
- US-A1- 2013 171 541
- CAO YUANMEI ET AL: "UV-Curable bismaleimides part I: Synthesis and photo-cure kinetics", PROGRESS IN ORGANIC COATINGS, ELSEVIER BV, NL, vol. 100, 5 April 2016 (2016-04-05), pages 118 - 128, XP029775531, ISSN: 0300-9440, DOI: 10.1016/J.PORGCOAT.2016.03.015
- CAO Y ET AL: "UV curable bismaleimides films with functionalized colliodal silica", PROGRESS IN ORGANIC COATINGS, ELSEVIER BV, NL, vol. 100, 23 February 2016 (2016-02-23), pages 153 - 164, XP029775572, ISSN: 0300-9440, DOI: 10.1016/J.PORGCOAT.2016.02.009

## Description

### FIELD OF INVENTION

The present invention relates to thermosetting polymers, adhesive and coating compositions specifically, high molecular weight, flexible polyimide resins functionalized with curable moieties that heat-, UV- and self-cure. Specifically, the invention also relates to hydrophobic, photoimagable polymeric compounds and compositions that can be used for redistribution layers, temporary adhesives, shape memory plastics and in the production of prepregs, copper-clad laminates and printed wiring boards.

### BACKGROUND OF INVENTION

Adhesive compositions are used for a variety of purposes in the fabrication and assembly of semiconductor packages and microelectronic devices. Prominent uses include bonding of electronic elements such as integrated circuit chips to lead frames and other substrates, and bonding of circuit packages or assemblies to printed wire boards.

### Temporary Adhesives

Temporary adhesive tapes and other temporary adhesive compositions are extensively used in wafer backgrinding, wafer dicing and many other processes in electronics fabrication. For temporary applications, adhesives must be fully removable after serving its purpose. However, many of the new processes that are encountered require high temperature stability over 250°C and for these applications the traditional materials are inadequate because they are unstable at very high temperature and can cause voids and delamination.

### Coatings and Packaging

Curable monomers used in adhesive compositions for electronics packaging must be hydrophobic, have low ionic content, high thermal stability, and good mechanical strength. They must also be thermally stable for extended periods of time at temperatures in excess of 250°C, with little or no weight loss that would cause delamination, and as well as being resistant to many solvents.

Often in electronics applications, a clear, non-filled conformal coating is an appropriate way to protect or encapsulate an electronic component. In this type of application, the coating protects delicate wiring that can easily be damaged (e.g. by shock), and/or circuitry that is susceptible to mechanical damage and/or corrosion.

During certain stages in the assembly of electronics components, such as solder reflow, high temperatures are encountered. Similarly, during operation, electronics components generate heat and thus, adhesives and coatings used must be resistant to high temperatures encountered during assembly and operation. Coatings and adhesives used in electronics must also be very hydrophobic to resist and protect against moisture, which can be very destructive.

In certain applications, such as underfilling, materials are required that have a very high glass transition temperature (T_{g}) along with a very low coefficient of thermal expansion (CTE). In other applications, softer materials are required (i.e., with a low T_{g}). Softer materials are generally more useful as conformal coatings because they can withstand shock and remain flexible even at very cold temperatures. Polyimides

Aliphatic, low modulus maleimide-terminated polyimides have high temperature stability (based on dynamic TGA measurements performed in air). These polyimide materials perform well in very short duration (a few seconds) high temperature excursions, such as solder reflow at 260°C. Yet even these short duration exposures, temperatures greater than 200°C can cause maleimide-terminated polyimides materials to lose flexibility, while prolonged exposure leads to thermo-oxidative degradation causing the material to turn black and become brittle. Adding antioxidants can remedy some of these problems, however, a large quantity of antioxidant is required to prevent the effect of thermal degradation and aging and antioxidant leaching can occur.

Maleimide oligomers UV-cure much slower than acrylics. In order to aid the UV-curing without adding large amounts of initiator, it would be useful a UV sensitizer built into the system. A potential solution to the problem of leaching would be to make the antioxidant a part of the polymer itself, that way it could be self-healing without the addition of materials that could be depleted over time or affect neighboring materials and structures.

Polyimides are frequently used in photolithography and photoresists, wafer passivation. Polyimide passivation layers of 4-6 microns in thickness protect delicate thin films of metals and oxides on the chip surface from damage during handling and from induced stress after encapsulation in plastic molding compound. Patterning is simple and straightforward. Because of the low defect density and robust plasma etch resistance inherent with polyimide films, a single mask process can be implemented, which permits the polyimide layer to function both as a stress buffer and as a dry etch mask for an underlying silicon nitride layer. In addition, polyimide layers are readily used for flip-chip bonding applications, including both C-4 and dual-layer bond pad redistribution (BPR) applications. Polyimide layers can also be patterned to form the structural components in microelectromechanical systems (MEMS).

Polyimides may also serve as an interlayer dielectric in both semiconductors and thin film multichip modules (MCM-Ds). The low dielectric constant, low stress, high modulus, and inherent ductility of polyimide films make them well suited for these multiple layer applications. Other uses for polyimides include alignment and/or dielectric layers for displays, and as a structural layers in micro machining. In lithium-ion battery technology, polyimide films can be used as protective layers for PTC thermistor (positive temperature coefficient) controllers.

However, polyimides are difficult to process. They are typically applied as a solution of the corresponding polyamic acid precursors onto a substrate, and then thermally cured to smooth, rigid, intractable films and structural layers. The film can be patterned using a lithographic (photographic) process in conjunction with liquid photoresists. Polyimides formed in situ by imidization through cyclodehydration of the polyamic acid precursors require the evaporation of high boiling point, polar aprotic solvents, which can be difficult to remove. Removal typically requires temperature of >300°C, is sometimes referred to as the "hard bake" step. This process is important, because if the polyimide is not fully imidized the material will absorb a great deal of moisture.

Polyimides have been used as interlayer dielectric materials in microelectronic devices such as integrated circuits (ICs) due dielectric constants lower than that of silicon dioxide. Also, such polyimide materials can serve as planarization layers for ICs as they are generally applied in a liquid form, allowed to level, and subsequently cured. However, thermally cured polyimides, can generate stress, which can lead to delamination and can warp thin wafers.

Existing polyimide materials are generally hydrophilic and usually require tedious multi-step processes to form vias required for electrical interconnects. Moreover, polyimides readily absorb moisture even after curing which can result in device failure when the moisture combined with ionic impurities, causes corrosion. Accordingly, there is a need for hydrophobic, polyimides that are compatible with very thin silicon wafers and will not cause warping of thin silicon wafers.

A need also exists for polyimide films that can be developed easily in photolithography. Generally, photoresists are classified as two types: negative and positive tone. A **"Positive resist"** photoresist becomes soluble in a photoresist developer when exposed to light, while unexposed areas remain insoluble. A **"negative resist"** photoresist becomes insoluble to developer when exposed to light. Negative photoresists are more widely used in electronic due to lower cost, superior adhesion to silicon, and much better chemical resistance. However, negative photoresists are inferior to positive resists in development of fine feature definition.

### Shape Memory Polymers

Many of the same challenges that are encountered in the electronics field are encountered in shape memory polymers or SMPs. SMPs or smart plastics, are high molecular weight materials that have the ability to change from a temporary or deformed shape, back to an original or permanent shape when an external stimulus such as heat is applied. Shape memory polymers are generally characterized as phase-segregated linear block co-polymers having hard segments and soft segments. The hard segments are typically crystalline, with a defined melting point (MP), and the soft segments are typically amorphous, with a defined glass transition temperature (T_{g}). When an SMP is heated above the MP or T_{g} of the hard segment, the material can be shaped, and the shape "memorized" by cooling. When cooled below the MP or T_{g} of the soft segments while the shape is deformed, that (temporary) shape becomes fixed. The original shape is recovered by heating above the MP or T_{g} of the soft segments, but below that of the hard segments. A temporary shape can also set by deforming at a temperature lower than the soft segment MP or T_{g} which absorbs the stress and strain forces. Reheated above the soft segment MP or T_{g}, but below that of the hard segments, relieves the stress and strain and the material returns to its original shape. The temperature-dependent recovery of original shape is called the "thermal shape memory effect". Properties that describe the shape memory capabilities of a material are the shape recovery of the original shape and the shape fixity of the temporary shape. SMPs can readily recover an original molded shape following numerous thermal cycles and can be heated above the MP of the hard segment and reshaped/cooled to fix a new shape.

Other physical properties of SMPs are significantly altered in response to external changes in temperature and stress, particularly at the MP or T_{g} of the soft segments. These properties include the elastic modulus, hardness, flexibility, vapor permeability, damping, index of refraction, and Dk. The elastic modulus (the ratio of the stress in a body to the corresponding strain) of an SMP can change by a factor of up to 200 when heated above the MP or T_{g} of the soft segment. The hardness of the material changes dramatically when the soft segment is at or above its MP or T_{g} and damping ability can be up to five times higher than a conventional rubber product.

Although many SM polymers have been found they are very weak and have very low tensile strength, as well as low T_{g} and very high CTE. Thus, a need exists for very thermally stable, strong, tough shape memory polymers. The ideal material would have good tensile strength, high elongation, relatively high T_{g} and low CTE, with either thermal or UV curing. Preferably, the material would be a hydrophobic, with low Dk and low Df US 2004/235992, JP 2005 316131 and US 2008/075961 are describing polyimides bearing photo-polymerizable groups and which are used in photosensitive resin compositions.

### SUMMARY OF THE INVENTION

The present invention provides a curable polyimide having a structure according to any one of Formulae **IA, IB, IC** and **1D:** 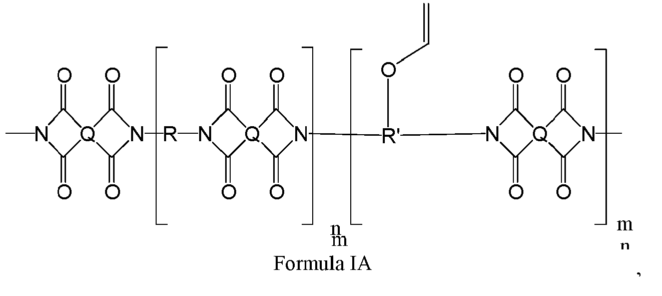 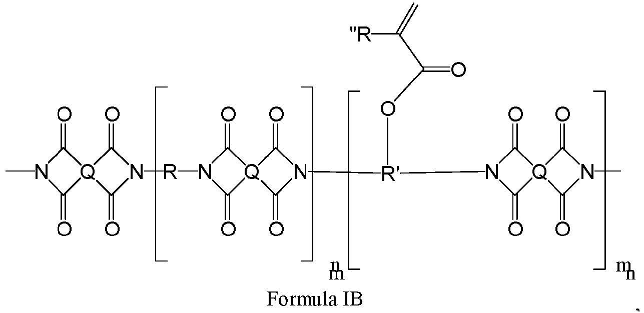 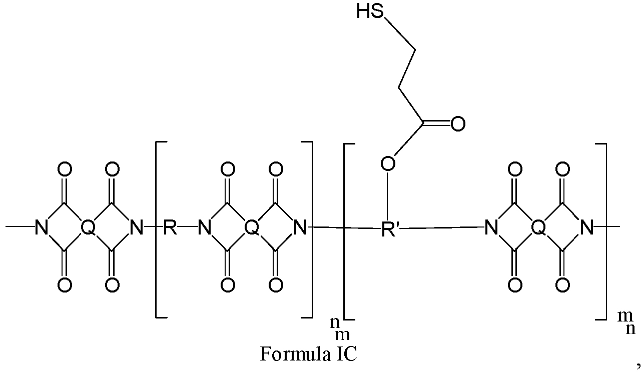 and 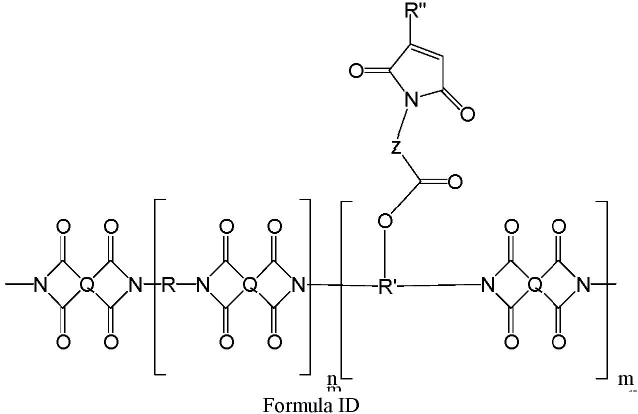 where R is independently a substituted or unsubstituted aliphatic, cycloaliphatic, alkenyl, polyether, polyester, polyamide, aromatic, heteroaromatic, or siloxane moieties; R' is an alcohol functionalized diamine; each Q is independently a substituted or unsubstituted aliphatic, cycloaliphatic, alkenyl, polyether, polyester, polyamide, aromatic, heteroaromatic, or siloxane moiety; each R" is H or methyl; z is independently a substituted or unsubstituted aliphatic or aromatic moiety; and n and m are integers having a value from 10 to about 100, with the proviso the average molecular weight of curable polyimide is greater than 20,000 Daltons. The curable polyimides of formulae **IA, IB, IC** and **ID** are the product of a condensation of diamine(s) with dianhydride(s) followed by functionalizing of the pendant alcohol group, wherein the curable, functionalized polyimide is the product of a condensation of at least one diamine selected from 1,3-diamino-2-propanol and 3,5-diaminobenzyl alcohol, with at least one dianhydride selected from the group consisting of: 4,4'-Bisphenol A dianhydride; pyromellitic dianhydride; 3,3',4,4'-benzophenone tetracarboxylic dianhydride; and 4,4'-oxydiphthalic anhydride, resulting in formation of a pendant alcohol, followed by functionalizing the pendant alcohol group.

The present invention also provides method for synthesizing a high molecular weight polyimide, comprising the steps of: dissolving at least one diamine in a solvent at room temperature; wherein the at least one diamine is selected from 1,3-diamino-2-propanol and 3,5-diaminobenzyl alcohol; adding at least one dianhydride, wherein the total amount of the at least one dianhydride amount is approximately one molar equivalent of the total amount of the at least one diamine; wherein the at least one dianhydride is selected from the group consisting of: 4,4'-Bisphenol A dianhydride; pyromellitic dianhydride; 3,3',4,4-benzophenone tetracarboxylic dianhydride; and 4,4-oxydiphthalic anhydride; slowly heating the mixture to reflux over 1-hour, refluxing the mixture while removing the water for about one to about two hours, or until all the water produced has been removed, wherein the average molecular weight of the polyimide is greater than 20,000 Daltons, wherein the imidized polyimide comprises at least one pendant alcohol moiety and reacting the pendant alcohol to produce a functionalized polyimide with polymerizable pendant moieties. In certain embodiments, the solvent is an aromatic solvent, such as anisole.

The alcohol pendant polyimides can be functionalized by reacting the pendant alcohol groups to produce a functionalized polyimide, which can involve catalyzing the reaction with a polymer-bound acid catalyst and removing the polymer-bound catalyst by filtration.

Diamines contemplated for use in the methods of the invention include but are not limited to dimer diamine; 1,10-diaminodecane; 1,12-diaminododecane; hydrogenated dimer diamine; 1,2-diamino-2-methylpropane; 1,2-diaminocyclohexane; 1,2-diaminopropane; 1,3-diaminopropane; 1,4-diaminobutane; 1,5-diaminopentane; 1,7-diaminoheptane; 1,8-diaminomenthane; 1,8-diaminooctane; 1,9-diaminononane; 3,3'-diamino-N-methyldipropylamine; diaminomaleonitrile; 1,3-diaminopentane; 9,10-diaminophenanthrene; 4,4'-diaminooctafluorobiphenyl; 3,5-diaminobenzoic acid; 3,7-diamino-2-methoxyfluorene; 4,4'-diaminobenzophenone; 3,4-diaminobenzophenone; 3,4-diaminotoluene; 2,6-diaminoanthroquinone; 2,6-diaminotoluene; 2,3-diaminotoluene; 1,8-diaminonaphthalene; 2,4-diaminotoluene; 2,5-diaminotoluene; 1,4-diaminoanthroquinone; 1,5-diaminoanthroquinone; 1,5-diaminonaphthalene; 1,2-diaminoanthroquinone; 2,4-cumenediamine; 1,3-bisaminomethylbenzene; 1,3-bisaminomethylcyclohexane; 2-chloro-1,4-diaminobenzene; 1,4-diamino-2,5 -dichlorobenzene; 1,4-diamino-2,5 -dimethylbenzene; 4,4'-diamino-2,2'-bistrifluoromethylbiphenyl; bis(amino-3-chlorophenyl)ethane; bis(4-amino-3,5-dimethylphenyl)methane; bis(4-amino-3,5-diisopropylphenyl)methane; bis(4-amino-3,5 -methyl-isopropylphenyl)methane; bis(4-amino-3,5 -diethylphenyl)methane; bis(4-amino-3-ethylphenyl)methane; diaminofluorene; 4,4'-(9-Fluorenylidene)dianiline; diaminobenzoic acid; 2,3-diaminonaphthalene; 2,3-diaminophenol; 3,5-diaminobenzyl alcohol; bis(4-amino-3-methylphenyl)methane; bis(4-amino-3-ethylphenyl)methane; 4,4'-diaminophenylsulfone; 3,3'-diaminophenylsulfone; 2,2-bis(4,-(4-aminophenoxy)phenyl)sulfone; 2,2-bis(4-(3-aminophenoxy)phenyl)sulfone; 4,4'-oxydianiline; 4,4'-diaminodiphenyl sulfide; 3,4'-oxydianiline; 2,2-bis(4-(4-aminophenoxy)phenyl)propane; 1,3-bis(4-aminophenoxy)benzene; 4,4'-bis(4-aminophenoxy)biphenyl; 4,4'-diamino-3,3'-dihydroxybiphenyl; 4,4'-diamino-3,3'-dimethylbiphenyl; 4,4'-diamino-3,3'-dimethoxybiphenyl; Bisaniline M (4-[2-[3-[2-(4-aminophenyl)propan-2-yl]phenyl]propan-2-yl]aniline)]Bisaniline); Bisaniline P (4-[2-[4-[2-(4-aminophenyl)propan-2-yl]phenyl]propan-2-yl]aniline); 9,9-bis(4-aminophenyl)fluorene; o-tolidine sulfone; methylene bis(anthranilic acid); 1,3-bis(4-aminophenoxy)-2,2-dimethylpropane; 1,3-bis(4-aminophenoxy)propane; 1,4-bis(4-aminophenoxy)butane; 1,5-bis(4-aminophenoxy)butane; 2,3,5,6-tetramethyl-1,4-phenylenediamine; 3,3',5,5'-tetramehylbenzidine; 4,4'-diaminobenzanilide; 2,2-bis(4-aminophenyl) hexafluoropropane; polyoxyalkylenediamines;1,3-cyclohexanebis(methylamine); m-xylylenediamine; p-xylylenediamine; bis(4-amino-3-methylcyclohexyl)methane; 1,2-bis(2-aminoethoxy)ethane; 3(4),8(9)-bis(aminomethyl)tricyclo(5.2.1.0^{2,6})decane; ethanolamine; 1,3-cyclohexanebis(methylamine); 1,3-diamino-2-propanol; 1,4-diaminobutane, 1,5-diaminopentane; 1,6-diaminohexane; 2,2-bis[4-(3-aminophenoxy)phenyl]propane; 2,3,5'-tetramethylbenzidine; 2,3-diamononaphtalene; and polyalkylenediamines.

Dianhydrides contemplated for use in the methods of the invention include but are not limited to 4,4'-Bisphenol A dianhydride; pyromellitic dianhydride; 1,2,3,4-cyclobutanetetracarboxylic dianhydride; 1,4,5,8-naphthalenetetracarboxylic dianhydride; 3,4,9,10-perylenentetracarboxylic dianhydride; bicyclo(2.2.2)oct-7-ene-2,3,5,6-tetracarboxylic dianhydride; diethylenetriaminepentaacetic dianhydride; ethylenediaminetetraacetic dianhydride; 3,3',4,4'-benzophenone tetracarboxylic dianhydride; 3,3',4,4'-biphenyl tetracarboxylic dianhydride; 4,4'-oxydiphthalic anhydride; 3,3',4,4'-diphenylsulfone tetracarboxylic dianhydride; 2,2'-bis(3,4-dicarboxyphenyl)hexafluoropropane dianhydride; 4,4'-bisphenol A diphthalic anhydride; 5-(2,5-dioxytetrahydro)-3-methyl-3-cyclohexene-1,2-dicarboxylic anhydride; ethylene glycol bis(trimellitic anhydride); hydroquinone diphthalic anhydride; 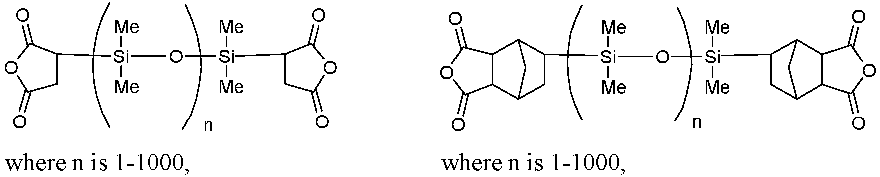 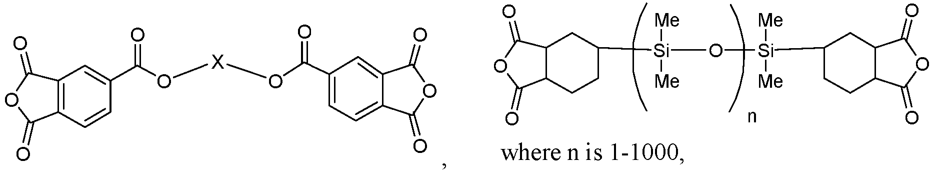 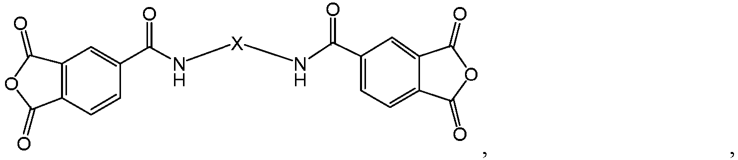 where X is saturated, unsaturated, strait or branched alkyl, polyester, polyamide, polyether, polysiloxane or polyurethane;

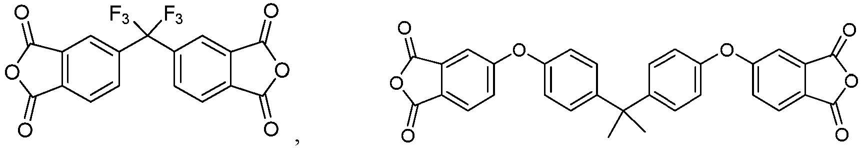

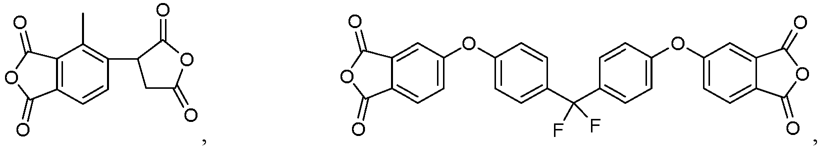

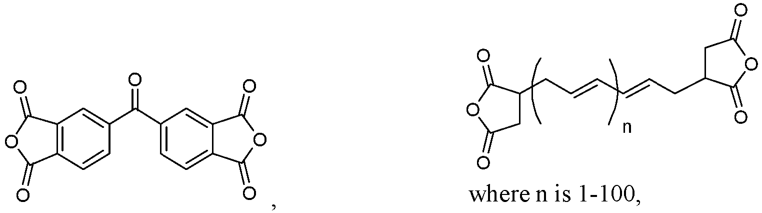

Also provided by the invention are adhesive formulations including comprising a polyimide of the invention, which can be a removable or temporary adhesive.

The temporary adhesives of the invention can be removed by applying an air jet to the temporary adhesive; and peeling the adhesive from the article. In some aspects the removal process may require soaking in a chemical solvent that removes residual adhesive such as cyclopentanone, cyclohexanone or a combination thereof.

The invention also provides articles, such as thinned or unthinned wafers, patterned or unpatterned chips, and electronics packages comprising a coating of a formulation of the invention.

Formulations provided by the invention comprise at least one curable, functionalized polyimide described herein, at least one reactive diluent or co-curable compound; and a solvent in which the functionalized polyimide is soluble. Such formulations can also include at least one adhesion promoters; at least one or more coupling agents; and/or at least one or more UV initiators; or free-radical initiators.

The formulations can be, for example, coatings, passivation layers, or redistribution layers.

For example, redistribution layers provided by the invention can include metallization between two layers of a formulation described herein. Also provided are articles coated on at least a part of a surface with a formulation of the invention, which can be a coating, passivation layer or redistribution layer.

The invention also provides prepregs that include comprising a fiber support impregnated with the formulation of the invention, as well as copper clad laminates in which copper foil is laminated to one surface or both surfaces of a prepreg of the invention. Also provided are printed wiring boards utilizing the copper-clad laminates of the invention.

The invention further provides flexible copper clad laminates comprising copper foil laminated to one surface or both surfaces of a cured layer of a polyimide formulation described herein.

### BRIEF DESCRIPTION OF THE DRAWINGS

**FIG 8** is a schematic flow diagram illustrating a printed circuit board including preparing a prepreg, laminating copper onto the prepreg, and etching a circuit pattern on the copper-cladding. Arrows A-E indicate steps **.**
**FIG 9** is a cross-sectional view through the structures at plane XVII of **FIG 8****.**
**FIG 10A** is a schematic flow diagram illustrating a one-sided flexible copper-clad laminate (FCCL) according to one embodiment of the invention that includes an adhesive layer. Arrows A and B indicate steps in the process.
**FIG 10B** is a schematic flow diagram illustrating a one-sided flexible copper-clad laminate (FCCL) according an embodiment of the invention that includes layers of adhesive. Arrows A and B indicate steps in the process.

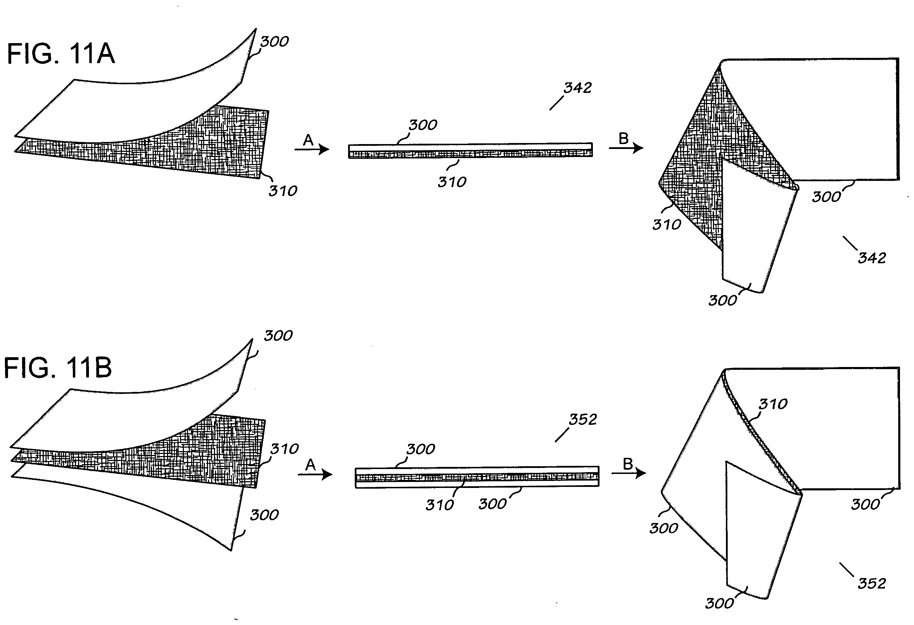

**FIG 11A** is a schematic flow diagram illustrating a one-sided flexible copper-clad laminate (FCCL) according to one embodiment of the invention that omits an adhesive layer. Arrows A and B indicate steps in the process.
**FIG 11B** is a schematic flow diagram illustrating a one-sided flexible copper-clad laminate (FCCL) according an embodiment of the invention that excludes layers of adhesive. Arrows A and B indicate steps in the process.
**FIG 12** is a graph showing the thermogravimetric analysis of **Compound 1-E.**
**FIG 13** is a graph showing the thermogravimetric analysis of **Compound 4A.**
**FIG 14** is a graph showing the elution profile of **Compound 1-B** from a gel permeation column for the estimation of molecular weight.
**FIG 15** is a graph showing the elution profile of **Compound 1-D** from a gel permeation column for the estimation of molecular weight.
**FIG 16** is a graph showing the elution profile of **Compound 1-E** from a gel permeation column for the estimation of molecular weight.
**FIG 17** is a graph showing the elution profile of **Compound 1-H** from a gel permeation column for the estimation of molecular weight.
**FIG 18** is a graph showing the elution profile of **Compound 2-A** from a gel permeation column for the estimation of molecular weight.
**FIG 19** is a graph showing the elution profile of **Compound 3-A** from a gel permeation column for the estimation of molecular weight.
**FIG 20** is a graph showing the elution profile of **Compound 4-A** from a gel permeation column for the estimation of molecular weight.
**FIG 21** is gel permeation column standard curve for the estimation of molecular weight.
**FIG 22** is scanning electron micrograph of copper oxide diffusion through a redistribution layer according to an embodiment of the invention (panel **B)** and a through a control redistribution layer (panel **A).**

### DETAILED DESCRIPTION

As used herein, the use of the singular includes the plural unless specifically stated otherwise. As used herein, "or" means "and/or" unless stated otherwise. Furthermore, use of the term "including" as well as other forms, such as "includes," and "included," is not limiting.

The section headings used herein are for organizational purposes only and are not to be construed as limiting the subject matter described.

Unless specific definitions are provided, the nomenclatures utilized in connection with, and the laboratory procedures and techniques of analytical chemistry, synthetic organic and inorganic chemistry described herein are those known in the art, such as those set forth in "IUPAC Compendium of Chemical Terminology: IUPAC Recommendations (The Gold Book)" (McNaught ed.; International Union of Pure and Applied Chemistry, 2^{nd} Ed., 1997) and "Compendium of Polymer Terminology and Nomenclature: IUPAC Recommendations 2008" (Jones et al., eds; International Union of Pure and Applied Chemistry, 2009). Standard chemical symbols are used interchangeably with the full names represented by such symbols. Thus, for example, the terms "hydrogen" and "H" are understood to have identical meaning. Standard techniques may be used for chemical syntheses, chemical analyses, and formulation.

### Definitions

**"About"** as used herein means that a number referred to as "about" comprises the recited number plus or minus 1-10% of that recited number. For example, "about 100 degrees" can mean 95-105 degrees or as few as 99-101 degrees depending on the situation. Whenever it appears herein, a numerical range such as " 1 to 20" refers to each integer in the given range; e.g., " 1 to 20 carbon atoms" means that an alkyl group can contain only 1 carbon atom, 2 carbon atoms, 3 carbon atoms, etc., up to and including 20 carbon atoms (although the term "alkyl" also includes instances where no numerical range of carbon atoms is designated). Where a range described herein includes decimal values, such as "1.2% to 10.5%", the range refers to each decimal value of the smallest increment indicated in the given range; e.g. "1.2% to 10.5%" means that the percentage can be 1.2%, 1.3%, 1.4%, 1.5%, etc. up to and including 10.5%; while "1.20% to 10.50%" means that the percentage can be 1.20%, 1.21%, 1.22%, 1.23%, etc. up to and including 10.50%.

As used herein, the term **"substantially"** refers to a great extent or degree. For example, "substantially all" typically refers to at least about 90%, frequently at least about 95%, often at least 99%, and more often at least about 99.9%.

**"Effective amount",** as used herein, refers to the amount of a compound or other substance that is sufficient in the presence of the remaining components to effect the desired result, such as reduction in photo-degradation and thermo-oxidative degradation by at least about 50%, usually at least about 70%, typically at least about 90%, frequently at least about 95% and most often, at least about 99%. In other aspects of the invention, an "effective amount" of a compound can refer to that concentration of the compound that is sufficient in the presence of the remaining components to effect the desired result. The effective amount of a compound or other substance is readily determined by one of ordinary skill in the art.

**"Adhesive", "adhesive compound", "adhesive composition",** and **"adhesive formulation"** as used herein, refer to any substance that can adhere or bond two items together. Implicit in the definition of an **"adhesive composition"** and **"adhesive formulation"** is that these are combinations or mixtures of more than one species, component or compound, which can include adhesive monomers, oligomers, and/or polymers along with other materials, whereas an "adhesive compound" refers to a single species, such as an adhesive polymer or oligomer.

More specifically, the terms "adhesive", "adhesive composition", and "adhesive formulation" refer to un-cured mixtures in which the individual components in the mixture retains the chemical and physical characteristics of the original components of which the mixture is made. Adhesive compositions are typically malleable and may be liquids, paste, gel or another form that can be applied to an item so that the item can be bonded to another item.

**"Cured adhesive", "cured adhesive compound",** and **"cured adhesive composition",** refer to adhesive components and mixtures obtained from reactive, curable original compounds or mixtures of compounds that have undergone a chemical and/or physical change such that the original compound or mixture of compounds is transformed into a solid, substantially non-flowing material. A typical curing process may involve cross-linking.

**"Curable"** means that an original compound or composition can be transformed into a solid, substantially non-flowing material by means of chemical reaction, cross-linking, radiation cross-linking, or the like. Thus, adhesive compounds and compositions of the invention are curable, but unless otherwise specified, adhesive compounds and compositions are not cured.

**"Thermoplastic,"** as used herein, refers to the ability of a compound, composition or other material (e.g. a plastic) to dissolve in a suitable solvent or to melt to a liquid when heated and freeze to a solid, often brittle and glassy, state when cooled sufficiently.

**"Thermoset,"** as used herein, refers to the ability of a compound, composition or other material to irreversibly "cure" resulting in a single three-dimensional network that has greater strength and less solubility compared to the un-cured compound, composition or other material.

Thermoset materials are typically polymers that may be cured, for example, through heat (e.g. above 200°C), via a chemical reaction (e.g. epoxy ring-opening, free-radical polymerization, etc.) or through irradiation (e.g. visible light, UV light, electron beam radiation, ion-beam radiation, or X-ray irradiation).

Thermoset materials, such as thermoset polymers or resins, are typically liquid or malleable forms prior to curing, and therefore may be molded or shaped into their final form, and/or used as adhesives. Curing transforms the thermoset resin into a rigid infusible and insoluble solid or rubber by a cross-linking process. Thus, energy and/or catalysts are typically added that cause the molecular chains of the polymers to react at chemically active sites (e.g., unsaturated or epoxy sites), linking the polymer chains into a rigid, 3D structure. The cross-linking process forms molecules with a higher molecular weight and resultant higher melting point. During the reaction, when the molecular weight of the polymer has increased to a point such that the melting point is higher than the surrounding ambient temperature, the polymer becomes a solid material.

**"Cross-linking,"** as used herein, refers to the bonding, typically covalent bonding, of two or more oligomer or longer, polymer chains by bridges of an element, a molecular group, a compound, or another oligomer or polymer. Cross-linking may take place upon heating; some cross-linking processes may also occur at room temperature or a lower temperature. As cross-linking density is increased, the properties of a material can be changed from thermoplastic to thermosetting

As used herein, **"B-stageable"** refers to the properties of an adhesive having a first solid phase followed by a tacky rubbery stage at elevated temperature, followed by yet another solid phase at an even higher temperature. The transition from the tacky rubbery stage to the second solid phase is thermosetting. However, prior to thermosetting, the material behaves similarly to a thermoplastic material. Thus, such adhesives allow for low lamination temperatures while providing high thermal stability.

A **"die"** or **"semiconductor die"** as used herein, refers to a small block of semiconducting material, on which a functional circuit is fabricated.

**"Chip"** as used herein, refers to die fabricated with a functional circuit, (e.g., a set of electronic circuits or an integrated circuit).

**A "flip-chip"** semiconductor device is one in which a semiconductor die is directly mounted to a wiring substrate, such as a ceramic or an organic printed circuit board. Conductive terminals on the semiconductor die, usually in the form of solder bumps, are directly physically and electrically connected to the wiring pattern on the substrate without use of wire bonds, tape-automated bonding (TAB). Because the conductive solder bumps making connections to the substrate are on the active surface of the die or chip, the die is mounted in a facedown manner, thus the name "flip-chip."

The term **"photoimageable",** as used herein, refers to the ability of a compound or composition to be selectively cured only in areas exposed to light. The exposed areas of the compound are thereby rendered cured and insoluble, while the unexposed area of the compound or composition remains un-cured and therefore soluble in a developer solvent. Typically, this operation is conducted using ultraviolet light as the light source and a photomask as the means to define where the exposure occurs. The selective patterning of dielectric layers on a silicon wafer can be carried out in accordance with various photolithographic techniques known in the art. In one method, a photosensitive polymer film is applied over the desired substrate surface and dried. A photomask containing the desired patterning information is then placed in close proximity to the photoresist film. The photoresist is irradiated through the overlying photomask by one of several types of imaging radiation including UV light, e-beam electrons, x-rays, or ion beam. Upon exposure to the radiation, the polymer film undergoes a chemical change (cross-links) with concomitant changes in solubility. After irradiation, the substrate is soaked in a developer solution that selectively removes the non-cross-linked or unexposed areas of the film.

The term **"passivation"** as used herein, refers to the process of making a material "passive" in relation to another material or condition. The term **"passivation layers"** (PLs) refers to layers that are commonly used to encapsulate semiconductor devices, such as semiconductor wafers, to isolate the device from its immediate environment and, thereby, to protect the device from oxygen, water, etc., as well airborne or space-borne contaminants, particulates, humidity and the like. Passivation layers are typically formed from inert materials that are used to coat the device. This encapsulation process also passivates semiconductor devices by terminating dangling bonds created during manufacturing processes and by adjusting the surface potential to either reduce or increase the surface leakage current associated with these devices. In certain embodiments of the invention, passivation layers contain dielectric material that is disposed over a microelectronic device. Such PLs are typically patterned to form openings therein that provide for making electrical contact to the microelectronic device. Often a passivation layer is the last dielectric material disposed over a device and serves as a protective layer.

The term **"Interlayer Dielectric Layer"** (ILD) refers to a layer of dielectric material disposed over a first pattern of conductive traces and between such first pattern and a second pattern of conductive traces. Such ILD layer is typically patterned to form openings therein (generally referred to as "vias") to provide for electrical contact between the first and second patterns of conductive traces in specific regions. Other regions of such ILD layer are devoid of vias and thus prevent electrical contact between the conductive traces of the first and second patterns in such other regions.

A **"redistribution layer"** or **"RDL"** as used herein, refers to an extra metal layer on a chip that makes the I/O (input-output) pads of an integrated circuit available in other locations.

**"Fan-out package"** as used herein, refers to a I/O circuit package in which a silicon chip is extended by molding the chip in a dielectric material (e.g., an epoxy resin) to extend the size of the chip. I/O pads of the silicon chip can be made available to the fan-out region using RDL.

**"Underfill," "underfill composition"** and **"underfill material"** are used interchangeably to refer to material, typically polymeric compositions, used to fill gaps between semiconductor components, such as between or under a semiconductor die and a substrate. "**Underfilling**" refers to the process of applying an underfill composition to a semiconductor component-substrate interface, thereby filling the gaps between the component and the substrate.

The term **"conformal coating"** as used herein, refers to a material applied to circuit boards, particularly electronic circuitry, to act as protection against that moisture, dust, chemicals, and temperature extremes that, if uncoated, could result in damage or failure of the electronics to function properly. Typically, the electronics assemblies are coated by brushing, spraying or dipping, with a protective coating layer that conforms to the electronics and isolates it from harsh environmental conditions. The conformal coating can be transparent to permit inspection of underlying circuitry. Furthermore, a suitably chosen material coating can reduce the effects of mechanical stress and vibration on the circuit and its ability to operate in extreme temperatures. For example, in a chip-on-board assembly process, a silicon die is mounted on the board with adhesive or a soldering process, and then electrically connected by wire bonding. To protect the very delicate package, the entire assembly is encapsulated in a conformal coating called a **"glob top".**

The term **"monomer"** refers to a molecule that can undergo polymerization or co-polymerization, thereby contributing constitutional units to the essential structure of a macromolecule (a polymer).

The term **"pre-polymer"** refers to a monomer or combination of monomers that have been reacted to a molecular mass state intermediate between that of the monomer and higher molecular weight polymers. Pre-polymers are capable of further polymerization via reactive groups they contain, to a fully cured high molecular weight state. Mixtures of reactive polymers with un-reacted monomers may also be referred to a **"resin".** The term **"resin",** as used herein, refers to a substance containing pre-polymers, typically with reactive groups. In general, resins are pre-polymers of a single type or class, such as epoxy resins and bismaleimide resins.

**"Polymer"** and **"polymer compound"** are used interchangeably herein, to refer generally to the combined products of a single chemical polymerization reaction. Combining monomer subunits into a covalently bonded chain produces polymers. Polymers that contain only a single type of monomer are known as **"homopolymers,"** while polymers containing a mixture of monomers are known as **"copolymers."**

The term **"copolymers"** is inclusive of products that are obtained by copolymersization of two monomer species, those obtained from three monomers species (terpolymers), those obtained from four monomers species (quaterpolymers), etc. It is well known in the art that copolymers synthesized by chemical methods include, but are not limited to, molecules with the following types of monomer arrangements:
**alternating copolymers,** which contain regularly alternating monomer residues; periodic copolymers, which have monomer residue types arranged in a repeating sequence;
**random copolymers,** which have a random sequence of monomer residue types;
**statistical copolymers,** which have monomer residues arranged according to a known statistical rule;
**block copolymers,** which have two or more homopolymer subunits linked by covalent bonds. The blocks of homopolymer within block copolymers, for example, can be of any length and can be blocks of uniform or variable length. Block copolymers with two or three distinct blocks are called diblock copolymers and triblock copolymers, respectively; and
**star copolymers,** which have chains of monomer residues having different constitutional or configurational features that are linked through a central moiety.

Furthermore, the length of a polymer chain according to the present invention will typically vary over a range or average size produced by a particular reaction. The skilled artisan will be aware, for example, of methods for controlling the average length of a polymer chain produced in a given reaction and also of methods for size-selecting polymers after they have been synthesized.

Unless a more restrictive term is used, the term "polymer" is intended to encompass homopolymers and co-polymers having any arrangement of monomer subunits as well as co-polymers containing individual molecules having more than one arrangement. With respect to length, unless otherwise indicated, any length limitations recited for the polymers described herein are to be considered averages of the lengths of the individual molecules in polymer.

As used herein, **oligomer"** or **"oligomeric",** refers to a polymer having a finite and moderate number of repeating monomers structural units. Oligomers of the invention typically have 2 to about 100 repeating monomer units; frequently 2 to about 30 repeating monomer units; and often 2 to about 10 repeating monomer units; and usually have a molecular weight up to about 3,000.

The skilled artisan will appreciate that oligomers and polymers may be incorporated as monomers in further polymerization or cross-linking reactions, depending on the availability of polymerizable groups or side chains.

**"Thermoplastic elastomer"** or **"TPE",** as used herein refers to a class of co-polymers that consist of materials with both thermoplastic and elastomeric properties.

**"Hard blocks"** or **"hard segments"** as used herein refer to a block of a copolymers (typically a thermoplastic elastomer) that is hard at room temperature by virtue of a high melting point (Tₘ) or T_{g}. By contrast, **"soft blocks"** or **"soft segments"** have a T_{g} below room temperature.

As used herein, **"reactive diluent"** refers to low-viscosity, mono-, bi- or polyfunctional monomers or oligomers or solutions thereof. Exemplary reactive diluents include acrylates, methacrylates, vinyl ethers, thiols, and epoxies.

As used herein, the term **"vinyl ether"** refers to a compound bearing at least one moiety having the structure:

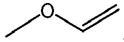

As used herein, the term **"vinyl ester"** refers to a compound bearing at least one moiety having the structure:

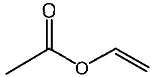

As used herein, **"aliphatic"** (i.e., non-aromatic) refers to any alkyl, alkenyl, cycloalkyl, or cycloalkenyl moiety.

**"Aromatic hydrocarbon"** or **"aromatic",** as used herein, refers to compounds having one or more benzene rings.

**"Alkane,"** as used herein, refers to saturated straight chain, branched or cyclic hydrocarbons having only single bonds. Alkanes have general formula C*ₙ*H_{2*n*+2}, where n is any integer.

**"Cycloalkane,"** refers to an alkane having one or more rings in its structure.

As used herein, **"alkyl"** refers to straight or branched chain hydrocarbyl groups having from 1 to about 500 carbon atoms. **"Lower alkyl"** refers generally to alkyl groups having 1 to 6 carbon atoms. The terms **"alkyl"** and **"substituted alkyl"** include, respectively, unsubstituted and substituted (as set forth below) C₁-C₅₀₀ straight chain saturated aliphatic hydrocarbon groups, unsubstituted and substituted C₂-C₂₀₀ straight chain unsaturated aliphatic hydrocarbon groups, unsubstituted and substituted C₄-C₁₀₀ branched saturated aliphatic hydrocarbon groups, unsubstituted and substituted C₁-C₅₀₀ branched unsaturated aliphatic hydrocarbon groups.

For example "alkyl" includes but is not limited to: methyl (Me), ethyl (Et), propyl (Pr), butyl (Bu), pentyl, hexyl, heptyl, octyl, nonyl, decyl, undecyl, ethenyl, propenyl, butenyl, penentyl, hexenyl, heptenyl, octenyl, nonenyl, decenyl, undecenyl, isopropyl (i-Pr), isobutyl (i-Bu), tert-butyl (t-Bu), sec-butyl (s-Bu), isopentyl, neopentyl, cyclopropyl, cyclobutyl, cyclopentyl, cyclohexyl, cycloheptyl, cyclooctyl, cyclopentenyl, cyclohexenyl, cycloheptenyl, cyclooctenyl, methylcyclopropyl, ethylcyclohexenyl, butenylcyclopentyl, tricyclodecyl, adamantyl, norbornyl .

In addition, as used herein "**C₃₆**" and "**C₃₆ moiety"** refer to all possible structural isomers of a 36 carbon aliphatic moiety, including branched isomers and cyclic isomers with up to three carbon-carbon double bonds in the backbone. One non-limiting example of a **C₃₆** moiety is the moiety comprising a cyclohexane-based core and four long "arms" attached to the core, as demonstrated by the following structure:

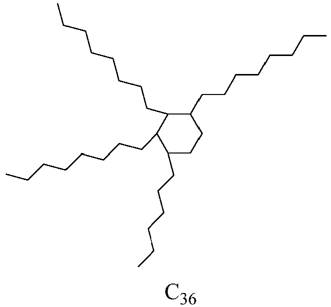

As used herein, **"cycloalkyl"** refers to cyclic ring-containing groups containing in the range of 3 to about 20 carbon atoms, typically 3 to about 15 carbon atoms. In certain embodiments, cycloalkyl groups have in the range of about 4 to about 12 carbon atoms, and in yet further embodiments, cycloalkyl groups have in the range of about 5 to about 8 carbon atoms. **"Substituted cycloalkyl"** refers to cycloalkyl groups further bearing one or more substituents as set forth below.

As used herein, the term **"aryl"** refers to unsubstituted, mono-, di- or trisubstituted monocyclic, polycyclic, biaryl aromatic groups covalently attached at any ring position capable of forming a stable covalent bond, certain preferred points of attachment being apparent to those skilled in the art (e.g., 3-phenyl, 4-naphtyl ). The aryl substituents are independently selected from the group consisting of halo, -OH, -SH, -CN, -NO₂, trihalomethyl, hydroxypyronyl, C₁₋₁₀ alkyl, aryl C₁₋₁₀ alkyl, C₁₋₁₀ alkyloxy C₁₋₁₀ alkyl, aryl C₁₋₁₀ alkyloxy C₁₋₁₀ alkyl, C₁₋₁₀ alkylthio C₁₋₁₀ alkyl, aryl C₁₋₁₀ alkylthio C₁₋₁₀ alkyl, C₁₋₁₀ alkylamino C₁₋₁₀ alkyl, aryl C₁₋₁₀ alkylamino C₁₋₁₀ alkyl, N-aryl-N-C₁₋₁₀ alkylamino C₁₋₁₀ alkyl, C₁₋₁₀ alkylcarbony lC₁₋₁₀ alkyl, aryl C₁₋₁₀ alkylcarbonyl C₁₋₁₀ alkyl, C₁₋₁₀ alkylcarboxy C₁₋₁₀ alkyl, aryl C₁₋₁₀ alkylcarboxy C₁₋₁₀ alkyl, C₁₋₁₀ alkylcarbonylamino C₁₋₁₀ alkyl, and aryl C₁₋₁₀ alkylcarbonylamino C₁₋₁₀ alkyl.

As used herein, **"arylene"** refers to a divalent aryl moiety. **"Substituted arylene"** refers to arylene moieties bearing one or more substituents as set forth above.

As used herein, **"alkylaryl"** refers to alkyl-substituted aryl groups and **"substituted alkylaryl"** refers to alkylaryl groups further bearing one or more substituents as set forth below.

As used herein, **"arylalkyl"** refers to aryl-substituted alkyl groups and **"substituted arylalkyl"** refers to arylalkyl groups further bearing one or more substituents as set forth below. Examples of arylalkyl and substituted arylalkyl include but are not limited to (4-hydroxyphenyl)ethyl and or (2-aminonaphthyl) hexenyl, respectively.

As used herein, **"arylalkenyl"** refers to aryl-substituted alkenyl groups and **"substituted** arylalkenyl" refers to arylalkenyl groups further bearing one or more substituents as set forth below.

As used herein, **"arylalkynyl"** refers to aryl-substituted alkynyl groups and **"substituted** arylalkynyl" refers to arylalkynyl groups further bearing one or more substituents as set forth below.

As used herein, **"aroyl"** refers to aryl-carbonyl species such as benzoyl and "substituted aroyl" refers to aroyl groups further bearing one or more substituents as set forth below.

**"Substituted"** refers to compounds or moieties bearing substituents that include, but are not limited to, alkyl, alkenyl, alkynyl, hydroxy, oxo, alkoxy, mercapto, cycloalkyl, substituted cycloalkyl, heterocyclic, substituted heterocyclic, aryl, substituted aryl (e.g., aryl C₁-₁₀ alkyl or aryl C₁-₁₀ alkyloxy), heteroaryl, substituted heteroaryl (e.g., heteroaryl C₁-₁₀ alkyl), aryloxy, substituted aryloxy, halogen, haloalkyl (e.g., trihalomethyl), cyano, nitro, nitrone, amino, amido, carbamoyl, =O, =CH-, -C(O)H-, -C(O)O-, -C(O)-, -S-, -S(O)₂-, -OC(O)-O-, -NR-C(O), -NRC-(O)-NR-, -OC(O)-NR-, where R is H or lower alkyl, acyl, oxyacyl, carboxyl, carbamate, sulfonyl, sulfonamide, sulfuryl, C₁₋₁₀ alkylthio, aryl C₁₋₁₀ alkylthio, C₁₋₁₀ alkylamino, aryl C₁₋₁₀ alkylamino, N aryl N C₁₋₁₀ alkylamino, C₁₋₁₀ alkyl carbonyl, aryl C₁₋₁₀ alkylcarbonyl, C₁₋₁₀ alkylcarboxy, aryl C₁₋₁₀ alkylcarboxy, C₁₋₁₀ alkyl carbonylamino, aryl C₁₋₁₀ alkylcarbonylamino, tetrahydrofuryl, morpholinyl, piperazinyl, and hydroxypyronyl.

As used herein, **"hetero"** refers to groups or moieties containing one or more hetero (i.e., non-carbon) atoms such as N, O, Si and S. Thus, for example **"heterocyclic"** refers to cyclic (i.e., ring-containing) groups having e.g. N, O, Si or S as part of the ring structure, and having in the range of 3 up to 14 carbon atoms. **"Heteroaryl"** and **"heteroalkyl"** moieties are aryl and alkyl groups, respectively, containing e.g. N, O, Si or S as part of their structure. The terms **"heteroaryl", "heterocycle"** or **"heterocyclic"** refer to a monovalent unsaturated group having a single ring or multiple condensed rings, from 1 to 8 carbon atoms and from 1 to 4 hetero atoms selected from nitrogen, sulfur or oxygen within the ring.

**"Heteroaryl"** includes but is not limited to thienyl, benzothienyl, isobenzothienyl, 2,3-dihydrobenzothienyl, furyl, pyranyl, benzofuranyl, isobenzofuranyl, 2,3-dihydrobenzofuranyl, pyrrolyl, pyrrolyl-2,5-dione, 3-pyrrolinyl, indolyl, isoindolyl, 3H-indolyl, indolinyl, indolizinyl, indazolyl, phthalimidyl (or isoindoly-1,3-dione), imidazolyl. 2H-imidazolinyl, benzimidazolyl, pyridyl, pyrazinyl, pyridazinyl, pyrimidinyl, triazinyl, quinolyl, isoquinolyl, 4H-quinolizinyl, cinnolinyl, phthalazinyl, quinazolinyl, quinoxalinyl, 1,8-naphthyridinyl, pteridinyl, carbazolyl, acridinyl, phenazinyl, phenothiazinyl, phenoxazinyl, chromanyl, benzodioxolyl, piperonyl, purinyl, pyrazolyl, triazolyl, tetrazolyl, thiazolyl, isothiazolyl, benzthiazolyl, oxazolyl, isoxazolyl, benzoxazolyl, oxadiazolyl, thiadiazolyl, pyrrolidinyl-2,5-dione, imidazolidinyl-2,4-dione, 2-thioxo-imidazolidinyl-4-one, imidazolidinyl-2,4-dithione, thiazolidinyl-2,4-dione, 4-thioxo-thiazolidinyl-2-one, piperazinyl-2,5-dione, tetrahydro-pyridazinyl-3,6-dione, 1,2-dihydro-[1,2,4,5]tetrazinyl-3,6-dione, [1,2,4,5]tetrazinanyl-3,6-dione, dihydro-pyrimidinyl-2,4-dione, pyrimidinyl-2,4,6-trione, 1H-pyrimidinyl-2,4-dione, 5-iodo-1H-pyrimidinyl-2,4-dione, 5-chloro-1H-pyrimidinyl-2,4-dione, 5-methyl-1H-pyrimidinyl-2,4-dione, 5-isopropyl-1H-pyrimidinyl-2,4-dione, 5-propynyl-1H-pyrimidinyl-2,4-dione, 5-trifluoromethyl-1H-pyrimidinyl-2,4-dione, 6-amino-9H-purinyl, 2-amino-9H-purinyl, 4-amino-1H-pyrimidinyl-2-one, 4-amino-5-fluoro-1H-pyrimidinyl-2-one, 4-amino-5-methyl-1H-pyrimidinyl-2-one, 2-amino-1,9-dihydro-purinyl-6-one, 1,9-dihydro-purinyl-6-one, 1H-[1,2,4]triazolyl-3-carboxylic acid amide, 2,6-diamino-N.sub.6-cyclopropyl-9H-purinyl, 2-amino-6-(4-methoxyphenylsulfanyl)-9H-purinyl, 5,6-dichloro-1H-benzoimidazolyl, 2-isopropylamino-5,6-dichloro-1H-benzoimidazolyl, 2-bromo-5,6-dichloro- 1H-benzoimidazolyl. Furthermore, the term "saturated heterocyclic" refers to an unsubstituted, mono-, di- or trisubstituted monocyclic, polycyclic saturated heterocyclic group covalently attached at any ring position capable of forming a stable covalent bond, certain preferred points of attachment being apparent to those skilled in the art (e.g., 1-piperidinyl, 4-piperazinyl).

Hetero-containing groups may also be substituted. For example, **"substituted heterocyclic"** refers to a ring-containing group having in the range of 3 to about 14 carbon atoms that contains one or more heteroatoms and also bears one or more substituents, as set forth above.

As used herein, the term **"phenol"** includes compounds having one or more phenolic groups having a structure: 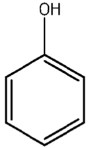 per molecule. The terms aliphatic, cycloaliphatic and aromatic, when used to describe phenols, refers to phenols to which aliphatic, cycloaliphatic and aromatic residues, direct bonding or ring fusion generates combinations of these backbones with phenols.

As used herein, **"alkenyl," "alkene"** or **"olefin"** refers to straight or branched chain unsaturated hydrocarbyl groups having at least one carbon-carbon double bond, and typically having in the range of about 2 to about 500 carbon atoms. In certain embodiments, **alkenyl** groups have in the range of about 5 to about 250 carbon atoms, about 5 to about 100 carbon atoms, about 5 to about 50 carbon atoms or 5 to about 25 carbon atoms. In other embodiments, alkenyl groups have in the range of about 6 to about 500 carbon atoms, about 8 to about 500 carbon atoms, about 10 to about 500 carbon atoms, about 20 to about 500 carbon atoms, or about 50 to about 500 carbon atoms. In yet further embodiments, alkenyl groups have in the range of about 6 to about 100 carbon atoms, about 10 to about 100 carbon atoms, about 20 to about 100 carbon atoms, or about 50 to about 100 carbon atoms, while in other embodiments, alkenyl groups have in the range of about 6 to about 50 carbon atoms, about 6 to about 25 carbon atoms, about 10 to about 50 carbon atoms, or about 10 to about 25 carbon atoms. **"Substituted alkenyl"** refers to alkenyl groups further bearing one or more substituents as set forth above.

As used herein, **"alkylene"** refers to a divalent alkyl moiety, and "oxyalkylene" refers to an alkylene moiety containing at least one oxygen atom instead of a methylene (CH₂) unit. **"Substituted alkylene"** and **"substituted oxyalkylene"** refer to alkylene and oxyalkylene groups further bearing one or more substituents as set forth above.

As used herein, **"alkynyl"** refers to straight or branched chain hydrocarbyl groups having at least one carbon-carbon triple bond, and having in the range of 2 to about 100 carbon atoms, typically about 4 to about 50 carbon atoms, and frequently about 8 to about 25 carbon atoms. **"Substituted alkynyl"** refers to alkynyl groups further bearing one or more substituents as set forth below.

**"Allyl"** as used herein, refers to refers to a compound bearing at least one moiety having the structure:

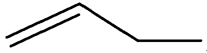

**"Imide"** as used herein, refers to a functional group having two carbonyl groups bound to a primary amine or ammonia. The general formula of an imide of the invention is:

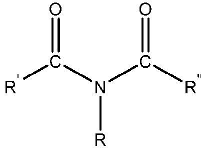

**"Polyimide"** refers to polymers of imide-containing monomers. Polyimides are typically linear or cyclic. Non-limiting examples of linear and cyclic (e.g. an aromatic heterocyclic polyimide) polyimides are shown below for illustrative purposes.

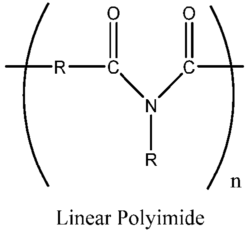

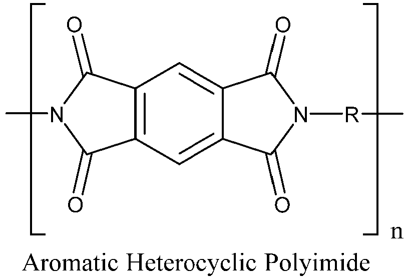

**"Maleimide,"** as used herein, refers to an N-substituted maleimide having the formula shown below: 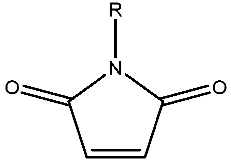 where R is an aromatic, heteroaromatic, aliphatic, or polymeric moiety.

**"Bismaleimide"** or "**BMI**", as used herein, refers to compound in which two imide moieties are linked by a bridge, i.e. a polyimide compound having the general structure shown below: 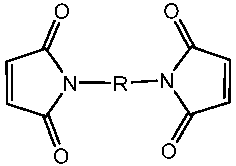 where R is an aromatic, heteroaromatic, aliphatic, or polymeric moiety. BMIs can cure through addition rather than condensation reactions, thus avoiding the formation of volatiles. BMIs can also be cured by a vinyl-type polymerization of a pre-polymer terminated with two maleimide groups.

As used herein, "acyl" refers to alkyl-carbonyl species.

As used herein, the term "acrylate" refers to a compound bearing at least one moiety having the structure:

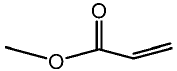

As used herein, the term "methacrylate" refers to a compound bearing at least one moiety having the structure:

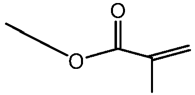

As used herein, **"maleate"** refers to a compound bearing at least one moiety having the structure:

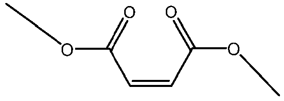

As used herein, **"styrene"** or **"styrenic"** refers to a compound bearing at least one moiety having the structure:

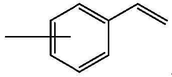

**"Benzoxazine"** as used herein, refers to a compound bearing at least one moiety having the structure:

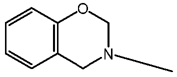

**"Fumarate"** as used herein, refers to a compound bearing at least one moiety having the structure:

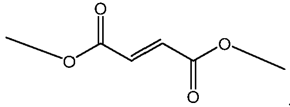

**"Cyanate ester"** as used herein, refers to a compound bearing at least one moiety having the structure:

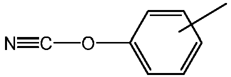

**"Cyanoacrylate"** as used herein, refers to a compound bearing at least one moiety having the structure:

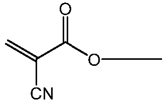

**"Propargyl"** as used herein, refers to a compound bearing at least one moiety having the structure:

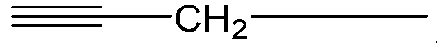

As used herein, **"norbornyl"** refers to a compound bearing at least one moiety having the structure:

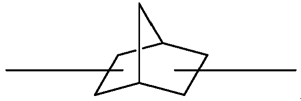

As used herein, the term **"acyloxy benzoate"** or **"phenyl ester"** refers to a compound bearing at least one moiety having the structure: 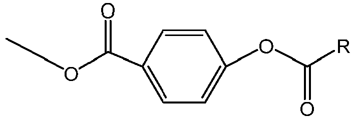 where R=H, lower alkyl, or aryl.

As used herein, a **"primary amine terminated difunctional siloxane bridging group"** refers to a moiety having the structural formula: 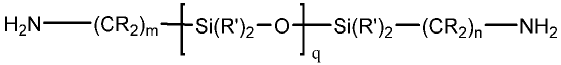 where each R is H or Me, each R' is independently H, lower alkyl, or aryl; each of m and n is an integer having the value between 1 to about 10, and q is an integer having the value between 1 and 100.

**"Diamine,"** as used herein, refers generally to a compound or mixture of compounds, where each species has 2 amine groups.

The term **"solvent,"** as used herein, refers to a liquid that dissolves a solid, liquid, or gaseous solute, resulting in a solution. **"Co-solvent"** refers to a second, third, etc. solvent used with a primary solvent.

As used herein, **"polar protic solvents"** are ones that contain an O-H or N-H bond, while "polar aprotic solvents" do not contain an O-H or N-H bond.

As used herein, the term **"citraconimide"** refers to a compound bearing at least one moiety having the structure:

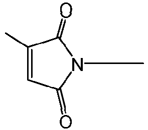

**"Itaconate",** as used herein refers to a compound bearing at least one moiety having the structure:

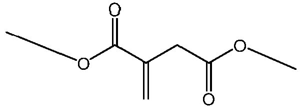

As used herein, the terms **"halogen," "halide,"** or **"halo"** include fluorine, chlorine, bromine, and iodine.

As used herein, **"siloxane"** refers to any compound containing a Si-O moiety. Siloxanes may be either linear or cyclic. In certain embodiments, siloxanes of the invention include 2 or more repeating units of Si-O. Exemplary cyclic siloxanes include hexamethylcyclotrisiloxane, octamethylcyclotetrasiloxane, decamethylcyclopentasiloxane, dodecamethylcyclohexasiloxane .

As used herein, **"oxirane"** or **"epoxy"** refers to divalent moieties having the structure:

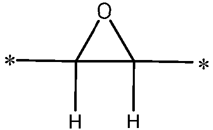

The asterisks denote a site of attachment of the oxirane group to another group. If the oxirane group is at the terminal position of an epoxy resin, the oxirane group is typically bonded to a hydrogen atom:

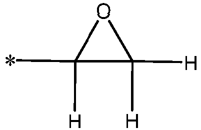

The terminal oxirane group is often part of a glycidyl group:

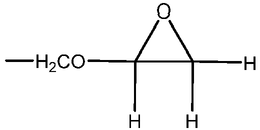

The term **"epoxy"** also refers to thermosetting epoxide polymers that cure by polymerization and cross-linking when mixed with a catalyzing agent or **"hardener,"** also referred to as a **"curing agent"** or **"curative."** Epoxies of the present invention include, but are not limited to aliphatic, cycloaliphatic, glycidyl ether, glycidyl ester, glycidyl amine epoxies, and combinations thereof.

The term **"epoxy"** also refers to thermosetting epoxide polymers that cure by polymerization and cross-linking when mixed with a catalyzing agent or **"hardener,"** also referred to as a **"curing agent"** or **"curative."** Epoxies of the present invention include, but are not limited to aliphatic, cycloaliphatic, glycidyl ether, glycidyl ester, glycidyl amine epoxies, and combinations thereof.

As used herein, the term **"oxetane"** refers to a compound bearing at least one moiety having the structure:

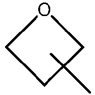

As used herein, **"benzophenone"** refers the moiety: 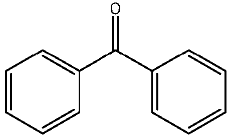 or a compound bearing a benzophenone moiety, including but not limited to benzophenone-containing anhydrides such as benzophenone tetracarboxylic dianhydride:

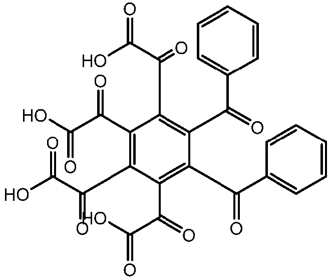

As used herein, the term **"free radical initiator"** refers to any chemical species that upon exposure to sufficient energy (e.g., light, heat, or the like) decomposes into parts **("radicals"),** which are uncharged, but every one of such parts possesses at least one unpaired electron.

**"Photoinitiation"** as used herein, refers to polymerization initiated by light. In most cases, photoinduced polymerization, utilizes initiators to generate radicals, which can be one of two types: **"Type** I **Photoinitiators"** (unimolecular photoinitiators), which undergo homolytic bond cleavage upon absorption of light; and **"Type II Photoinitiators"** (bimolecular photoinitiators), consisting of a photoinitiator such as benzophenone or thioxanthone and a coinitiator such as alcohol or amine.

As used herein, the term **"coupling agent"** refers to chemical species that are capable of bonding to a mineral surface and that also contain polymerizably reactive functional group(s) so as to enable interaction with a polymer composition, such as a compound or composition of the invention. Coupling agents thus facilitate linkage of e.g. an adhesive, die-attach paste, passivation layer, film, or coating to the substrate to which it is applied.

As used herein, **"breakdown voltage"** of an dielectric insulator is the minimum voltage that causes a portion of an insulator to become electrically conductive.

**"Glass transition temperature"** or **"Tg"** is used herein to refer to the temperature at which an amorphous solid, such as a polymer, becomes brittle on cooling, or soft on heating. More specifically, it defines a pseudo second order phase transition in which a supercooled melt yields, on cooling, a glassy structure and properties similar to those of crystalline materials e.g. of an isotropic solid material.

**"Low glass transition temperature"** or **"Low T_{g}**" as used herein, refers to a T_{g} at or below about 50°C. **"High glass transition temperature"** or **"High T_{g}"** as used herein, refers to a T_{g} of at least about 60°C, at least about 70 °C, at least about 80°C, at least about 100°C. **"Very high glass transition temperature"** and **"very high T_{g}"** as used herein, refers to a T_{g} of at least about 150°C, at least about 175°C, at least about 200°C, at least about 220°C or higher. High glass transition temperature compounds and compositions of the invention typically have a T_{g} in the range of about 70 °C to about 300°C.

**"Modulus"** or **"Young's modulus"** as used herein, is a measure of the stiffness of a material. Within the limits of elasticity, modulus is the ratio of the linear stress to the linear strain, which can be determined from the slope of a stress-strain curve created during tensile testing.

The **"Coefficient of Thermal Expansion"** or **"CTE"** is a term of art describing a thermodynamic property of a substance. The CTE relates a change in temperature to the change in a material's linear dimensions. As used herein **"α1 CTE"** or **"α1"** refers to the CTE before the T_{g}, while **"α2 CTE"** refers to the CTE after the T_{g}. Most polymers have CTEs between about 50 and 200.

**"Low Coefficient of Thermal Expansion"** or **"Low CTE"** as used herein, refers to an **CTE** of less than about 50 ppm/°C, typically less than about 30 ppm/°C or less than about 10 ppm/°C.

**"Viscosity"** refers to resistance to gradual deformation by shear stress or tensile stress. Viscosity of liquids can be understood informally as the "thickness". **"Low viscosity"** as used herein, is exemplified by water (0.894 centipoise (cP)) and typically refers to a viscosity at 25°C less than about 10,000 cP, often less than about 1,000 cP, typically less than about 100 cP and often less than about 10 cP. **"High viscosity"** fluids have a viscosity at 25°C greater than about 20,000 cP, typically greater than about 50,000 cP and often greater than about 100,000 cP. Generally, for easy handling and processing, the viscosity of a composition of the present invention should be in the range of about 10 to about 12,000 cP, typically about 10 to about 2,000 cP, and often about 10 to about 1,000 cP.

**"Thermogravimetric analysis"** or **"TGA"** refers to a method of testing and analyzing a material to determine changes in weight of a sample that is being heated in relation to change in temperature. **"Decomposition onset"** refers to a temperature when the loss of weight in response to the increase of the temperature indicates that the sample is beginning to degrade.

As used herein the term **"85/85"** is used to describe a highly accelerated stress test (HAST) performed on electronics components. In this test, the electronics parts are exposed to 85°C and 85% relative humidity for hundreds to thousands of hours. The parts are then checked for adhesion and/or electrical performance.

As used herein the term **"PCT"** or **"pressure-cook test"** is used to describe a HAST test performed on electronics components. In this case the electronics parts are placed in a pressure cooker and exposed to 121°C with 100% relative humidity for up to 96 hours. The parts are then checked for adhesion or electrical performance. This is typically the highest reliability test performed on electronics components.

As used herein the term **"dielectric constant"** or **"relative permittivity"** (Dk) is the ratio of the permittivity (a measure of electrical resistance) of a substance to the permittivity of free space (which is given a value of 1). In simple terms, the lower the Dk of a material, the better it will act as an insulator. As used herein, **"low dielectric constant"** or "**low-κ**" refers to a material with a Dk less than that of silicon dioxide, which has Dk of 3.9. Thus, **"low dielectric constant refers"** to a Dk of less than 3.9, typically less than about 3.4, frequently less than about 3.2, and most often less than about 3.0. Most polyimides have a Dk of about 3.4.

As used herein the term **"dissipation dielectric factor",** and abbreviation "**Df**" are used herein to refer to a measure of loss-rate of energy in a thermodynamically open, dissipative system. In simple terms, Df is a measure of how inefficient the insulating material of a capacitor is. It typically measures the heat that is lost when an insulator such as a dielectric is exposed to an alternating field of electricity. The lower the Df of a material, the better its efficiency. **"Low dissipation dielectric factor"** typically refers to a Df of less than about 0.01 at 1-GHz frequency, frequently less than about 0.005 at 1-GHz frequency, and most often 0.001 or lower at 1-GHz frequency.

**"Thixotropy"** as used herein, refers to the property of a material which enables it to stiffen or thicken in a relatively short time upon standing, but upon agitation or manipulation to change to low-viscosity fluid; the longer the fluid undergoes shear stress, the lower its viscosity. Thixotropic materials are therefore gel-like at rest but fluid when agitated and have high static shear strength and low dynamic shear strength, at the same time.

### Temporary Adhesives

Temporary adhesives are used through the fabrication of electronics devices and components, at various steps where a removable attachment is required, or when permanent attachment is facilitated by temporarily holding two or more parts together. An exemplary use of temporary adhesive is in the process of backgrinding silicon wafers to a desired thickness.

**Backgrinding** is a semiconductor device fabrication process that reduces the thickness of semi-conductor wafers (e.g., crystalline silicon wafers), which allows stacking and high-density packaging of integrated circuits **(IC),** often referred to as **"chips".** ICs are produced from semiconductor wafers that may undergo a multitude of processing steps under harsh conditions to produce a final package. Silicon wafers predominantly in use today have diameters of 200 mm and 300 mm from which hundreds of IC microchips can be made. Wafers can also be made of materials other than pure silicon and/or can be doped with metals such as B, Al, Ar, P, Li, Bi, Ga and combinations thereof. For the purposes of this disclosure, **"wafer"** refers to semiconductor wafers made from silicon, doped silicon and/or any other material.

Wafers are initially produced having a thickness of approximately 750 µm, which ensures mechanical stability and avoids warping during processing steps. These thick wafers are then ground down to application-specific thickness, typically 75 to 50 µm.

### Pendant polyimides

The present invention provides compounds with pre-imidized backbones and photopolymerizable, pendant functional groups, according to the following structural formulae **IA, IB, IC, and 1D**: 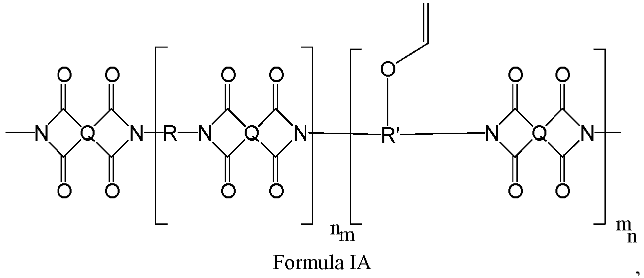 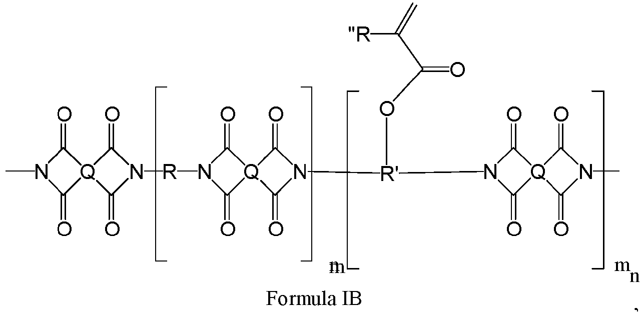 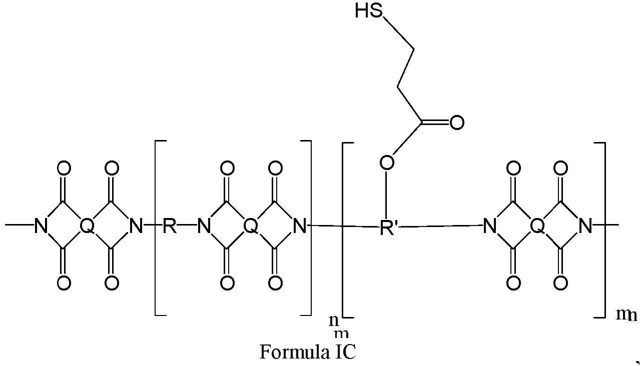 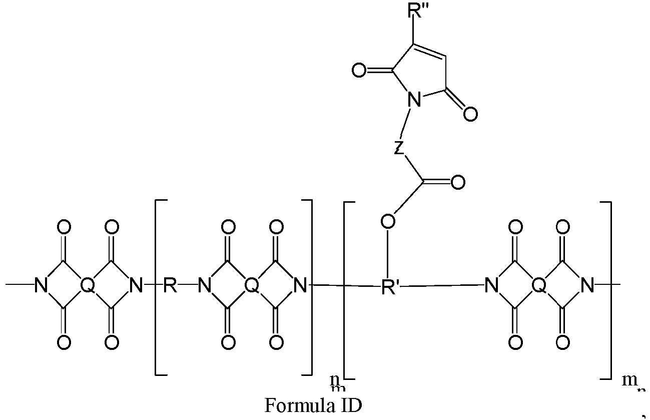 where R independently a substituted or unsubstituted aliphatic, cycloaliphatic, alkenyl, polyether, polyester, polyamide, aromatic, heteroaromatic, or siloxane moieties; R' is independently a diamine with alcohol functionality, such as 1,3-diamino-2-propanol or 3,5-diaminobenzyl alcohol; Each Q is independently a substituted or unsubstituted aliphatic, cycloaliphatic, alkenyl, polyether, polyester, polyamide, aromatic, heteroaromatic, or siloxane moiety; R" is hydrogen or methyl; z is independently a substituted or unstubstituted aliphatic or aromatic; and n and m are integers having a value from 10 to about 100; with the proviso the average molecular weight of curable polyimide is greater than 20,000 Daltons determined by gel permeation chromatography, wherein the curable, functionalized polyimide is the product of a condensation of at least one diamine selected from 1,3-diamino-2-propanol and 3,5-diaminobenzyl alcohol, with at least one dianhydride selected from the group consisting of: 4,4'-Bisphenol A dianhydride; pyromellitic dianhydride; 3,3',4,4'-benzophenone tetracarboxylic dianhydride; and 4,4'-oxydiphthalic anhydride, resulting in formation of a pendant alcohol, followed by functionalizing the pendant alcohol group.

The present invention provides temporary adhesive compositions suitable for backgrinding, dicing and other applications. The present invention is based in part on the observation that highly flexible, low surface energy temporary adhesives with high tensile strength are more easily removed than more rigid ones, coupled with the development of methods for synthesizing high molecular weight (>20,000 Daltons), flexible polyimides that are adhesive, but easily peeled off a surface to which they are applied.

The invention also provides articles coated on at least one side with a temporary adhesive described herein.

Compounds of formula **IA, IB, IC** and **ID** are also useful in many other applications. Adhesive compositions of the invention that include the polyimide of Formula are suitable for use in backgrinding and dicing processes, which increasingly require high temperature stability because the grinding and singulation processes typically create temperatures in excess of 250°C. Thus, the temporary adhesives of the invention are typically stable to temperatures of at least about 250°C, frequently to temperatures of at least about 300°C, and can remain stable at temperatures of about 350°C or higher during extended exposures to heat generated during backgrinding as well as other processes encountered during IC chip manufacturing. The high temperature stability of adhesives comprising polyimides of the invention is illustrated by the TGA diagrams, which show less than 2% weight loss at 350°C.

Moreover, temporary adhesive compositions of the invention experience little or no weight loss during curing or exposure to heating that would cause delamination from the wafer or support during high temperature processes. Furthermore, the temporary adhesive formulations of the invention are resistant to many common solvents that may be used in during electronic article manufacture yet are removable with other solvents. The temporary adhesive formulations of the invention are fully removable from wafers after the processes of backgrinding, patterning and dicing are complete.

### Preparation of Pendent Polyimides

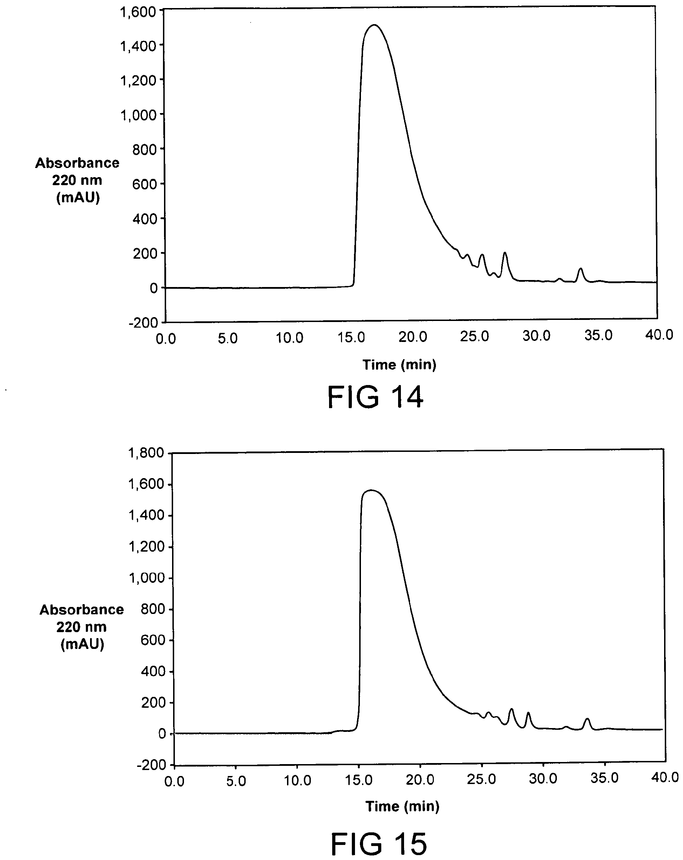

The polyimides of Formulae **IA, IB, IC and ID** are prepared by contacting at least two diamines with at least one dianhydride in a suitable solvent. The solvents used most often during polyimide synthesis are polar aprotic solvents such as *N*-Methyl-2-pyrrolidone (NMP), dimethylformamide (DMF), dimethylacetamide (DMAC), and dimethyl sulfoxide (DMSO). Very high molecular weight polyimides can be produced by adding the dianhydride to a diamine solution and stirring at room temperature for several hours. See **FIGs 14-21** (Compounds 1-B, 1-D, 1-E, 1-H, 2-A, 3-A and 4-A). The polyamic acid intermediate thus formed is very soluble in these polar aprotic solvents. An aromatic solvent such as toluene can be added to form an azeotrope with the water generated by thermal cyclodehydration during polyimide synthesis, thereby driving removal of the water. However, such solvents typically have very high boiling points and may need to be removed from the produced resin after the reaction is complete. Alternatively, the resin can be left in solution until needed; however, it may be difficult to remove all of the solvent from adhesive or other compositions or formulations without application of very high temperature, even when used as a thin film.

Alternative solvents for producing functionalized polyimides include aromatic solvents, particularly ether-functionalized aromatic solvents, such as anisole. Anisole is effective for dissolving polyimides as well the polyamic acid intermediate at high temperature. Anisole is relatively unreactive and produces polyimides with minimum color, whereas polar aprotic solvents produce polyimides that are very dark in color.

In one embodiment of the invention, functionalized polyimides are synthesized by adding diamines (one of which contains an alcohol moiety) to a reactor with anisole, followed by the addition of the dianhydride. Stirring nearly equivalent amount of diamine and dianhydride at room temperature produces the highest molecular weights. Although the polyamic acid intermediate may not be very soluble in ether solvents, as the mixture is slowly heated over 1 hour and as the temperature goes above 100° C, the components dissolve well, and the reaction is confirmed by the production of water. In certain cases, a small amount of polar aprotic solvent such as NMP, DMAC or DMF may also be added as a co-solvent to aid the solubility. After one to two hours of reflux, all the water is removed from the reaction and the fully imidized polymer is formed. A curable moiety can then be formed by converting the alcohol pendent group into a vinyl ether, a (meth)acrylate, a mercapto-ester or a maleimido-ester. The pendent ester moieties are formed via a reaction with the aid of an acid catalyst. In order to synthesize a product that is easily worked-up, a polymer bound sulfonic acid catalyst (Amberlyst^{®} 36 resin; Dow Chemical, Midland, Michigan) can be used. The beads of catalyst can simply be filtered out of solution after the reaction is complete. The pendent vinyl ether groups are produced via the transetherification reaction with an excess of butyl vinyl ether in the presence of palladium acetate phenanthroline complex.

A wide variety of diamines are contemplated for use in the practice of the invention, such as for example: dimer diamine; 1,10-diaminodecane; 1,12-diaminododecane; hydrogenated dimer diamine; 1,2-diamino-2-methylpropane; 1,2-diaminocyclohexane; 1,2-diaminopropane; 1,3-diaminopropane; 1,4-diaminobutane; 1,5-diaminopentane; 1,7-diaminoheptane; 1,8-diaminomenthane; 1,8-diaminooctane; 1,9-diaminononane; 3,3-diamino-N-methyldipropylamine; diaminomaleonitrile; 1,3-diaminopentane; 9,10-diaminophenanthrene; 4,4-diaminooctafluorobiphenyl; 3,5-diaminobenzoic acid; 3,7-diamino-2-methoxyfluorene; 4,4-diaminobenzophenone; 3,4-diaminobenzophenone; 3,4-diaminotoluene; 2,6-diaminoanthroquinone; 2,6-diaminotoluene; 2,3-diaminotoluene; 1,8-diaminonaphthalene; 2,4-diaminotoluene; 2,5-diaminotoluene; 1,4-diaminoanthroquinone; 1,5-diaminoanthroquinone; 1,5-diaminonaphthalene; 1,2-diaminoanthroquinone; 2,4-cumenediamine; 1,3-bisaminomethylbenzene; 1,3-bisaminomethylcyclohexane; 2-chloro-1,4-diaminobenzene; 1,4-diamino-2,5 -dichlorobenzene; 1,4-diamino-2,5 -dimethylbenzene; 4,4-diamino-2,2-bistrifluoromethylbiphenyl; bis(amino-3-chlorophenyl)ethane; bis(4-amino-3,5-dimethylphenyl)methane; bis(4-amino-3,5-diisopropylphenyl)methane; bis(4-amino-3,5 -methyl-isopropylphenyl)methane; bis(4-amino-3,5 -diethylphenyl)methane; bis(4-amino-3-ethylphenyl)methane; diaminofluorene; 4,4-(9-Fluorenylidene)dianiline; diaminobenzoic acid; 2,3-diaminonaphthalene; 2,3-diaminophenol; 3,5-diaminobenzyl alcohol; bis(4-amino-3-methylphenyl)methane; bis(4-amino-3-ethylphenyl)methane; 4,4-diaminophenylsulfone; 3,3' -diaminophenylsulfone; 2,2-bis(4,-(4-aminophenoxy)phenyl)sulfone; 2,2-bis(4-(3-aminophenoxy)phenyl)sulfone; 4,4-oxydianiline; 4,4-diaminodiphenyl sulfide; 3,4-oxydianiline; 2,2-bis(4-(4-aminophenoxy)phenyl)propane; 1,3-bis(4-aminophenoxy)benzene; 4,4-bis(4-aminophenoxy)biphenyl; 4,4-diamino-3,3-dihydroxybiphenyl; 4,4-diamino-3,3-dimethylbiphenyl; 4,4-diamino-3,3-dimethoxybiphenyl; Bisaniline M (4-[2-[3-[2-(4-aminophenyl)propan-2-yl]phenyl]propan-2-yl]aniline)]Bisaniline); Bisaniline P (4-[2-[4-[2-(4-aminophenyl)propan-2-yl]phenyl]propan-2-yl]aniline); 9,9-bis(4-aminophenyl)fluorene; o-tolidine sulfone; methylene bis(anthranilic acid); 1,3-bis(4-aminophenoxy)-2,2-dimethylpropane; 1,3-bis(4-aminophenoxy)propane; 1,4-bis(4-aminophenoxy)butane; 1,5-bis(4-aminophenoxy)butane; 2,3,5,6-tetramethyl-1,4-phenylenediamine; 3,3',5,5'-tetramehylbenzidine; 4,4'-diaminobenzanilide; 2,2-bis(4-aminophenyl)hexafluoropropane; polyoxyalkylenediamines;1,3-cyclohexanebis(methylamine); m-xylylenediamine; p-xylylenediamine; bis(4-amino-3-methylcyclohexyl)methane; 1,2-bis(2-aminoethoxy)ethane; 3(4),8(9)-bis(aminomethyl)tricyclo(5.2.1.0^{2,6})decane; ethanolamine; 1,3-cyclohexanebis(methylamine); 1,3-diamino-2-propanol; 1,4-diaminobutane, 1,5-diaminopentane; 1,6-diaminohexane; 2,2-bis[4-(3-aminophenoxy)phenyl]propane; 2,3,5-tetramethylbenzidine; 2,3-diamononaphtalene; polyalkylenediamines (e.g. Huntsman's Jeffamine^{®} D-230, D-400, D2000, and D-4000 products), and any other diamines or polyamines, especially if they contain an alcohol moiety.

A wide variety of dianhydrides are also contemplated for use in the practice of the invention, including: 4,4'-Bisphenol A dianhydride; pyromellitic dianhydride; 1,2,3,4-cyclobutanetetracarboxylic dianhydride; 1,4,5,8-naphthalenetetracarboxylic dianhydride; 3,4,9,10-perylenentetracarboxylic dianhydride; bicyclo(2.2.2)oct-7-ene-2,3,5,6-tetracarboxylic dianhydride; diethylenetriaminepentaacetic dianhydride; ethylenediaminetetraacetic dianhydride; 3,3',4,4'-benzophenone tetracarboxylic dianhydride; 3,3',4,4'-biphenyl tetracarboxylic dianhydride; 4,4'-oxydiphthalic anhydride; 3,3',4,4'-diphenylsulfone tetracarboxylic dianhydride; 2,2'-bis(3,4-dicarboxyphenyl)hexafluoropropane dianhydride; 4,4'-bisphenol A diphthalic anhydride; 5-(2,5-dioxytetrahydro)-3-methyl-3-cyclohexene-1,2-dicarboxylic anhydride; ethylene glycol bis(trimellitic anhydride); hydroquinone diphthalic anhydride; 1,2,3,6-tetrahydrophthalic anhydride; 3,4,5,6-tetrahydrophthalic anhydride; 1,8-naphthalic anhydride; glutaric anhydride; dodecenylsuccinic anhydride; hexadecenylsuccinic anhydride; hexahydrophthalic anhydride; methylhexahydrophthalic anhydride; tetradecenylsuccinic anhydride; and the like. Use of mono-anhydrides terminates the polymer.

Additional dianhydrides contemplated for use include, but are not limited to: 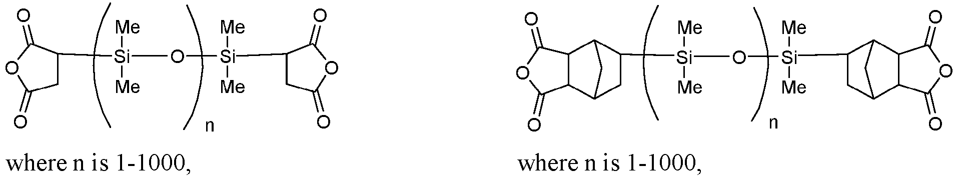 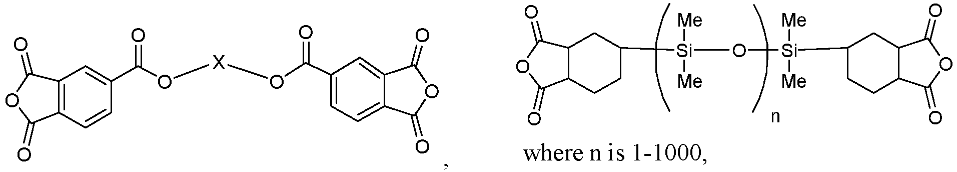 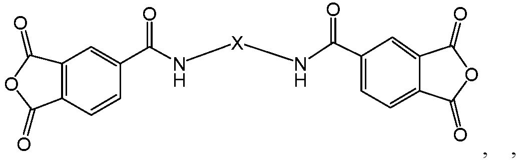 where X is saturated, unsaturated, strait or branched alkyl, polyester, polyamide, polyether, polysiloxane or polyurethane;

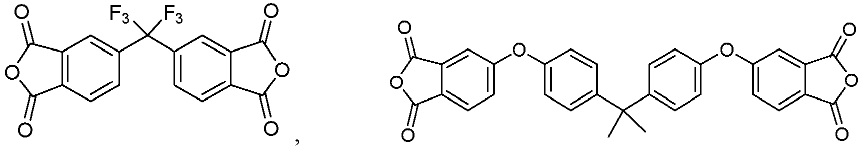

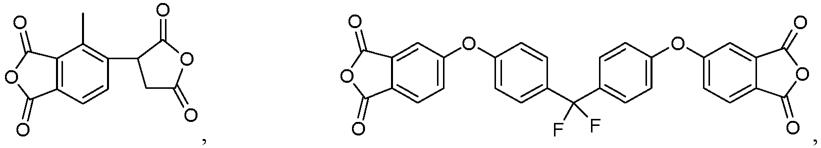

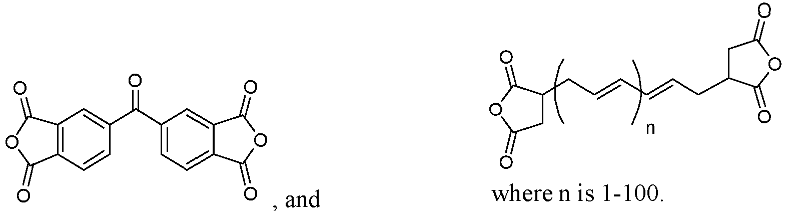

In another embodiment, the invention provides coating and passivation formulations comprising:
A. at least one curable, functionalized polyimide described here;
B. at least one reactive diluent; and
C. a solvent in which the functionalized polyimide is soluble.

In certain aspects, the formulation may also include:
D. one or more adhesion promoters;
E. one or more coupling agents; and
F. one or more UV initiators.

In certain embodiments, the present invention provides chain-propagated polyimide polymers having a flexible aliphatic backbone in place of the aromatic ether backbone found in conventional polyimide polymers, while having the same high temperature resistance due to their imide linkage. Polyimide polymers of the invention display lower shrinkage than conventional polyimide polymers due to the chain propagation mechanism, thereby reducing stress on wafers passivated with such polymers. Taken together, the materials of the invention reduce the potential for delamination and warpage of semiconductor interconnection layers.

The polyimides are suitable for use in preparing redistribution layers, passivation layers and other chip coatings and are less subject to stress effects than prior polyimides. Therefore, the polyimides of the present invention and formulations thereof, are compatible with very thin silicon wafers.

In other embodiments, the curable functionalized polyimides may be combined with other monomers, such as thermoset monomers, and reactive diluents, fillers, and flame-retardants to make fully formulated curable compositions.

Co-monomers suitable for use in the polyimide containing composition include but are not limited to, acrylates methacrylates, acrylamides, methacrylamides, maleimides, vinyl ethers, vinyl esters, styrenic compounds, allyl functional compounds, epoxies, epoxy curatives, benzoxazines, cyanate esters, polyphenylene oxides (PPO), polyphenylene ethers (PPE), and olefins.

In certain embodiments of the invention the co-monomers used in compositions with the pendent curable polyimides are based on polyimides that contain a terminal curable moiety, such as the following generic example. 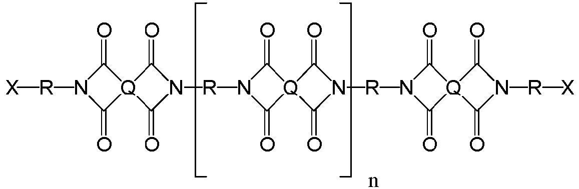 Wherein, R and Q are each independently a substituted or unsubstituted aliphatic, alkenyl, aromatic or siloxane; X is a curable moiety.

Various molecular weight compounds of the above example are commercially available from Designer Molecules, Inc., San Diego California. Examples of the compounds include the following trade names: BMI-689; BCI-737; BCI-1500; BMI-1500; BMI-1550; BMI-1700; BCI-3000; BMI-3000; BMI-2500; BMI-4100; BMI-6000; BMI-6100 and ILR-1363.

Free radical initiators also include photoinitiators. For compositions of the invention that contain a photoinitiator, the curing process can be initiated, for example, by UV radiation. In one embodiment, the photoinitiator is present at a concentration of 0.1 wt % to 10-wt %, based on the total weight of the composition (excluding any solvent).

Photoinitiators include benzoin derivatives, benzilketals, α,α-dialkoxyacetophenones, α-hydroxyalkylphenones, α-aminoalkylphenones, acylphosphine oxides, titanocene compounds, combinations of benzophenones and amines or Michler's ketone.

In some embodiments, both photoinitiation and thermal initiation may be desirable. For example, curing of a photoinitiator-containing composition can be started by UV irradiation, and in a later processing step, curing can be completed by the application of heat to accomplish a free-radical cure. Both UV and thermal initiators may therefore be added to the adhesive compositions of the invention.

Inhibitors for free-radical cure may also be added to the compositions described herein to extend the useful shelf life. Examples of free-radical inhibitors include hindered phenols such as 2,6-di-tert-butyl4-methylphenol; 2,6-di-tert-butyl-4-methoxyphenol; tert-butyl hydroquinone; tetrakis (methylene (3,5-di-tert-butyl-4-hydroxyhydrocinnamate)) benzene; 2,2'-methylenebis(6-tertbutyl-p-cresol); and 1,3,5-trimethyl-2,4,6-tris(3',5'-di-tertbutyl-4-hydroxybenzyl) benzene. Other useful hydrogen donating antioxidants such as derivatives of p-phenylenediamine and diphenylamine. It is also well known in the art that hydrogen-donating antioxidants may be synergistically combined with quinones and metal deactivators to make a very efficient inhibitor package. Examples of suitable quinones include benzoquinone, 2-tert butyl-1,4-benzoquinone; 2-phenyl-1,4-benzoquinone; naphthoquinone, and 2,5-dichloro-1,4-benzoquinone. Examples of metal deactivators include N,N'-bis(3,5-di-tert-butyl-4-hydroxyhydrocinnamoyl)hydrazine; oxalyl bis(benzylidenehydrazide); and N-phenyl-N'-(4-toluenesulfonyl)-p-phenylenediamine amine.

Nitroxyl radical compounds such as TEMPO (2,2,6,6-tetramethyl-1-piperidnyloxy, free radical) are also effective as inhibitors at low concentrations. The total amount of antioxidant plus synergists typically falls in the range of 100 to 2000 ppm relative to the weight of total base resin. Other additives, such as adhesion promoters, in types and amounts known in the art, may also be added.

Fillers contemplated for use in the practice of the invention include but are not limited by materials such as: graphite; perfluorinated hydrocarbons (Teflon^{™}); boron nitride; carbon nanotubes; silica nano-particles; polyhedral oligomeric silsesquioxane (POSS^{™}) nanoparticles . The fillers contemplated for use will affect the dielectric properties of the compositions, they will affect the Tg and CTE, as well as the flammability rating of the composition.

Flame retardants contemplated for use in the practice of the invention include but are not limited to organophosphorous compounds.

### Redistribution Layers

Redistribution layers are a type of passivation material that provide a way to make the bond pads in one location on a chip available in other locations on a chip, or beyond (e.g., in the case of fan-out packages, described below). Using RDL, bond pads can be functionally moved around the face of the die for flip-chip applications, which can separate narrowly spaced, or high-density sites for solder balls, and thereby distribute the stress of mounting. In stacked die packages, RDL layers allow unique positions for address lines using identical generic chips. Furthermore, bond pads can be moved to more convenient locations based on the overall geometry of the chip and surrounding packages and connections.

### Fan-out RDL

Redistribution layers have traditionally been used on the surface of single chips. However, the emerging technology of "fan-out" wafer level packaging (FOWLP) has significantly expanded the need and therefore the use of RDL. FOWLP (which is distinguished from "fan-in" WLP, described above), expands IC chip surface area by embedding a singulated chip in a molded package that is fabricated post-singulation. Multiple chips can be molded into the same package and the original I/O pads can then be redistributed to the fan-out regions of package. Redistribution layers make relatively inexpensive low CTE polymer (e.g., epoxy) molds suitable for carrying the delicate metallization lines from a silicon chip to a fan-out region, thereby redistributing the I/O pads across a substantially increased surface area.

The present invention thus provides polymer formulations suitable for use in RDL. According to embodiments of the present invention, there is provided devices comprising a semiconductor wafer or other substrate and a redistribution layer disposed on the surface of the wafer, or substrate. The redistribution layer pre-imidized or partially imidized backbone with a photopolymerizable functional group, having a structure according to any of Formulae **IA, IB, IC** and **ID.**

The polyimides of this invention are fully imidized and are soluble in common organic solvents such as aromatic solvents or ketones required for the coating application. Furthermore, once UV cured, the polyimides of the invention are developable in common solvents such as cyclopentanone.

Advantageously, polyimides of the present invention are photoimagable, thereby allowing patterning of the redistribution layer. For example, a redistribution polymer formulation of the invention can be applied to the surface of an IC chip and/or fan-out package, and then photoimaged to remove areas designated for via holes or for UBM (Under Bump Metallization) sites, so as to allow subsequently sputtered and plated metallization to make contact with the bottom metallization layer to facilitate high density connections.

Another desirable feature of the polyimides of the invention is that they have much lower moisture uptake than traditional polyimide coatings. Therefore, the there is little risk that the RDL formulations will subject delicate metallization to corrosive conditions.

### Prepregs, Copper-clad laminates and Printed Circuit Boards

The present invention also provides compositions for making prepregs (reinforcement fiber pre-impregnated with a resin), copper clad laminates and printed circuit boards. Also provided are prepregs, copper-clad laminates and printed circuit boards comprising polyimides of the invention.

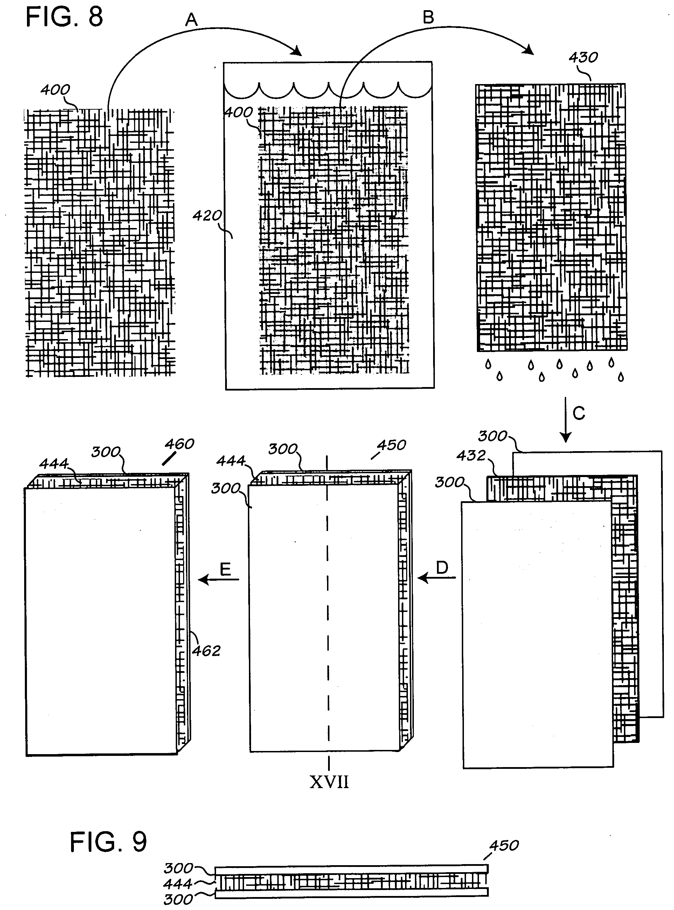

Copper clad laminates and printed circuit boards is illustrated in **FIG 8****.** Steps in the process are indicate by arrows. The process begins with a reinforcing fiber **400** such as, fiberglass or carbon fiber. The fiber can be in the form of a woven or unwoven fabric, or single strands of fiber that will be held together by the polymer. The fiber **400** is immersed in a liquid formulation **420** containing an uncured polyimide described herein (step **A),** thereby impregnating the fiber with the polyimide formulation to form a prepreg. The wet prepreg **430** is then dried to remove excess solvent (step **B).** Conveniently, the dried prepreg **432** can then be stored until needed.

The dried prepreg will typically be coated on one or both side with a layer of copper to form a copper-clad laminate (CCL). The copper can be applied by electroplating or by laminating thin copper foil to the prepreg. **FIG 8** illustrates preparation of a double-sided using copper foil **300.** Thus. in step **C,** the dried prepreg **432** is assembled in a sandwich fashion with a sheet of copper foil **300** on either side. Optionally, layers of adhesive can be interleaved between the foil to increase adhesion (not shown). This is likely unnecessary because polyimides of the invention have strong adhesive properties. In some embodiments, adhesion promoters can be added to formulation 420 to increase bonding of the foil to the prepreg. In step **D,** the foil **300** is laminated to the prepreg **432** using heat and pressure. Advantageously, polyimides of the invention can be cured using heat. **FIG 9** shows a cross section of CCL **450** having a central core of fiber-reinforced, cured polyimide 444, laminated to copper foil **300** on each side.

Circuit patterns **462** can then be formed on either or both sides of the CCL **450** by photolithography to from a printed circuit board (PCB). **460.** The resulting PCB exhibits the high structural strength and heat resistance necessary for contemporary electronics applications.

### Flexible Copper-Clad Laminates

The compounds and compositions of the invention are useful in any application that requires flexibility. In particular, flexible copper clad laminates (FCCLs) are increasingly used in electronics as they can provide the ultrathin thin profile demanded by increasing miniaturization. Moreover, circuitry is becoming prevalent in non-traditional situations, such as clothing, where the ability to conform to a three-dimensional shape other than a flat board is required.

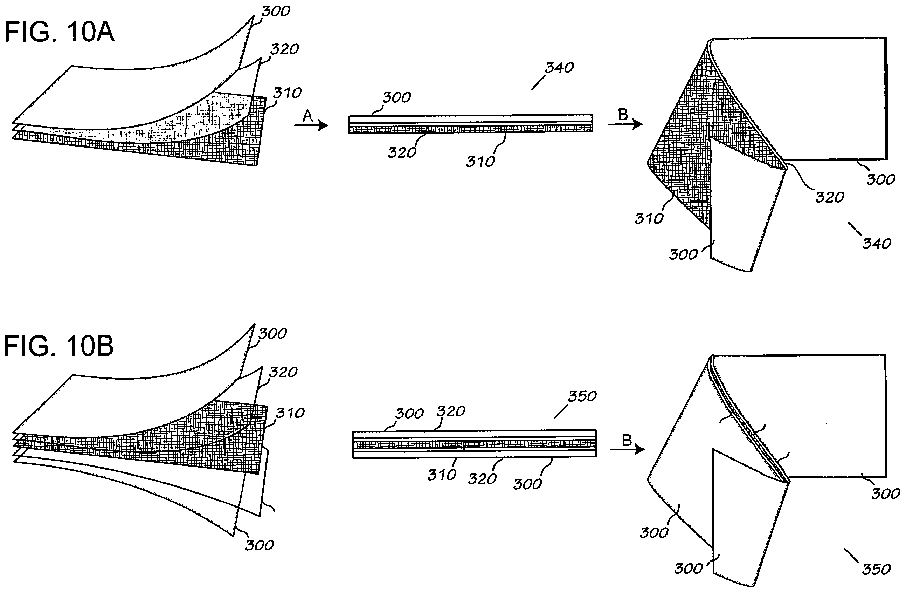

FCCL are illustrated in **FIGs 10A** and **10B** for single- and double-sided FCCLs respectively. A thin and flexible film of polyimide polymer **310** prepared as described herein, is assembled with an adhesive layer **320** and copper foil **300 (****FIG 10A****).** The assembly is then laminated (step **A)** to form a single-sided copper clad laminate **340.** The FCCL can then be rolled, bent or formed as needed (step B), while providing the basis for thin, flexible circuitry that can be used in consumer electronics, clothing and other goods.

Double-sided FCCL production is illustrated in **FIG 10B****.** The adhesive layer 320 and copper foil **300** are placed on both sides of polymer film **310** to form a 5-layer assembly, which is then laminated (step **A**) to form a double-sided FCCL **350.**

Double-sided, adhesiveless FCCL can be prepared (FIG 10B) in the same manner as the single-sided product, except that both sides of film 310 are contacted with foil **300** prior to curing (step **B).** The double-sided adhesiveless FCCL **352** can similarly be rolled, shaped, and formed (step **B).**

Application of circuit traces to FCCL can be performed using standard photolithography processes develop for patterning printed circuit boards.

### EXAMPLES

### MATERIALS AND METHOD

### Dynamic mechanical analysis (DMA)

Polymer formulations were prepared in a suitable solvent (e.g. anisole) with <5% dicumyl peroxide (Sigma-Aldrich, St. Louis MO), and 500 ppm inhibitor mix (Designer Molecules, Inc.; Cat. No. A619730; weight% p-Benzoquinone and 70 weight% 2,6-di-tert-butyl-4-methylphenol) and dispensed into a to 5 inch × 5 inch stainless steel mold. The mixture was then vacuum degassing and the solvent (e.g. anisole) was allowed to slowly evaporate at 100°C for ~16 hours in an oven. The oven temperature was then ramped to 180°C and hold for 1 hour for curing. Then the oven temperature was ramp to 200°C and h11d for 1 hour before cooling to room temperature. The resulting film (400-800 um) was then released from mold and cut into strips (≃ 2 inch x ≃7.5 mm) for measurement.

The strips were analyzed on a Rheometrics Solids Analyzer (RSA ii) (Rheometric Scientific Inc.; Piscataway, N.J.) with a temperature ramp from 25 to 250°C at a rate of 5°C/min under forced air using the Dynamic Temperature Ramp type test with a frequency of 6.28 rad/s. The autotension sensitivity was 1.0 g with max autotension displacement of 3.0 mm and max autotension rate of 0.01 mm/s. During the test, maximum allowed Force was 900.0 x g and min allowed force is 3.0 x g. Storage modulus and loss modulus temperature were plotted against and temperature. The maximum loss modulus value found was defined as the glass transition (T_{g}).

### Coefficient of Thermal Expansion (CTE)

Formulations were prepared as above for DMA. Samples sufficient to give a 0.2 mm to 10 mm thick film were dried at 100°C for 2 hours to overnight and cured for 1-2 hours at ≃180°C to ≃250°C.

Hitachi TMA 7100 was used for CTE measurement. The film was placed on the top of a sample holder (disk type quartz) and move down quartz testing probe was lowered onto top of the sample to measure sample thickness. The temperature ramped from 25°C to250°C at a 5°C/min, load 10 mN to measure expansion/compression. CTE was calculated as the slope of length change verses temperature change in ppm/°C. α1 CTE and α2 CTE are calculated based on T_{g}.

### Thermalgravimetric analysis (TGA)

Thermalgravimetric analysis measurements were performed on an TGA-50 Analyzer (Shimadzu Corporation; Kyoto, Japan) under an air flow of 40 mL/min with heating rate of 5°C/min to or 10°C/min. The sample mass lost versus temperature change was recorded and the decomposition temperature was defined at the temperature at which the sample lost 5% of its original mass.

### Tensile Strength and Percent Elongation

Samples were dried to remove solvent at 100°C for 2 hours to overnight and cured for 1-2 hours at 180°C ~250°C in a metal mold to obtain thin films. Test strip film dimension for test was 6 inch x 0.5 inch x 0.25 inch; measurement length 4.5 inches.

The tensile strength and percent elongation were measure using an Instron 4301 Compression Tension Tensile Tester. Tensile strength was calculated as the ratio of load verses sample cross-section area (width x thickness). Percent elongation was calculated as the ratio of original length of sample (4.5 inch) verses length at break point.

### Permittivity / Dielectric Constant (Dk) and Loss Tangent / Dielectric Dissipation Factor (Df)

Formulations were prepared as above for DMA, except that a 2 inch x 2 inch film was cut for analysis.

Dk and Df measurements were carried out by National Technical Systems (Anaheim, CA, USA) with IPC TM-650 2.5.5.9 as the test procedure. The samples were placed in a conditioning cabinet at 23 ± 2°C and 50 ± 5% relative humidity for 24 hours prior to testing, which was performed at measured conditions of 22.2°C and 49.7% relative humidity. One sweep of the impedance material analyzer was performed with an oscillatory voltage of 500 mV at 1.5 GHz and the sweep was performed between 99.5% and 100.5% of the desired value (1.4925 GHz and 1.5075 GHz).

### Gel Permeation Chromatography

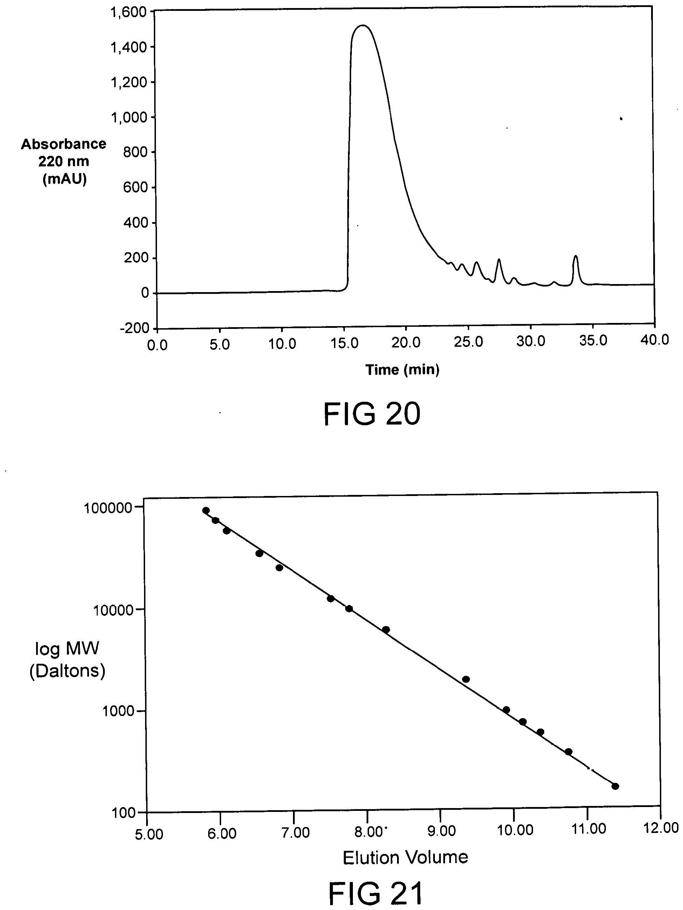

Gel permeation chromatography analysis of polymer molecular weight was carried out on an Ultimate 3000 HPLC instrument (Thermo Scientific; Carlsbad, CA) using tetrahydrofuran (THF) as eluent solvent and polystyrene standards as reference for molecular weight (MW) calculation based on the retention time of the polymer samples. The standards used had MWs of: 96,000; 77,100; 58,900; 35,400; 25,700; 12,500; 9,880; 6,140; 1,920; 953; 725; 570; 360; and162. UV-vis detecting mode was applied at wavelength 220 nm and 10 mg/mL polymer in THF solution were used for testing. The standard curve is given in **FIG 21****.**

### Spin Coating and Photolithography

A silicon wafer was secured on the middle of a spin coater and spun at low rpm (550 rpm) while dropping material on rotating wafer surface over approximately 5-10 seconds. The speed was increased to 1,150 rpm and spin for 15 seconds. The coated wafer was dried in an oven at 100°C for 5-15 min

A photomask was placed on the coated wafer and exposed to UV (I-line, 365nm) for 50 sec to achieve 500mJ to cure exposed area. Film thickness was measured post-UV-cure, using a surface profiler.

The film was developed in cyclopentanone or propylene glycol methyl ether acetate (PGMEA) and tetramethlyammonium hydroxide (TMAH) to remove uncured areas of film (negative type photolithography).

Films were air dried post development and film thickness measured to calculate film thickness loss due to development. Film thickness was again measured following curing at 100°C for 1 hour.

### Chemicals

Unless another supplier is indicated, chemicals were purchased from TCI America, Portland OR.

### POLYIMIDES WITH VINYL PENDANT GROUPS

### EXAMPLE 1: Synthesis of Vinyl Pendent Polyimide (1-A)

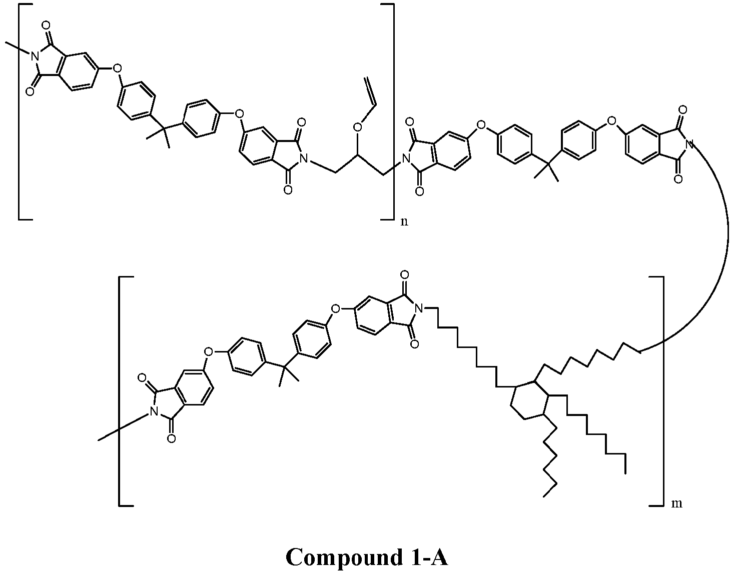

A 3 L reactor was charged with the following ingredients: 9.0 g (100 mmol) 1,3-diamino-2-propanol, 219.6 g (400 mmol) Priamine^{™} 1075 (C₃₆-dimer diamine; Croda, Edison, NJ) and 1500 g of anisole (methoxybenzene). The solution was stirred while 261.0 g (500 mmol) 4,4'-Bisphenol A dianhydride (BPADA) was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by the recovery of (18.0 mL) the theoretical yield of water, producing an alcohol pendent polyimide.

The solution was cooled down to about 75°C and a large excess (500.0 g, 5.0 mol) of butyl vinyl ether was added to the reactor along with 1.0 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product. ¹H NMR data were consistent with an aliphatic/aromatic polyimide. Infrared spectroscopy confirmed the presence of the imide carbonyl group and vinyl group. The FTIR spectrum of the sample showed major bands at 3065, 1712, 1615, 1232 and 734 wavenumbers.

### EXAMPLE 2: Synthesis of Vinyl Pendent Polyimide 1-B

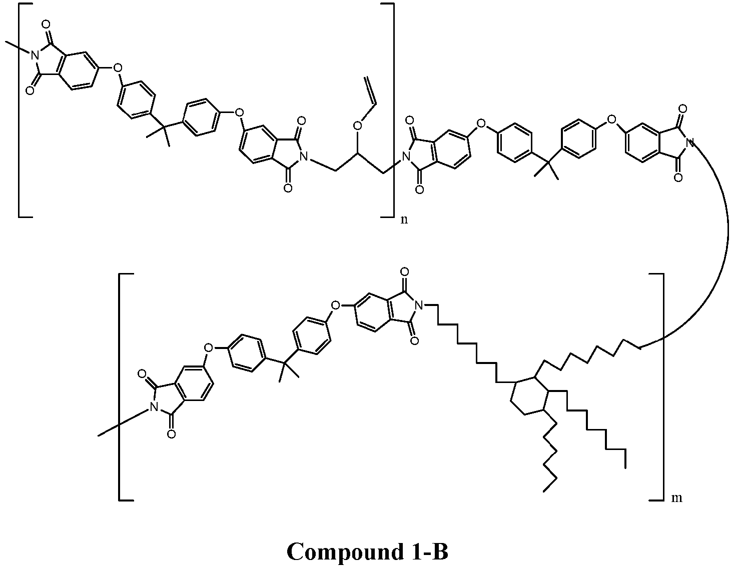

A 3 L reactor was charged with the following ingredients: 6.75 g (75 mmol) 1,3-diamino-2-propanol, 233.4 g (425 mmol) Priamine^{™} 1075, and 1500 g of anisole. The solution was stirred while 261.0 g (500-mmol) BPADA was added to the flask. The mixture was heated to reflux temperature of about 155° C. During the heating, the dianhydride slowly started to dissolve and produced a turbid solution. As the polyimide was generated, the water produced was condensed and collected in a Dean-Stark trap. After 1.5 hours, the reaction was complete as indicated by the recovery of (18.0 mL) the theoretical yield of water, producing an alcohol pendent polyimide.

The solution was cooled down to about 75°C and a large excess (3.75 mol, 375.0 g) of butyl vinyl ether was added to the reactor along with 0.75 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

**Molecular Weight** was analyzed as described above by gel permeation chromatography. See **FIG 14****.** The estimated molecular weight of **Compound 1-B** was calculated to be 55,000 Daltons.

¹H NMR data were consistent with an aliphatic/aromatic polyimide. Infrared spectroscopy confirmed the presence of the vinyl group and imide carbonyl group. The FTIR spectrum of the sample showed major bands at 3065, 1713, 1615, 1232, 839, and 747 wavenumbers.

### EXAMPLE 3: Synthesis of Vinyl Pendent Polyimide 1-C

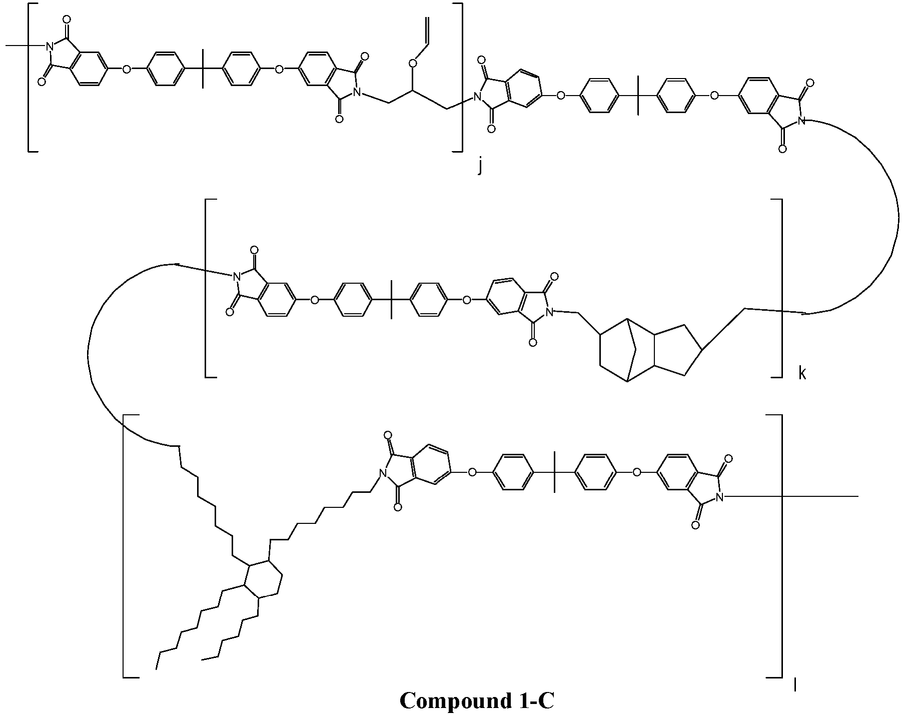

A 3 L reactor was charged with the following ingredients: 4.5 g 1,3-diamino-2-propanol (50 mmol), 9.7 g (50 mmol) tricyclodecanediamine (TCD-DA), 219.4 g (400 mmol) Priamine^{™} 1075, and 1500 g of anisole. The solution was stirred while 261.0 g (500-mmol) BPADA was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of (18.0 mL) the theoretical yield of water, producing an alcohol pendent polyimide.

The solution was cooled down to about 75°C and a large excess (2.5 mol; 250.0 g) of butyl vinyl ether was added to the reactor along with 0.5 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

¹H NMR data were consistent with an aliphatic/aromatic polyimide. Infrared spectroscopy confirmed the presence of the vinyl group and the imide carbonyl. The FTIR spectrum of the sample showed major bands at 3065, 1713, 1615, 1599, 1238, 831, and 733 wavenumbers.

### EXAMPLE 4: Synthesis of Vinyl Pendent Polyimide 1-D

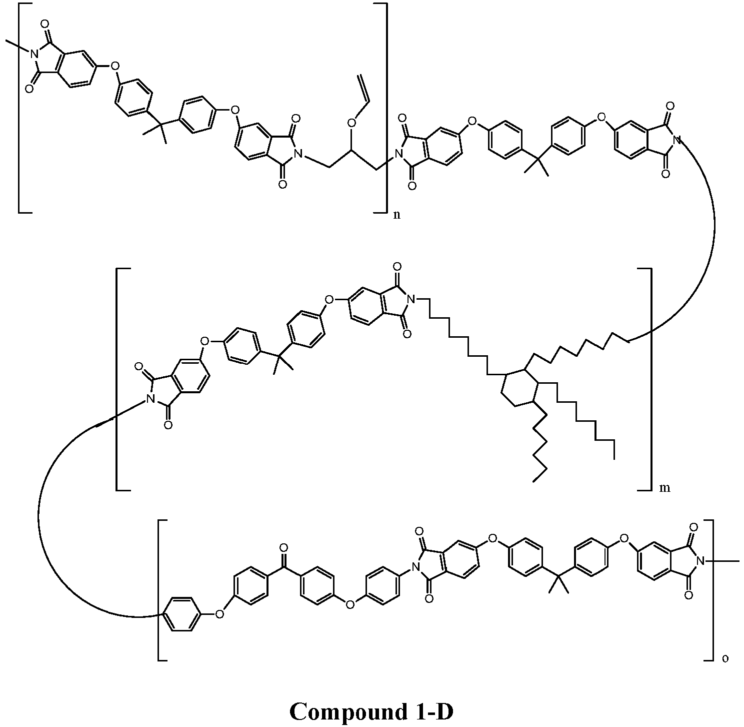

A 3 L reactor was charged with the following ingredients: 5.4 g (60 mmol) 1,3-diamino-2-propanol, 39.6 g (100 mmol) BAPB (4,4'-Bis (4-aminophenoxy) benzophenone), 86.7 g (340 mmol) Priamine^{™} 1075, and 1500 g of anisole. The solution was stirred while 261.0 g (500-mmol) BPADA was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0 mL) theoretical yield of water, producing an alcohol pendent polyimide.

The solution was cooled down to about 75°C and a large excess (3.0 mol, 300.0 g) of butyl vinyl ether was added to the reactor along with 0.6 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

**Molecular Weight** was analyzed as described above by gel permeation chromatography. See **FIG 15****.** The estimated molecular weight of **Compound 1-D** was calculated to be 75,000 Daltons.

¹H NMR data were consistent with aliphatic/aromatic polyimide. Infrared spectroscopy confirmed the presence of the vinyl group and imide carbonyl group. The FTIR spectrum of the sample showed major bands at 3055, 1711, 1612, 1599, 1233, 840, and 739 wavenumbers.

### EXAMPLE 5: Synthesis of Vinyl Pendent Polyimide 1-E

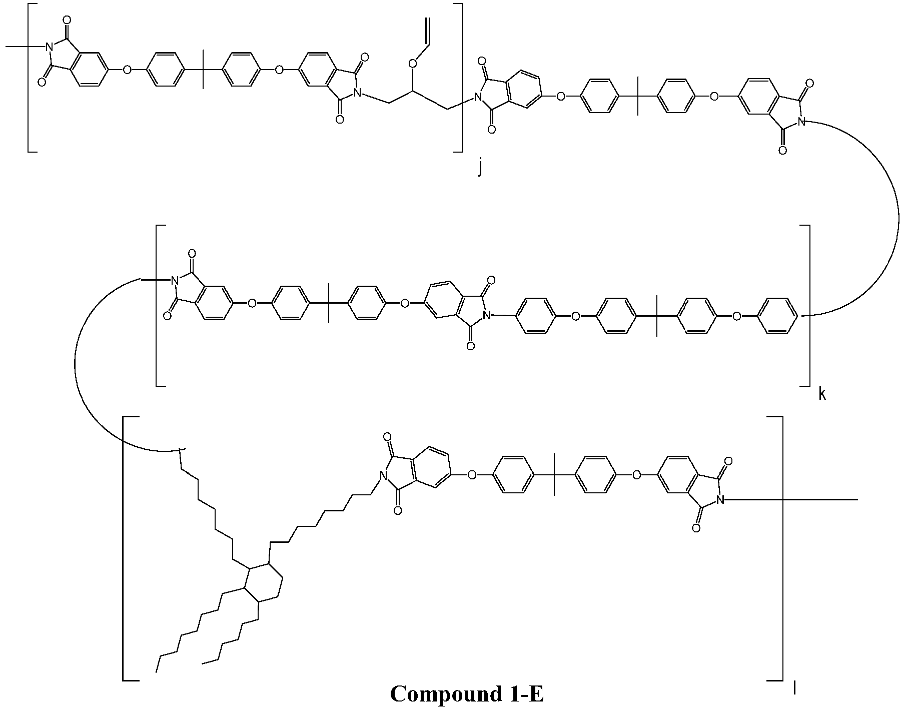

A 3 L reactor was charged with the following ingredients: 9.0 g (100 mmol) 1,3-diamino-2-propanol, 10.3 g (25 mmol) BAPPP (2,2-Bis[4-(4-aminophenoxy)phenyl]propane), 205.9 g (375 mmol) Priamine^{™} 1075, and 1500 g of anisole. The solution was stirred while 261.0 g (500 mmol) BPADA was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0 mL) theoretical yield of water, producing an alcohol pendent polyimide.

The solution was cooled down to about 75°C and a large excess (5.0 mol, 500.0 g) of butyl vinyl ether was added to the reactor along with 1.0 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

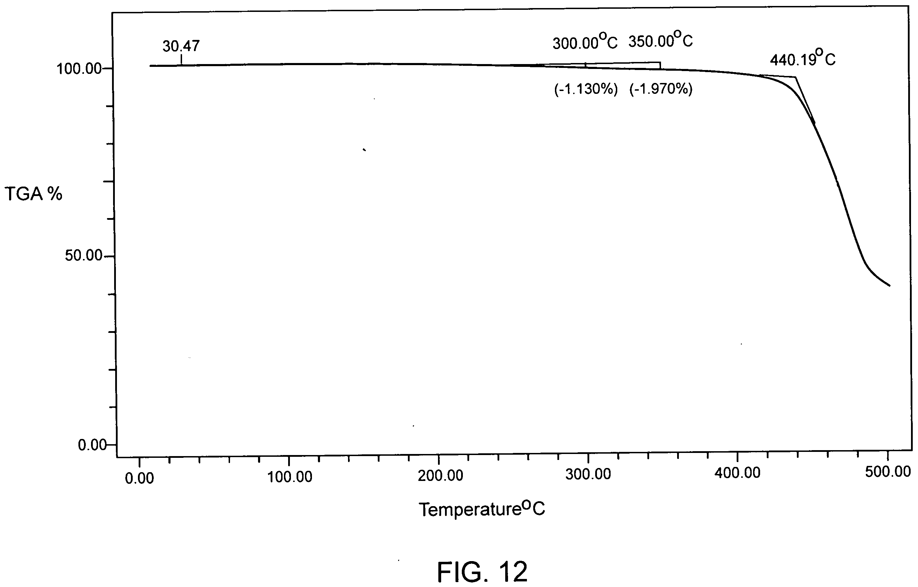

**Thermal Stability.** The thermal stability of this compound was demonstrated by TGA analysis (performed as described above). The compound had less than 2% weight loss at 350°C and an onset of thermal degradation at 440.19°C. See **FIG 12****.**

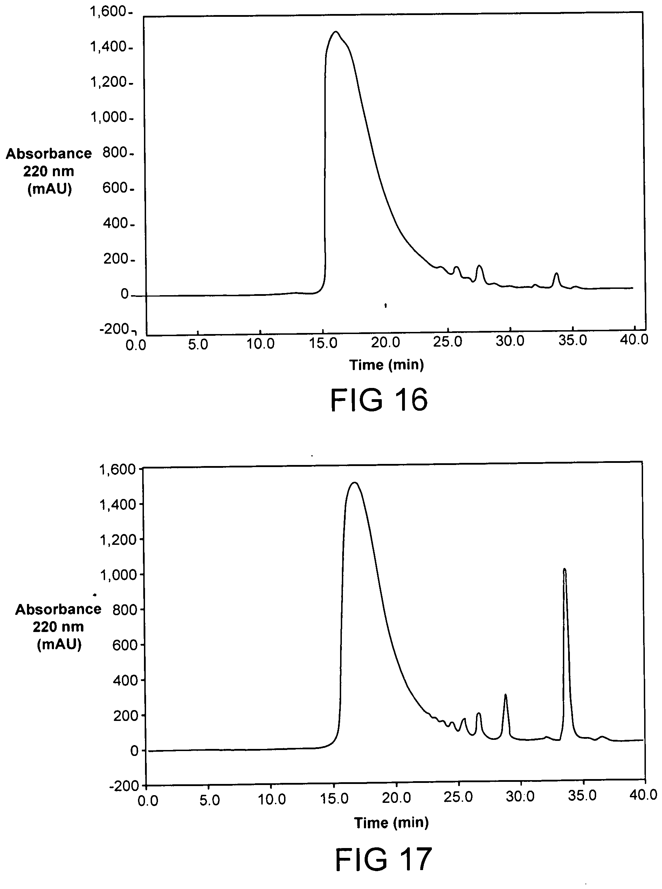

**Molecular Weight** was analyzed as described above by gel permeation chromatography. See FIG 16. The estimated molecular weight of **Compound 1-E** was 75,000 Daltons.

¹H NMR data were consistent with an aliphatic/aromatic polyimide. Infrared spectroscopy confirmed the presence of the vinyl group and the imide carbonyl group. The FTIR spectrum of the sample showed major bands at 3056, 1712, 1613, 1601, 1237, 839, and 734 wavenumbers.

### EXAMPLE 6: Synthesis of Vinyl Pendent Polyimide 1-F

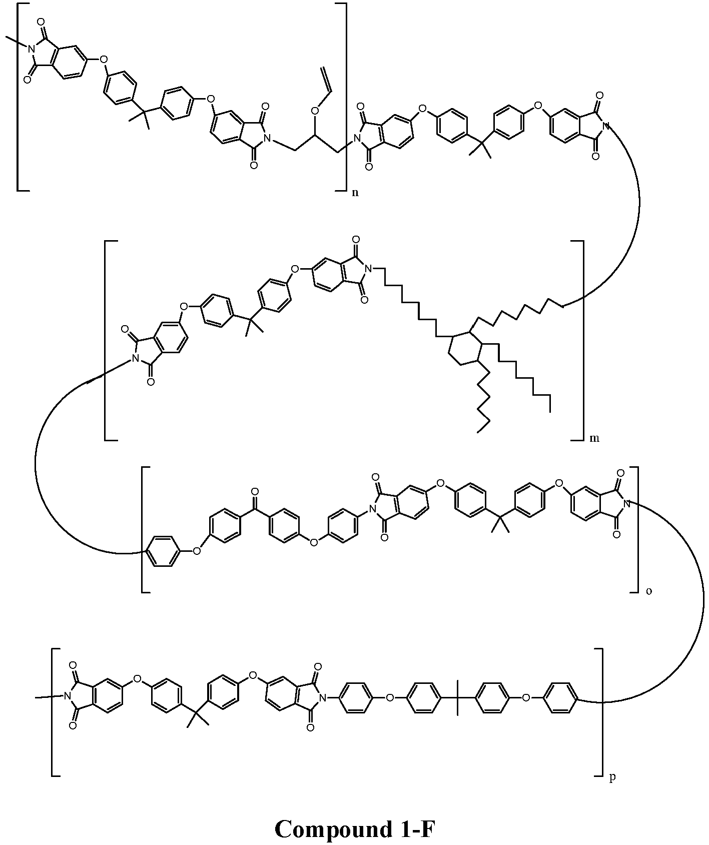

A 3 L reactor was charged with the following ingredients: 3.4 g (37.5 mmol) 1,3-diamino-2-propanol, BAPB (112.5 mmol, 44.6 g), 61.6 g (150.0 mmol) BAPPP, 109.6 g (200 mmol) Priamine^{™} 1075, and 1500 g of anisole. The solution was stirred while 261.0 g (500-mmol) bisphenol-A-dianhydride (BPADA) was added to the flask. The mixture was heated to reflux temperature of about 155° C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0 mL) theoretical yield water, producing an alcohol pendent polyimide.

The solution was cooled down to about 75°C and a large excess (1.88 mol, 188.0 g) of butyl vinyl ether was added to the reactor along with 0.4 g of palladium acetate phenanthroline complex as a catalyst for the transetherification reaction. The solution was stirred for about 5 hours at 75° C and then stirred overnight at room temperature. The product was vacuum distilled to remove the excess butyl vinyl ether and some of the excess anisole to produce about a 25% solids solution of the vinyl pendant polyimide product.

Infrared spectroscopy confirmed the presence of the vinyl group and the imide carbonyl group. The FTIR spectrum of the sample showed major bands at 3055, 1712, 1615, 1601, 1238, 839, and 736 wavenumbers.

### EXAMPLE 7: Synthesis of Vinyl Pendent Polyimide 1-G

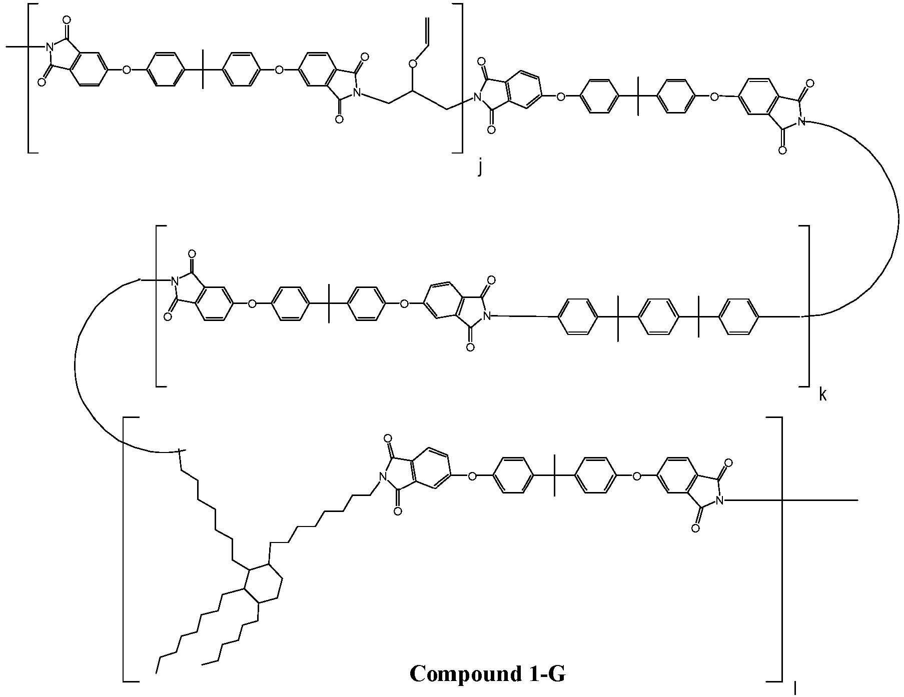

A 3 L reactor was charged with the following ingredients: 9.0 g (100 mmol) 1,3-diamino-2-propanol, 77.5 g (225.0 mmol) Bisaniline P, 96.1 g (175.0 mmol) Priamine^{™} 1075, and 1500 g of anisole. The solution was stirred while 261.0 g (500-mmol) BPADA was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0 mL) theoretical yield of water, producing an alcohol pendent polyimide.

The solution was cooled down to about 75°C and a large excess (5.0 mol, 500.0 g) of butyl vinyl ether was added to the reactor along with 1.0 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

¹H NMR data were consistent with an aliphatic/aromatic polyimide. Infrared spectroscopy confirmed the presence of the vinyl group and the imide carbonyl group. The FTIR spectrum of the sample showed major bands at 3055, 1713, 1613, 1600, 1232, and 734 wavenumbers.

### EXAMPLE 8: Synthesis of Vinyl Pendent Polyimide 1-H

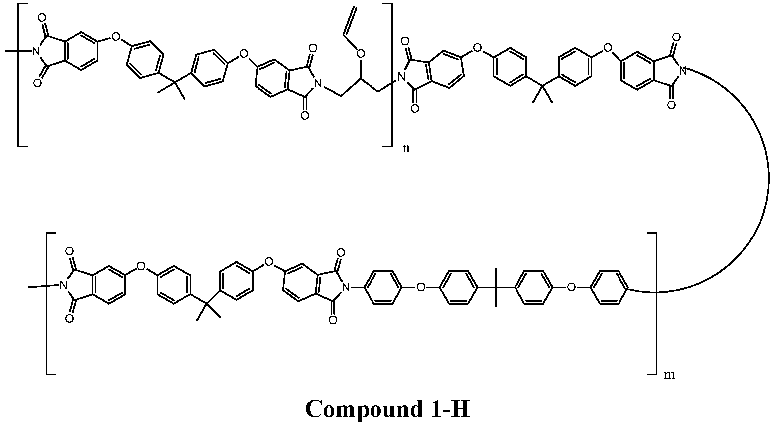

A 3 L reactor was charged with the following ingredients: 4.5 g 1(50.0 mmol) 3-diamino-2-propanol, 184.7 g (450.0 mmol), BAPPP and 1500 g of anisole. The solution was stirred while 261.0 g (500-mmol) bisphenol-A-dianhydride (BPADA) was added to the flask. The mixture was heated to reflux temperature of about 155° C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0 mL) theoretical yield of water, producing an alcohol pendent polyimide.

The solution was cooled down to about 75°C and a large excess (2.5 mol, 250.0 g) of butyl vinyl ether was added to the reactor along with 0.5 g of palladium acetate phenanthroline complex as a catalyst for the transetherification reaction. The solution was stirred for about 5 hours at 75° C and then stirred overnight at room temperature. The product was vacuum distilled to remove the excess butyl vinyl ether and some of the excess anisole to produce about a 25% solids solution of the vinyl pendant polyimide product.

**Molecular Weight** was analyzed as described above by gel permeation chromatography. See FIG 17. The estimated molecular weight of Compound 1-H was 65,000 Daltons.

¹H NMR data were consistent with an aromatic polyimide. Infrared spectroscopy confirmed the presence of the vinyl group and the imide carbonyl. The FTIR spectrum of the sample showed major bands at 3055, 1712, 1614, 1598, 1231, 830 and 741 wavenumbers.

### EXAMPLE 9: Synthesis of Vinyl Pendent Polyimide 1-I

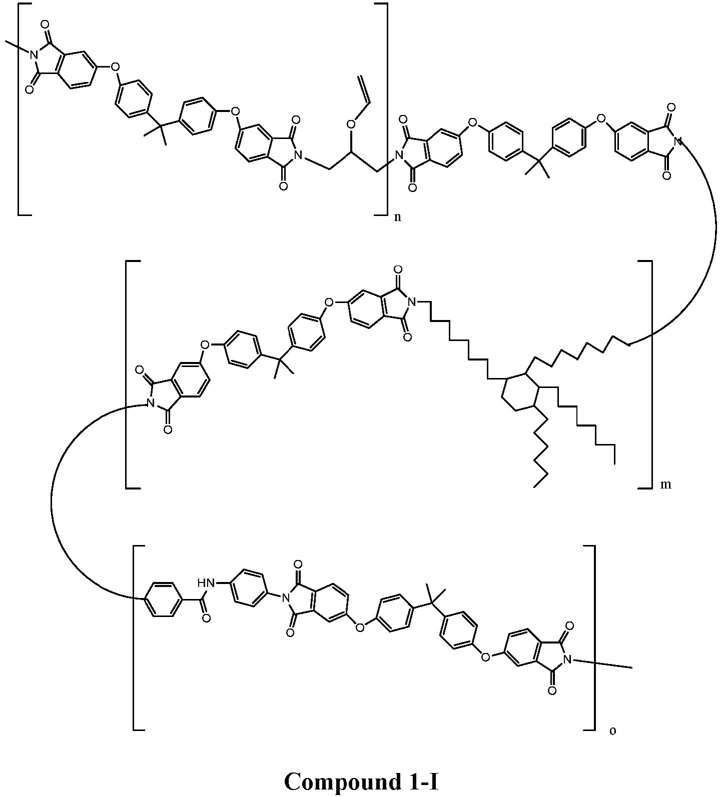

A 3 L reactor was charged with the following ingredients: 4.5 g (50.0 mmol) 1,3-diamino-2-propanol, 11.4 g (50.0 mmol) 4,4'-diaminobenzanilide), 109.6 g (200 mmol) Priamine^{™} 1075 and 1500 g of anisole. The solution was stirred while 82.1 g (200-mmol), BAPPP and 261,0 g (500.0-mmol) of BPADA was added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of the (18.0) theoretical yield of water, producing an alcohol pendent polyimide.

The solution was cooled down to about 75°C and a large excess (2.5 mol, 250.0 g) of butyl vinyl ether was added to the reactor along with 0.5 g of palladium acetate phenanthroline complex as a catalyst for the transetherification reaction. The solution was stirred for about 5 hours at 75° C and then stirred overnight at room temperature. The product was vacuum distilled to remove the excess butyl vinyl ether and some of the excess anisole to produce about a 25% solids solution of the vinyl pendant polyimide product.

Infrared spectroscopy confirmed the presence of the amide carbonyl, the vinyl group and the imide carbonyl. The FTIR spectrum of the sample showed major bands at 3299, 3055, 1714, 1652. 1613, 1599, 1239, 734 wavenumbers.

### EXAMPLE 10: Synthesis of Vinyl Pendent Polyimide 1-J

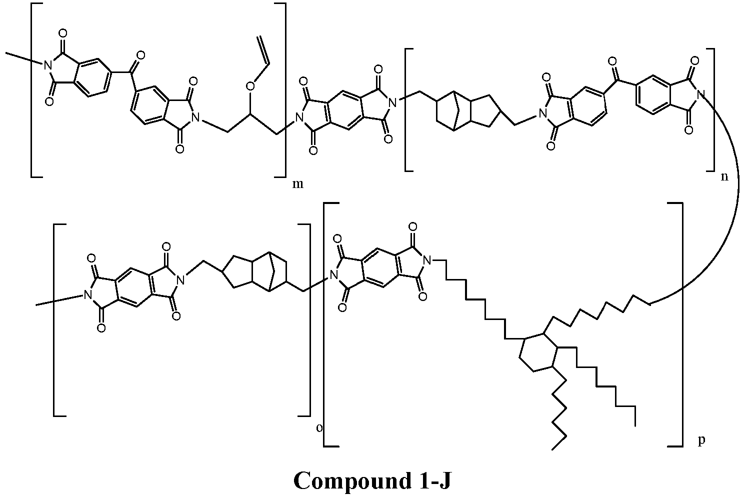

A 3 L reactor was charged with the following ingredients: 4.5 g (50.0 mmol) 1,3-diamino-2-propanol, 55.9 g (285.0 mmol) TCD-DA, 90.6 g (165.0 mmol) Priamine^{™} 1075 and 1500 g of 50:50 (wt:wt) anisole:dimethyl acetamide. The solution was stirred while 72.0 g (330.0 mmol) pyromellitic dianhydride and 54.8 g (170.0 mmol) benzophenone tetracarboxylic dianhydride were added to the flask. The mixture was heated to reflux temperature of about 155° C. During the heating, the dianhydride slowly started to dissolve and produced a turbid solution. As the polyimide was generated, the water produced was condensed and collected in a Dean-Stark trap. After 1.5 hours, the reaction was complete as indicated by recovery of about 30 mL of water and dimethylacetamide, producing an alcohol pendent polyimide.

The solution was cooled down to about 75°C and a large excess (2.5 mol, 250.0 g) of butyl vinyl ether was added to the reactor along with 0.50 g of palladium acetate phenanthroline complex as a catalyst for the transetherification reaction. The solution was stirred for about 5 hours at 75° C and then stirred overnight at room temperature. The product was vacuum distilled to remove the excess butyl vinyl ether and some of the excess anisole to produce about a 25% solids solution of the vinyl pendant polyimide product.

Infrared spectroscopy confirmed the presence of the vinyl group and the imide carbonyl group. The FTIR spectrum of the sample showed major bands at 3062, 1718, 1710, 1615, 1601, 1235, and 743 wavenumbers.

### EXAMPLE 11: Synthesis of Vinyl Pendent Polyimide 1-K

A 3 L reactor was charged with the following ingredients: 6.75 g (75 mmol)1,3-diamino-2-propanol, 79.6 g (145.0 mmol) Priamine^{™} 1075, 25.9 g (75.0 mmol) Bisaniline-M, 38.1 g (190.0 mmol) 3,4-oxydianiline, 6.16 g (15.0 mmol) of 2,2-Bis [4-(4-aminophenoxy)phenyl] propane and 1500 g of 50:50 (wt:wt) anisole:dimethyl acetamide. The solution was stirred while 16.1 g (50.0 mmol) benzophenone tetracarboxylic dianhydride, 77.6 g (250.0 mmol) oxydiphthalic anhydride; and 104.0 g (200.0 mmol) BPADA were added to the flask. The mixture was heated to reflux temperature of about 155°C. During the heating, the dianhydride slowly started to dissolve and produced a turbid solution. As the polyimide was generated, the water produced was condensed and collected in a Dean-Stark trap. After 1.5 hours, the reaction was complete as indicated by the recovery of about 30 mL of water and dimethylacetamide, producing an alcohol pendent polyimide.

The solution was cooled down to about 75°C and a large excess (3.75 mol, 375.0 g) of butyl vinyl ether was added to the reactor along with 0.75 g of palladium acetate phenanthroline complex as a catalyst for the transetherification reaction. The solution was stirred for about 5 hours at 75°C and then stirred overnight at room temperature. The product was vacuum distilled to remove the excess butyl vinyl ether and some of the excess anisole to produce about a 25% solids solution of the vinyl pendant polyimide product.

Infrared spectroscopy confirmed the presence of the vinyl group and the imide carbonyl group. The FTIR spectrum of the sample showed major bands at 3063, 1718, 1711, 1613, 1600, 1241, and 740 wavenumbers.

### POLYIMIDES WITH THIOL PENDANT GROUPS

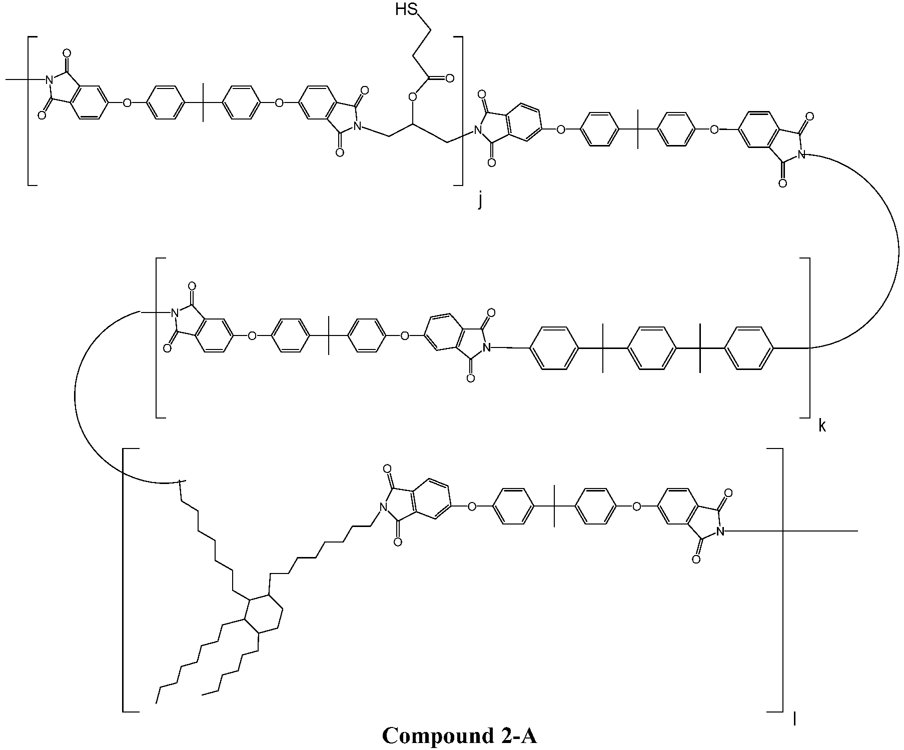

### EXAMPLE 12: Synthesis of Thiol Pendent Polyimide 2-A

A 1 L reactor was charged with 0.90 g (10.0 mmol) of 1,3-diamino-2-propanol. To the reactor was also added 21.5 g (62.5 mmol) of Bisaniline P, 34.3 g (62.5 mmol) of Priamine^{™} 1075, and 500 g of anisole. To the stirred solution was added 70.2 g (135.0 mmol) of BPADA. The mixture was heated to reflux for 1.5 hours to produce the alcohol pendent polyimide. The solution was cooled and 1.06 g (10.0 mmol) of 3-mercaptopropionic acid and 2.0 g of Amberlyst^{®} 36 acidic ion exchange resin was added. The mixture was refluxed for 1.0 hour to produce an ester. The Amberlyst^{®} resin was filtered out to leave a clear yellow solution that was about 20% solids in anisole.

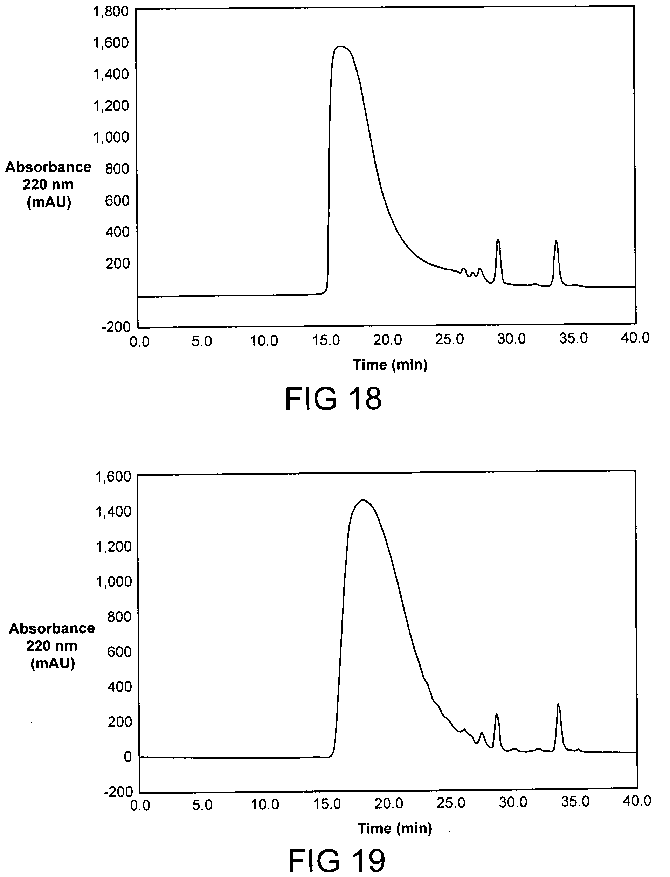

Molecular Weight was analyzed as described above by gel permeation chromatography. See FIG 18. The estimated molecular weight of **Compound 2-A** was 'calculated to be 65,000 Daltons.

¹H NMR data were consistent with an aliphatic/aromatic polyimide. Infrared spectroscopy confirmed the presence of the imide carbonyl. The FTIR spectrum of the sample showed major bands at 1710, 1600, 1231, 834 and 733 wavenumbers.

### POLYIMIDES WITH METHACRYLATE PENDANT GROUPS

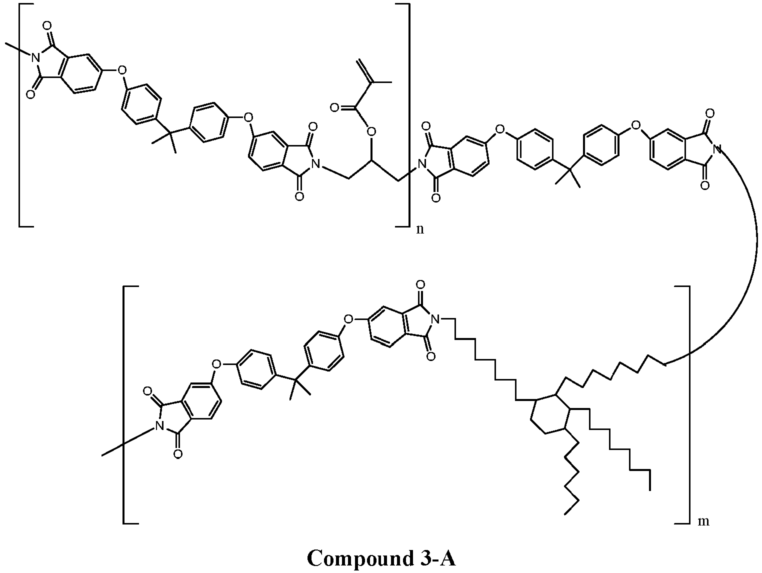

### EXAMPLE 13: Synthesis of Methacrylate Pendent Polyimide 3-A

To a 1 L reactor were added 0.9 g (10.0 mmol) of 1,3-diamino-2-propanol, 54.9 g (100.0 mmol) of Priamine^{™} 1075, and 500 g of anisole. To the reactor was added 57.2 g (110.0 mmol) of BPADA and the mixture was heated to reflux for 1.5 hours to produce the alcohol pendent polyimide, with recovery of the 4 mL of the theoretical amount of water being removed. The solution was cooled to 60°C and 1.55 g (10.0 mmol) of methacrylic anhydride was added to the reactor along with 0.1 g of dimethyl aminopyridine. The solution was stirred for 2 hours to assure the complete reaction.

**Molecular Weight** was analyzed as described above by gel permeation chromatography. See FIG 19. The estimated molecular weight of **Compound 3-A** was calculated to be ~50,000 Daltons.

¹H NMR data were consistent with an aliphatic/aromatic polyimide. Infrared spectroscopy confirmed the presence of the methacrylate group and the imide carbonyl. The FTIR spectrum of the sample showed major bands at 3056, 1713, 1599,1238,831 and 733 wavenumbers.

### POLYIMIDES WITH MALEIMIDE PENDANT GROUPS

### EXAMPLE 14: Synthesis of Maleimide Pendent Polyimide 4-A

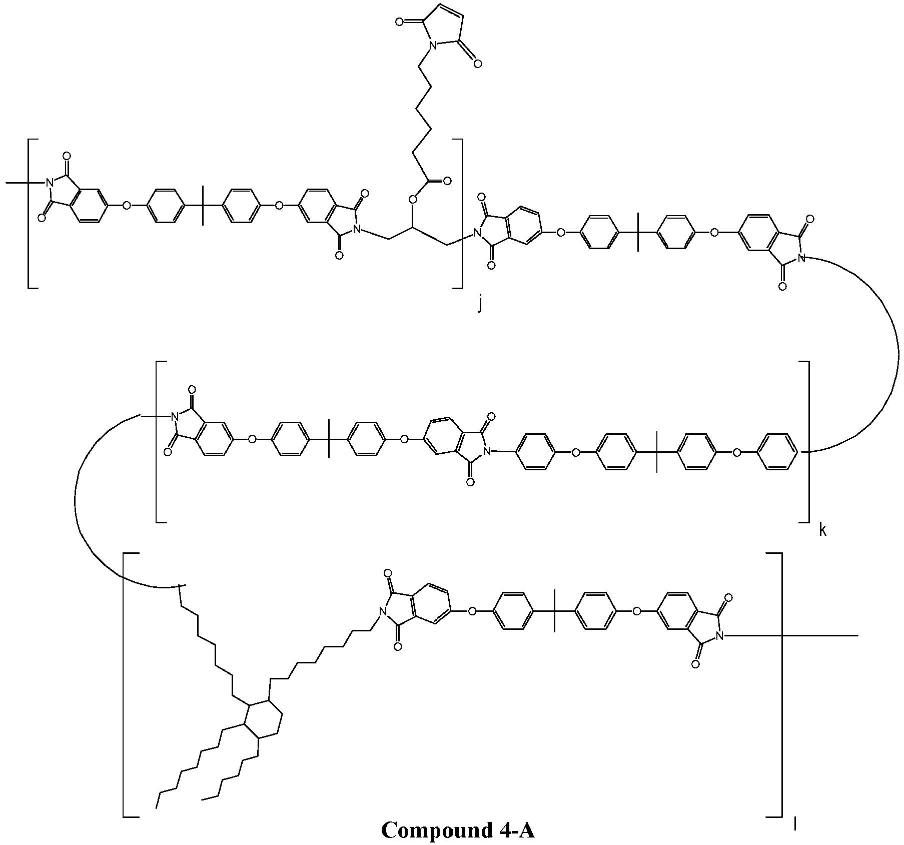

To a 1 L reactor was added 0.9 g (10.0 mmol) of 1,3-diamino-2-propanol; 4.11 g (10.0 mmol) of BAPPP, 43.9 g (80.0 mmol) of Priamine^{™} 1075, and 500 g of anisole. To the stirred solution was added 52.0 g (100.0 mmol) of BPADA. The mixture was heated to reflux for 1.5 hours to assure a complete reaction and form the alcohol pendent polyimide, with recovery of the 3.6 mL of the theoretical amount of water being produced. To the solution was added 2.10 g (10.0 mmol) of maleimidocaproic acid (Sigma, St. Louis, MO) and 2.0 g of Amberlyst^{®} 36 acidic ion exchange resin. The mixture was heated to reflux for 1 hour to form an ester, and recovery of the 1.8 mL of theoretical amount of water. The Amberlyst^{®} resin was filtered out of the solution.

Molecular Weight was analyzed as described above by gel permeation chromatography. See **FIG 20****.** The estimated molecular weight of **Compound 4-A** was calculated to be ~65,000 Daltons.

¹H NMR data were consistent with an aliphatic/aromatic polyimide. Infrared spectroscopy confirmed the presence of the maleimide group and the imide carbonyl group. The FTIR spectrum of the sample showed major bands at 1714, 1601, 1235, 839, and 744 wavenumbers.

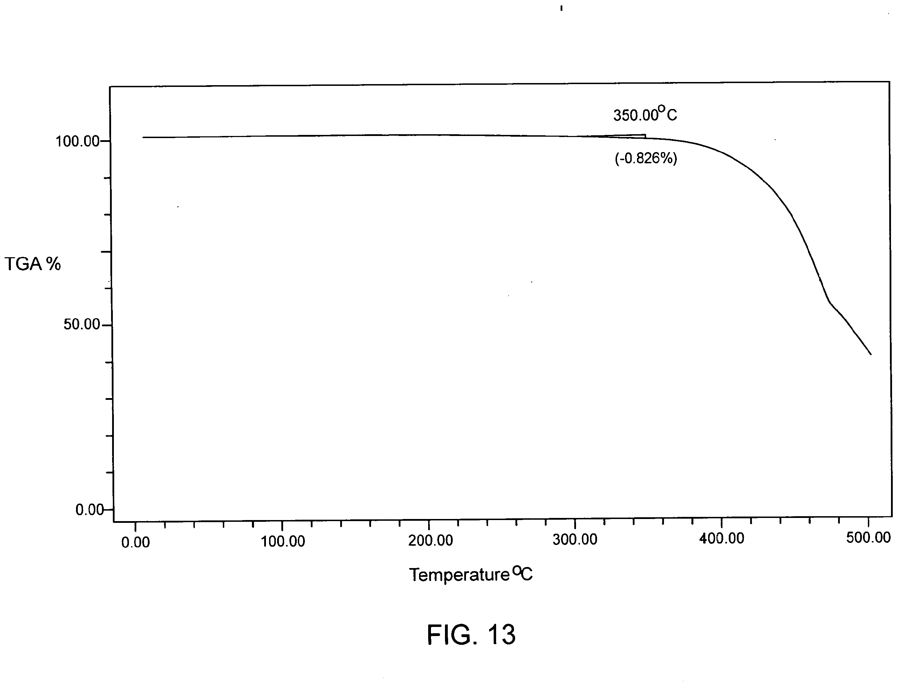

**Thermal stability.** The thermal stability of this compound was demonstrated by TGA analysis (performed as described above). The compound had less than 1% weight loss at 350°C. See **FIG 13****.**

### FORMULATIONS OF POLYIMIDES WITH PENDANT GROUPS

### EXAMPLE 15: Thermally Curable Formulations

The resins were mixed with representative co-reactant as indicated below in **Table 1** plus 2% by weight dicumyl peroxide, degassed and cured in an oven at 175° C for 1-hour. Various properties of the cured formulation were determined using the methods described above. The results are summarized in **Table 1.**

**Table 1. Properties of Thermally Cured Formulations**

| **Sample** | **%** | **Co-Reactant** | **%** | **T_{g}(DMA)** | **Dk** | **Df** |
|---|---|---|---|---|---|---|
| 1-B | 65 | BMI-2500 | 35 | 55 | | - |
| 1-B | 50 | BMI-2500 | 50 | 77 | | - |
| 1-B | 35 | BMI-2500 | 65 | 96 | 2.54 | 0.002 |
| 1-D | 80 | SA-9000(PPE) | 20 | 69 | | - |
| 1-D | 70 | SA-9000(PPE) | 30 | 77 | | - |
| 1-D | 60 | SA-9000(PPE) | 40 | 86 | 2.78 | 0.003 |
| 1-H | 80 | SR-601 | 20 | 163 | | - |
| 1-H | 70 | SR-601 | 30 | 152 | | - |
| 1-H | 60 | SR-601 | 40 | 140 | | - |
| 1-I | 25 | BMI-1500 | 75 | 43 | | - |
| 1-I | 50 | BMI-1500 | 50 | 56 | | - |
| 1-J | 25 | BMI-689 | 75 | 52 | 2.42 | 0.002 |
| 1-J | 50 | BMI-689 | 50 | 73 | | - |
| 1-J | 75 | BMI-689 | 25 | 102 | | - |
| 1-K | 75 | SR-833S | 25 | 156 | | - |
| 1-K | 85 | SR-833S | 15 | 142 | | - |
| 2-A | 75 | TriallylIsocyanurate | 25 | 92 | | - |
| 2-A | 65 | TriallylIsocyanurate | 35 | 107 | | - |
| 3-A | 60 | Tris(2-acryloxyethyl)isocyanurate | 40 | 151 | | - |
| 3-A | 50 | Tris(2-acryloxyethyl)isocyanurate | 50 | 170 | | - |
| 4-A | 85 | BMI-70 | 15 | 77 | | - |
| 4-A | 75 | BMI-70 | 25 | 102 | | - |

| | | | | | | |
|---|---|---|---|---|---|---|
| • SA-9000(PPE) = low molecular weight, bi-functional oligomer based on polyphenylene ether (PPE) with vinyl end-groups; SABIC Innovative Plastics, Riyadh, Saudi Arabia) | | | | | | |

### ULTRAVIOLET LIGHT-CURABLE FORMULATIONS

### EXAMPLE 16: 1-A UV-Curable Formulation

The following components were dissolved in 20 g of anisole with mixing:
56 wt% Resin 1-A
19 wt% BMI 2500 (Designer Molecule, Inc.)
19 wt% SR 454 (ethoxylated trimethylolpropane triacrylate; Sartomer Arkema Group, Exton, PA)
2 wt% 4 META
2 wt% Irgacure^{®} 819
2 wt% Irgacure^{®} 784

The solution was poured into a standard dogbone tensile test mold, degassed and placed in an oven to dry at 100°C for 6 hours. Both sides of the film were exposed to ultraviolet light (365 nm) for 2 minutes per side, followed by heating to 175°C for 1-hour to complete the cure.

The cured formulation was tested for tensile strength, elongation, T_{g}, CTE, Dk, and Df. The results of those tests are given below in **Table 2.**

### EXAMPLE 17: 1-C UV-Curable Formulation

The following components were dissolved in 20 g of anisole with mixing:
63 wt% Resin 1-C
20 wt% BMI 2500
8 wt% SR833S (tricyclodecane dimethanol diacrylate; (Arkema Group), Exton, PA)
3 wt% Tris (2 acryloxyethyl)isocyanurate)
2 wt% 4 META
2 wt% Irgacure^{®} 819
2 wt% Irgacure^{®} 784

The solution was poured into standard dogbone tensile mold, degassed and placed in an oven to dry at 100°C for about 6 hours. Both sides of the film were exposed to ultraviolet light (365 nm) for 2 minutes per side, followed by heating to 175°C for 1-hour to complete the cure.

The cured formulation was tested for tensile strength, elongation, T_{g}, and CTE. The results of those tests are given below in **Table 2.**

### EXAMPLE 18: 1-D UV-Curable Formulation

The following components were dissolved in 20 g of anisole with mixing:
75 wt% Resin 1-D
9 wt% Tris(2-acryloxyethyl)isocyanurate)
10 wt% SR833S
2 wt% 4-META 2-(Methacryloyloxy)ethyl 1,3-dioxo- 1,3-dihydroisobenzofuran- 5-carboxylate;
Sigma-aldrich, St Louis, MO
2 wt% Irgacure^{®} 819
2 wt% Irgacure^{®} 784

The solution was poured into a standard dogbone tensile mold, degassed and placed in an oven to dry at 100°C for 6 hours. Both sides of the film were exposed to ultraviolet light (365 nm) for 2 minutes per side, followed by heating to 175°C for 1-hour to complete the cure.

The cured formulation was tested for tensile strength, elongation, T_{g} and CTE. The results of those tests are given below in **Table 2.**

### EXAMPLE 19: 1-E UV-Curable Formulation

The following components were dissolved in 20 g of anisole with mixing:
25 wt% 1-E Resin
55 wt% BMI-2500 (Designer Molecules, Inc.)
14 wt% SR833S
2 wt% 4-META
2 wt% Irgacure^{®} 819
2 wt% Irgacure^{®} 784

The solution was poured into a standard dogbone tensile mold and placed in an oven to dry at 100°C for 6 hours. Both sides of the film were exposed to ultraviolet light (365 nm) for 2 minutes per side, followed by heating to 175°C for 1-hour to complete the cure.

The cured formulation was tested for tensile strength, elongation, T_{g}, and CTE. The results of those tests are given below in **Table 2.**

### EXAMPLE 20: 1-F UV-Curable Formulation

The following components were dissolved in 20 g of anisole with mixing:
68 wt% 1-F Resin
18 wt% SR-833S
8 wt% Tris(2-acryloxyethyl)isocyanurate
2 wt% 4-META
2 wt% Irgacure^{®} 819
2 wt% Irgacure^{®} 784

The solution was poured into a standard dogbone tensile mold and placed in an oven to dry at 100°C. Both sides of the film were exposed to ultraviolet light (365 nm) for 2 minutes per side, followed by heating to 175°C for 1-hour to complete the cure.

The cured formulation was tested for tensile strength, elongation, T_{g} and CTE. The results of those tests are given below in **Table 2.**

### EXAMPLE 21: 1-G UV-Curable Formulation

46 wt% 1-G Resin
20 wt% DMI-4100 (Polyimide-BMI, Designer Molecules, Inc.)
15 wt% BMI-1550 (Designer Molecules, Inc.)
12 wt% SR833S
2 wt% 4-META
2 wt% Irgacure^{®} 819 (Bis(2,4,6-trimethylbenzoyl)-phenylphosphineoxide; C; Ciba Specialty Chemicals, Basel, CH)
2 wt% Irgacure^{®} 784 (cyclopenta- 1,3 -diene; 1-(2,4-difluorocyclohexa-2,3,5-trien-1-yl)pyrrole;titanium; Ciba Specialty Chemicals, Basel, CH)
1 wt% Ethyl(4-aminodimethyl)benzoate (Sigma-Aldrich, St. Louis MO)

The solution was poured into a standard dogbone tensile mold and placed in an oven to dry at 100°C for 6 hours. Both sides of the film were exposed to ultraviolet light (365 nm) for 2 minutes per side, followed by heating to 175°C for 1-hour to complete the cure.

The cured formulation was tested for tensile strength, elongation, T_{g}, CTE, Dk, and Df. The results of those tests are given below in **Table 2.**

**Table 2. Properties of UV-Cured Formulations**

| **Formulation** | **Tensile Strength (MPa)** | **Percent Elongation at break** | **T_{g} (TMA)** | **CTE (α1)** | **Dk** | **Df** |
|---|---|---|---|---|---|---|
| 1-A | 57 | 43 | 98 | 80 | 2.48 | 0.002 |
| 1-C | 48 | 100 | 80 | 87 | - | - |
| 1-D | 73 | 50 | 110 | 76 | - | - |
| 1-E | 85 | 32 | 105 | 78 | - | - |
| 1-F | 88 | 17 | 130 | 54 | - | - |
| 1-G | 75 | 78 | 145 | 53 | 2.7 | 0.003 |

### EXAMPLE 22: Redistribution Layers Formulations

A formulation for use as RDL must not only have good physical properties, but also must UV-cure with less than 1000 mJ of UV light. The material must also develop using standard developing solutions such as cyclopentanone, be resistant to chemical stripper solutions, adhere well to copper surfaces, and effectively block the diffusion of copper oxide into the polymer matrix to prevent delamination.

The formulas presented in **Table 2** are all suitable for use as RDL materials, however, the formulations also must contain proper coupling agents to make sure that adhesion to copper is met, especially after pressure cooker testing (PCT). The right coupling agents also help to prevent copper oxide migration.

The coupling agents that have been found to work best are 2-(3,4-epoxycylohexyl) ethyltrimethoxysilane (Gelest Inc., Morrisville, PA) and N-phenyl-3-aminopropyltrimethoxysilane (Gelest Inc. Morrisville, PA). 1-2% of each coupling agent is added to the formulations in Table 2 for RDL formulations.

### RDL Formulation

A solution was prepared by mixing the following materials:
10.0 g of tris(2-hydroxyethyl) isocyanurate triacrylate
12.0 g of dicyclopentadiene dimethanol diacrylate (Sartomer (Arkema Group))
2.0 g of 4-methacryloxyethyl trimellitic anhydride
76.0 g of the pendent vinyl ether functionalized polyimide (1-D Resin)
400.0 g of anisole

To the solution was added the following photoinitiator combination: 2.0 g of Irgacure^{®} 819 (Bis(2,4,6-trimethylbenzoyl)-phenylphosphineoxide); 2.0 g of Irgacure^{®} 784 (Bis(.eta.5-2,4-cylcopentadien-1-yl)-bis(2,6-difluoro-3-(1H-pyrrol-1-yl)- phenyl) titanium), followed by the addition of 1.0 g of ethyl-4-(dimethylamino)benzoate. These solids were mixed well in a double planetary mixer to ensure they were fully dissolved.

To the solution was added the following coupling agents: 2.0 g of N-phenyl-3-aminopropyl trimethoxysilane, and 1.0 g of 2-(3,4-epoxycyclohexyl)ethyl trimethoxysilane. The solution was stirred to completely dissolve everything.

The solution was filtered through a 1-micron filter to remove any trace particles that could interfere with making a perfect coating.

### Spin Coating Experiment

Silicon wafer was cleaned and dried and placed on a spin coating machine. The RDL solution was poured on the center of the copper wafer to make a puddle. The wafer was spun for 10 seconds at about 550 rpm, followed by 10 seconds at 1100 rpm. The wafer was dried in the oven for 10 minutes at 100° C. A photomask was applied to the wafer and placed in a UV chamber for 50 seconds to get approximately 500 mJ/cm² UV dosage.

The wafer was placed in a bath containing cyclopentanone to develop the pattern. After 1-minute the cleanly developed pattern was observed.

The wafer was placed in the oven at 125°C for 30 minutes to make sure the coupling agents take affect and adhesion to the copper surface is maximized.

The copper wafers are placed in a pressure cooker for 96 hours to test the adhesion of the coating onto the surface. After the test they are dried and cross-cut with a razor blade, scotch tape was adhered onto the surface and pulled away to find any weakness in the adhesion. The test indicates that the material has very good adhesion, with no delamination visually observed under a microscope.

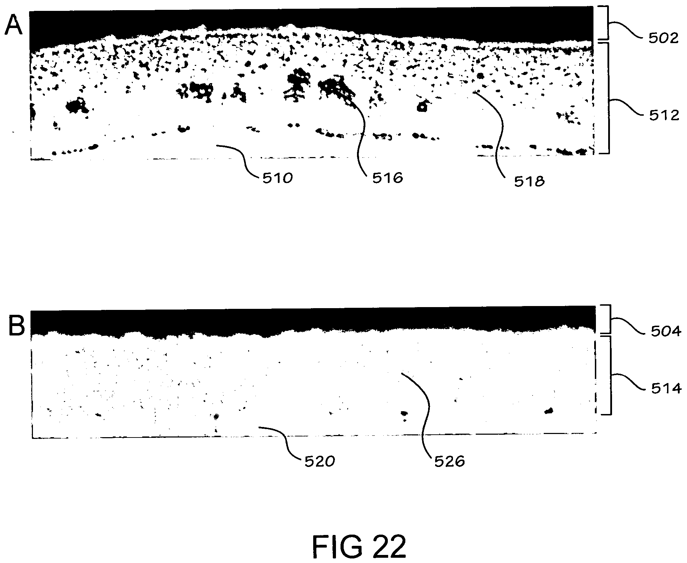

Copper oxide diffusion was tested by high temperature storage (HTS) at 175°C for 200 hours in the oven. The cross-sectional analysis of the copper wafer using scanning electron microscopy is a good way to analyze for copper oxide diffusion. The presence of voids in the copper oxide layer and diffusion into the resin layer will ultimately cause delamination from the surface, and this is present in most RDL materials on the market. However, the invention formulations show no voids and no copper oxide diffusion, indicating that the combination of the resins in the formulation and the adhesion promoters and coupling agents have capped the copper oxide and prevented its diffusion into the resin layer **(****FIG 22****).** Panel **A** shows a control which used an organic RDL solution and Panel **B** used the RDL solution described above. The figure shows the copper layer **512** and **514** in the control and invention RDL, respectively; **502** and **505** are the RDL layers. The plated copper is indicated **510** and **520;** oxidized copper is above the plated **(518, 526).** In the control, voids are seen, but they are absent from the plated copper covered with the RDL formulation of the invention.

### TEMPORARY ADHESIVE COMPOUNDS AND COMPOSITIONS

### EXAMPLE 23: Temporary Adhesive Formulation

Temporary adhesives for high temperature applications require that the material be soft, so that during the lamination process at temperature the material can flow and fill all of the groves. The material must UV-cure and be stable with less than 5% weight loss at 350°C.

All of the resins described herein have less than 1% weight loss at 350°C when made into a thin film and analyzed using TGA. The materials must be UV-cured, therefore a co-reactant that is low in viscosity and has little to no weight loss must be added to properly UV cure. Preferred co-reactants include, but are not limited to tri(2-acryloxyethyl)isocyanurate; BMI-689 (Designer Molecules, Inc.); 1,10-decane diol diacrylate; tricyclodecane dimethanol diacrylate; and trimethylolpropane triacrylate. The co-reactants are typically added in about 5-20% by weight to the formulation.

### EXAMPLE 24: Temporary Adhesive for Backgrinding (Compound 5 plus Tris[2-(acryloyloxy)ethyl] isocyanurate

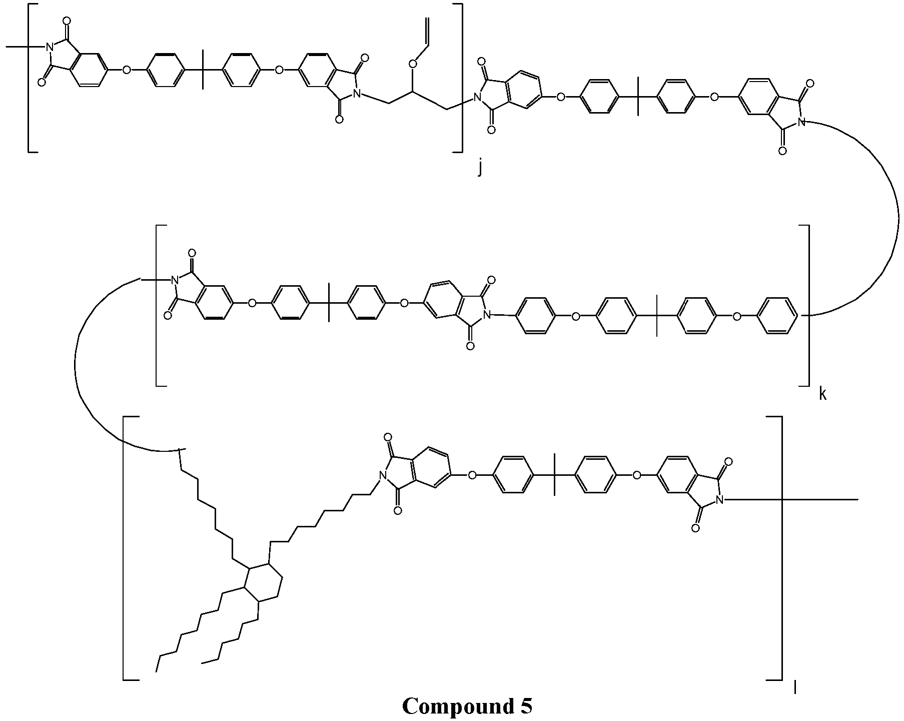

where j is approximately 0.2 ± 0.01; k is approximately 0.05 ± 0.01; and l is approximately 0.75 ± 0.01.

### Synthesis of pendent vinyl ether polyimide:

A 3-L reactor was assembled and charged with 9.0 g (100 mmol) of 1,3-diamino-2-propanol, followed by the addition of 10.3 g (25 mmol) of 2,2-bis-[4-(4-aminophenoxy)phenyl]propane, and 205.9 g (375 mmol) of Priamine^{®} 1075 (dimer diamine). To the reactor was added 1500 g of anisole, followed by stirring to form a homogeneous solution. To the reactor was added 262.5 g (505 mmol) of bisphenol-A-dianhydride. The mixture was stirred vigorously and heated slowly to about 155°C to form the polyimide as the water from the reaction is azeotropically distilled into a Dean-Stark trap. The solution is refluxed for about 1-2 hours to assure complete polyimide formation.

The pendent alcohol functionalized polyimide is converted to a vinyl ether via transetherification reaction. Once the solution is cooled down to about 75°C then a large excess, (500 mmol; 500 g) of butyl vinyl ether was added to the reactor along with 1 g of palladium acetate phenanthroline complex (Designer Molecules, San Diego, CA). The solution was stirred at 75°C for about 6 hours, followed by room temperature stirring overnight. The excess butyl vinyl ether and some anisole were removed under reduced pressure to produce a 25% solids solution of polyimide in anisole.

The temporary adhesive formulation was a combination of the above polyimide (9.0 g, 90 wt%) with the following acrylic Tris[2-(acryloyloxy)ethyl] isocyanurate (1.0 g, 10 wt%). The materials were dissolved in 20 g of anisole, followed by the addition of 0.05 g of Irgacure-819 photoinitiator. The solution was spin coated onto a silicon wafer for 10 seconds at 550 rpm's followed by 10 seconds at 1150 rpm's. The wafer was placed in the oven to dry at 120°C for 10 minutes, followed by allowing the material to cool down to ambient temperature over 30 minutes. The adhesion of the film on the wafer was tested by trying to remove the film using a razor blade. The material was on very well and had the feel of a very low modulus thermoplastic that was very difficult to remove from the surface.

The wafer was placed under the UV light at 365 nm and received 1000 mJ of UV exposure. The material was again tested for adhesion by trying to remove the material with a razor blade. After UV exposure the material peeled away very well, with no trace of polymer left on the surface of the wafer. The material felt much stiffer and that is what caused the much easier peeling of the surface. Not to be bound by any one theory, but since the material contains a large amount of greasy aliphatic groups it has low surface energy and with no coupling agents present it does not stick too well when the modulus is increased.

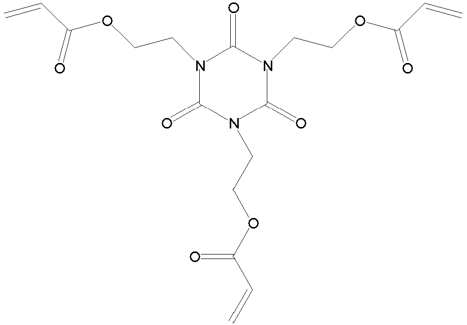

The TGA analysis of the 50 micron thick film that was exposed to 1000 mJ of UV light (365 nm) shows 1.13% weight loss at 300° C, and 1.97% weight loss at 350° C (Figure 12).

Figure 13, shows the TGA analysis of a maleimide-pendent polyimide of example 14. The TGA analysis shows about 0.826% weight loss at 350° C after a similar 50 micron thick film was exposed to 1000 mJ of UV light.

### EXAMPLE 25: Composites and Printed Wiring Boards

The curable pendent polyimides along with co-reactants described are suitable for making prepregs in combination with glass fabric. Glass fabric is dipped into a concentrated solution of the resin and dried, followed by lamination of multiple layers at up to 200° C for 1-hour to form the composite. Additionally, adhesion promoters and flame retardants may be added to make a better product.

A solution of the following formulation was prepared by combining the following:
62 wt% Compound 1-C
19 wt% BMI-2500
10 wt% Tricyclodecanedimethanol diacrylate
2 wt% Tris[2-(acryloyloxy)ethyl] isocyanurate
2 wt% 4-methacryloxyethyl trimellitic anhydride
2.5 wt% Irgacure^{®} 819
2.5 wt% Irgacure^{®} 784

A thick film (600 microns) was cured using 365 nm UV light for 5 minutes on each side, followed by placing in the oven for 1 hour at 175° C.

### EXMAPLE 26: Shape Memory Polyimide

All of the formulations described in Tables 1 and 2 were found to be possess shape memory properties. The approximately 500-micron thick materials after being cured were cut into 0.5 inch x 6 inch strips and twisted into deformed shapes. The pieces were placed in the oven set to 180° C, and within a few seconds the materials would unwind and return to the original 0.5 inch x 6 inch strips.

## Claims

1. A curable, functionalized polyimide having a structure according to any one of Formulae **IA, IB, IC** and **ID:** 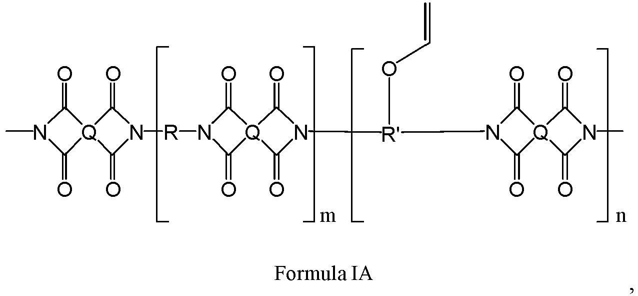 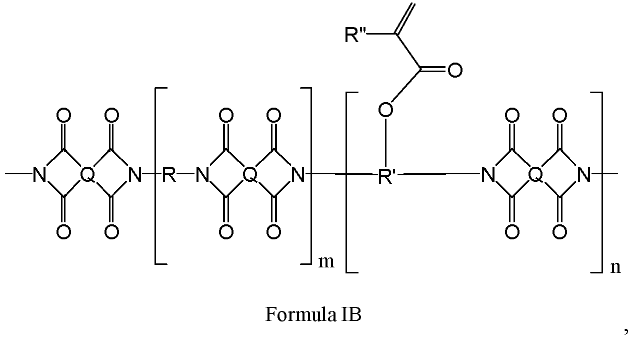 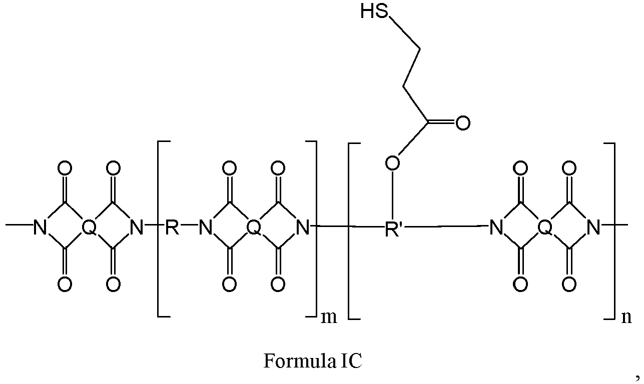 and 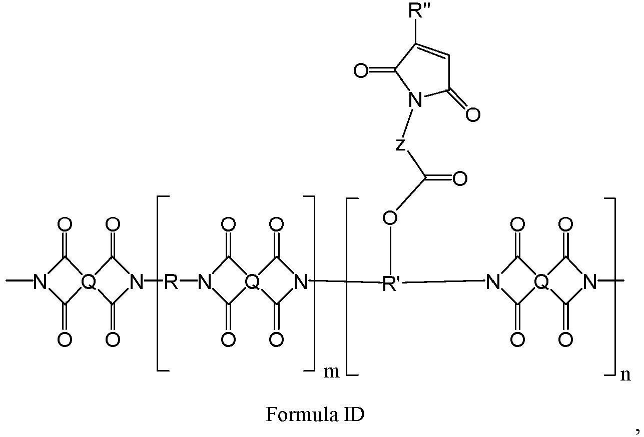 wherein:
R is independently a substituted or unsubstituted aliphatic, cycloaliphatic, alkenyl, polyether, polyester, polyamide, aromatic, heteroaromatic, or siloxane moiety;
R' is independently a diamine that contains an alcohol moiety;
each Q is independently a substituted or unsubstituted aliphatic, cycloaliphatic, alkenyl, polyether, polyester, polyamide, aromatic, heteroaromatic, or siloxane moiety;
each R" is H or methyl;
z is independently a substituted or unsubstituted alkyl or aromatic moiety; and
n and m are integers having a value from 10 to 100, with the proviso the average molecular weight of curable polyimide is greater than 20,000 Daltons determined by gel permeation chromatography,
wherein the curable, functionalized polyimide is the product of a condensation of at least one diamine selected from 1,3-diamino-2-propanol and 3,5-diaminobenzyl alcohol, with at least one dianhydride selected from the group consisting of: 4,4'-Bisphenol A dianhydride; pyromellitic dianhydride; 3,3',4,4'-benzophenone tetracarboxylic dianhydride; and 4,4'-oxydiphthalic anhydride, resulting in formation of a pendant alcohol, followed by functionalizing the pendant alcohol group.

2. A method for synthesizing a curable, functionalized polyimide of claim 1 , comprising the steps of:
a) dissolving at least one diamine in a solvent at room temperature, wherein the at least one diamine is selected from 1,3-diamino-2-propanol and 3,5-diaminobenzyl alcohol;
b) adding at least one dianhydride, wherein the total amount of the at least one dianhydride is approximately one molar equivalent of the total amount of the at least one diamine, and wherein the at least one dianhydride is selected from the group consisting of: 4,4' -Bisphenol A dianhydride; pyromellitic dianhydride; 3,3' , 4,4'-benzophenone tetracarboxylic dianhydride; and 4,4'-oxydiphthalic anhydride;
c) slowly over 1 hour heating the mixture to reflux, thereby producing an imidized polymer and water;
d) refluxing the mixture while removing the water, for about one to about two hours, or until all the water produced has been removed, wherein the average molecular weight of the polyimide is greater than 20,000 Daltons, wherein the polyimide comprises at least one pendant alcohol moiety; and
e) reacting the pendant alcohol to produce a functionalized polyimide with polymerizable pendant moieties.

3. A method according to claim 2, wherein the solvent is an aromatic solvent.

4. A method according to claim 3, wherein the aromatic solvent comprises anisole.

5. The method according to claim 2, wherein step e), reacting the pendant alcohol, comprises:
i) catalyzing the reaction of the alcohol groups with a polymer-bound acid catalyst, and
ii) removing the polymer-bound catalyst by filtration.

6. An adhesive formulation comprising a curable, functionalized polyimide according to claim 1.

7. An adhesive according to claim 6, wherein the adhesive is removable.

8. An article coated on at least a part of one surface with the adhesive formulation according to claim 6, wherein optionally the article is a thinned or unthinned wafer, a patterned or unpatterned chip, or an electronics package.

9. A formulation comprising:
a) at least one curable, functionalized polyimide according claim 1,
b) at least one reactive diluent;
c) a solvent in which the curable, functionalized polyimide is soluble; and optionally, at least one adhesion promoter, at least one coupling agent, at least one UV initiator or a combination thereof.

10. A formulation according to claim 9, wherein the formulation is a coating, a passivation layer, or a redistribution layer comprising metallization between two layers of the formulation.

11. A prepreg comprising a fiber support impregnated with a formulation of claim 10.

12. A copper clad laminate or a flexible copper clad laminate comprising copper foil laminated to one surface or both surfaces of the prepreg according to claim 11 or a printed wiring board comprising the copper-clad laminate.

13. A UV curable composition comprising:
a) at least one curable, functionalized polyimide according to claim 1; and
b) at least one reactive diluent.

14. A curable, functionalized polyimide according to claim 1, selected from the group consisting of:

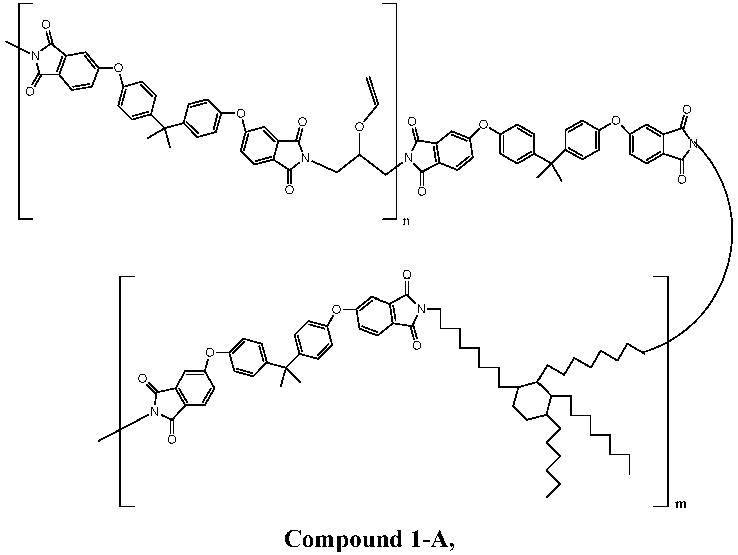

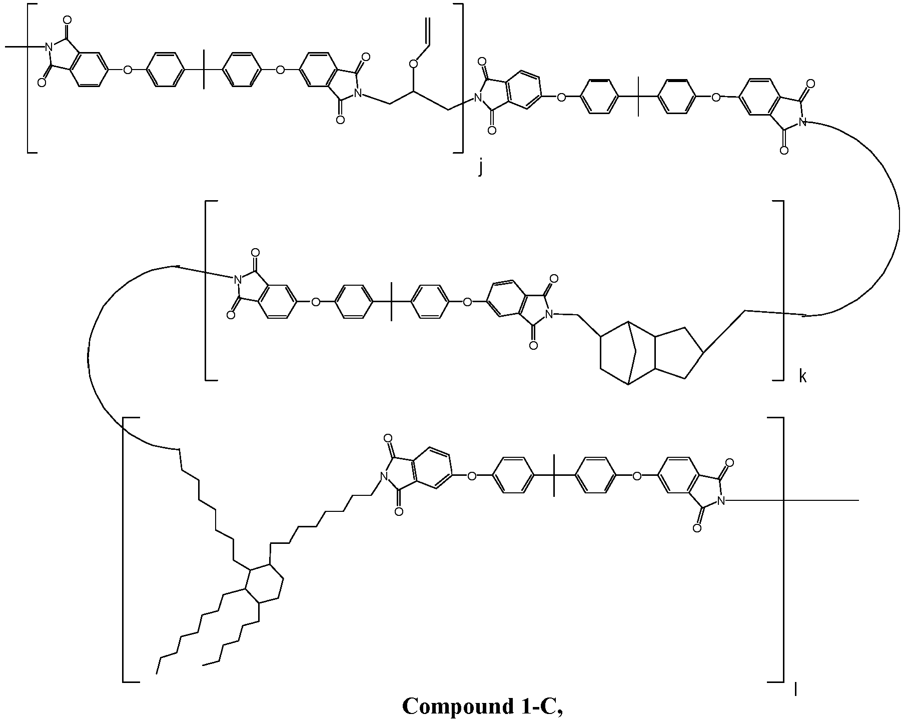

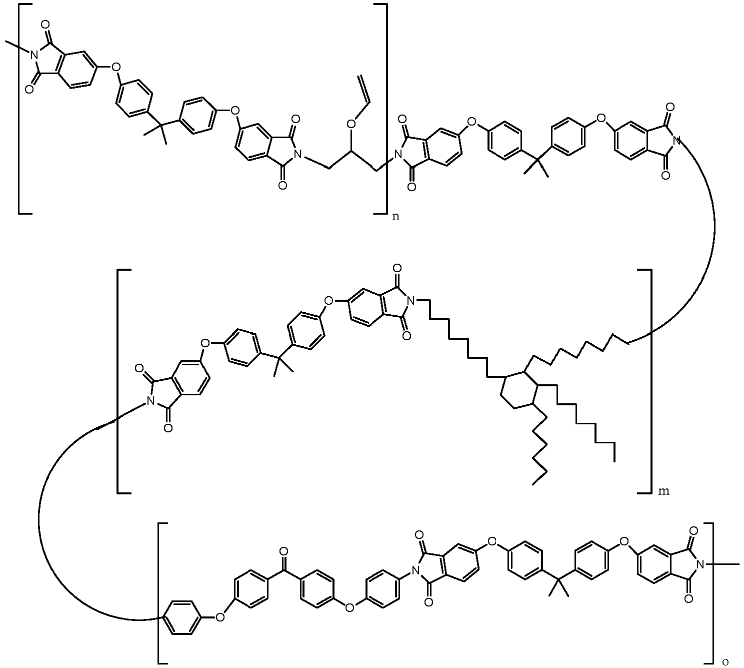

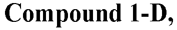

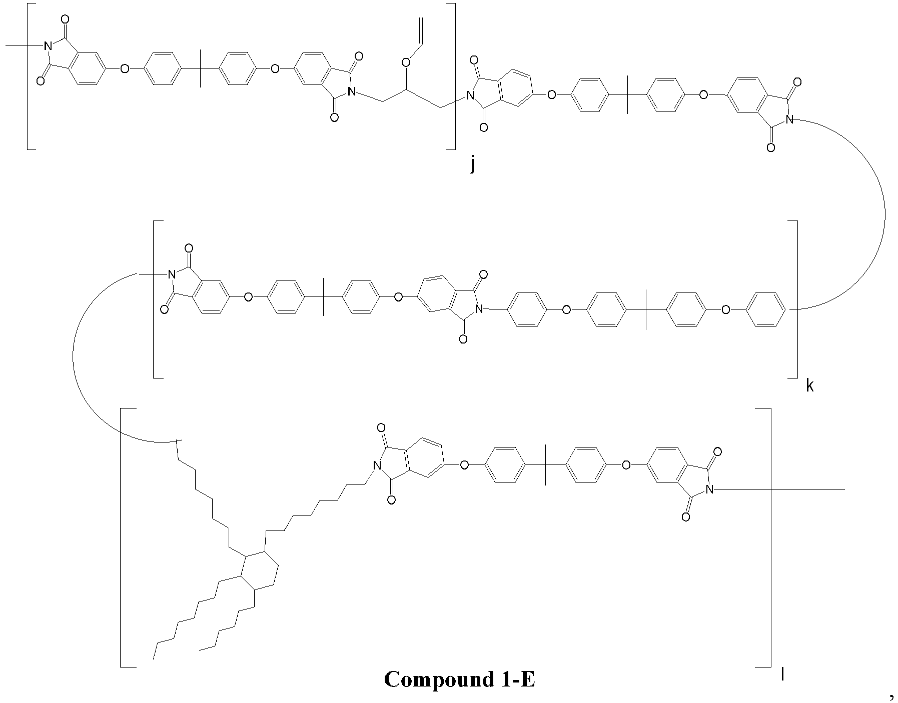

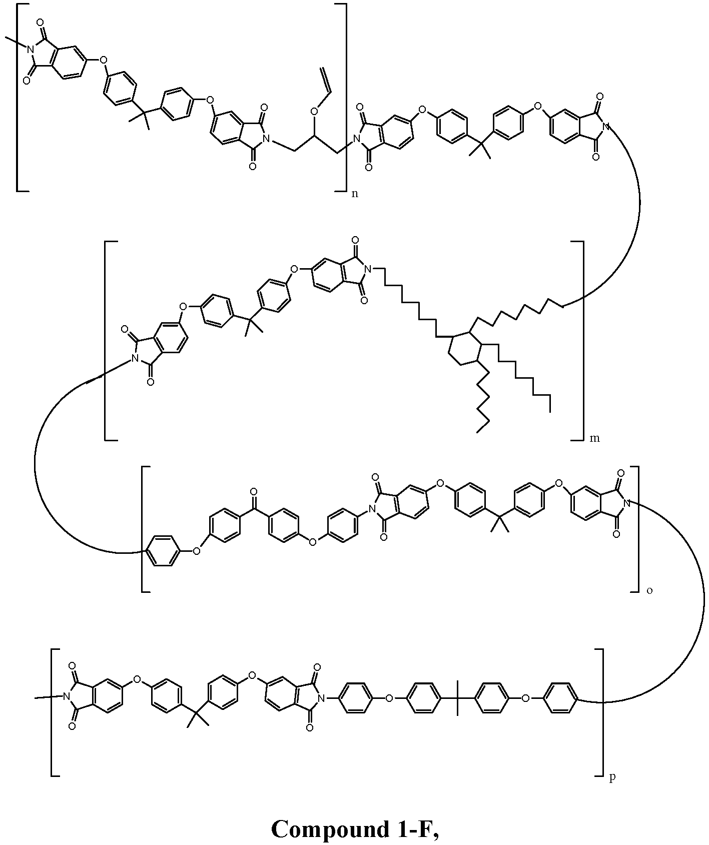

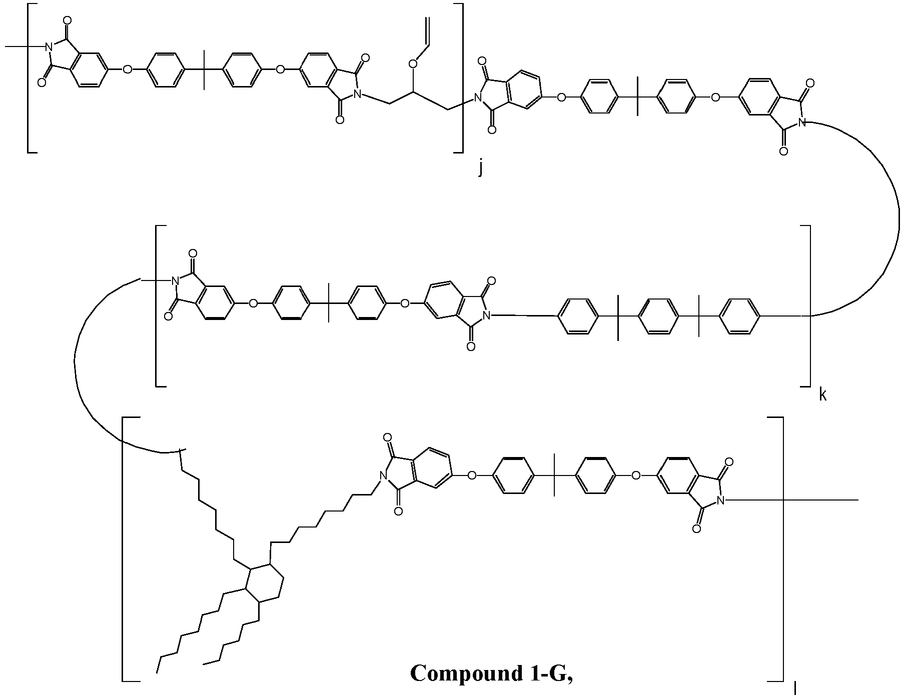

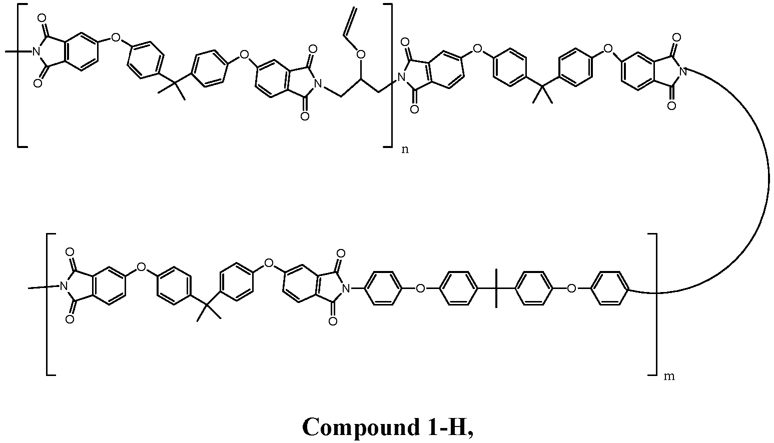

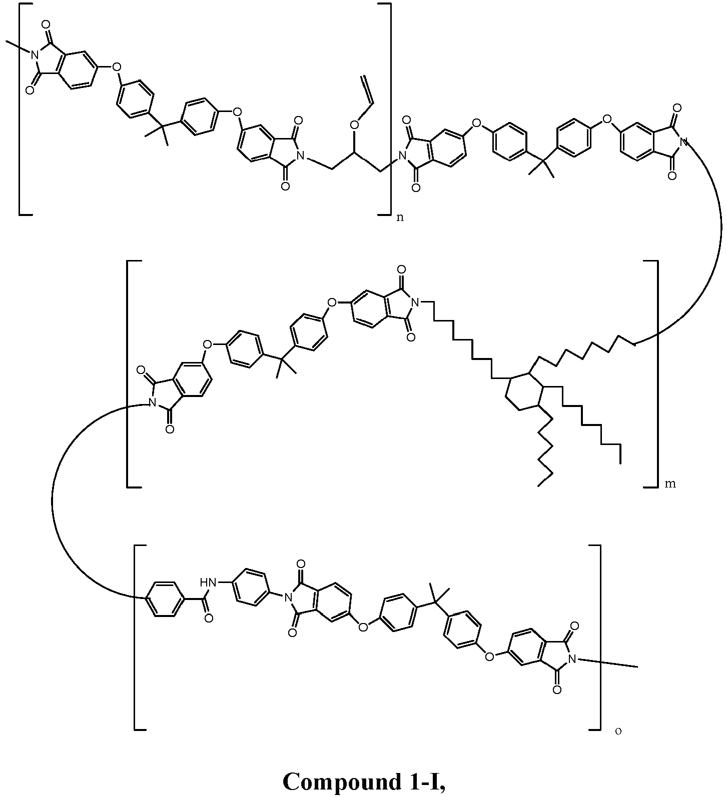

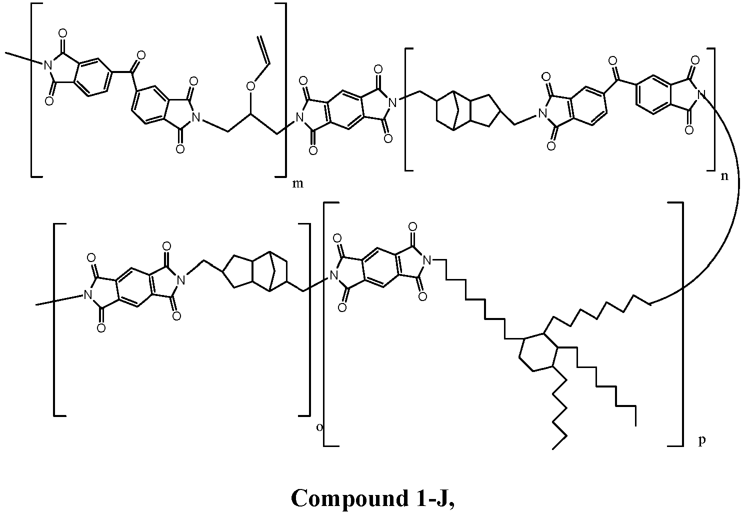

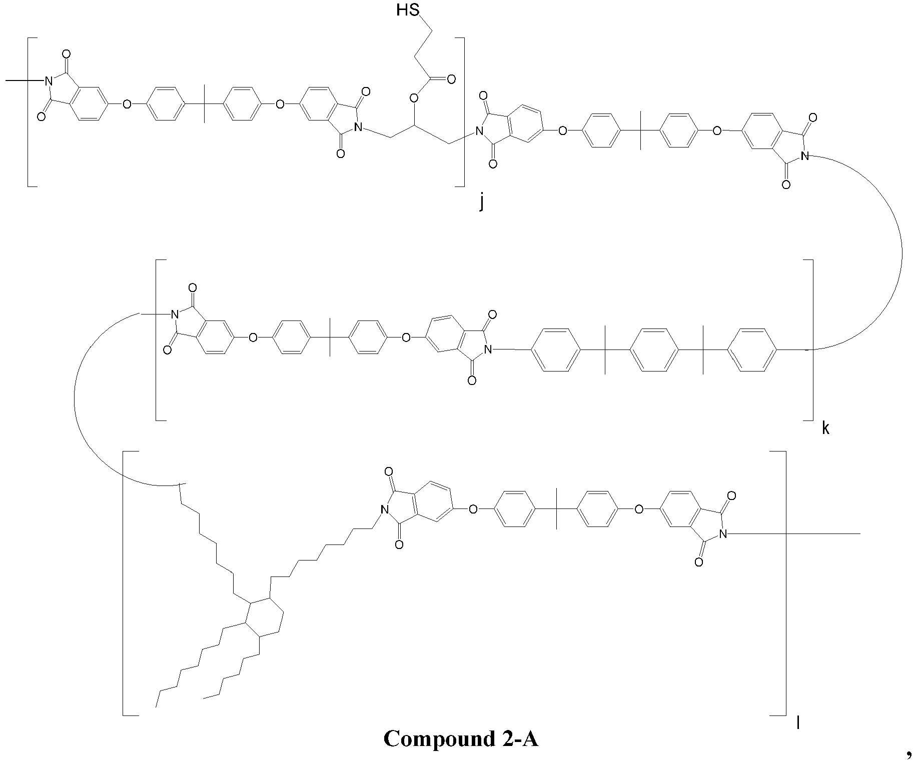

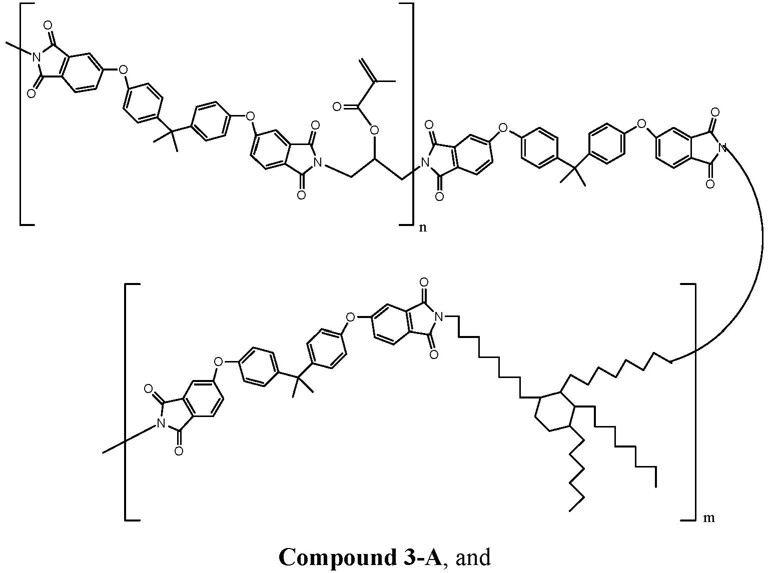

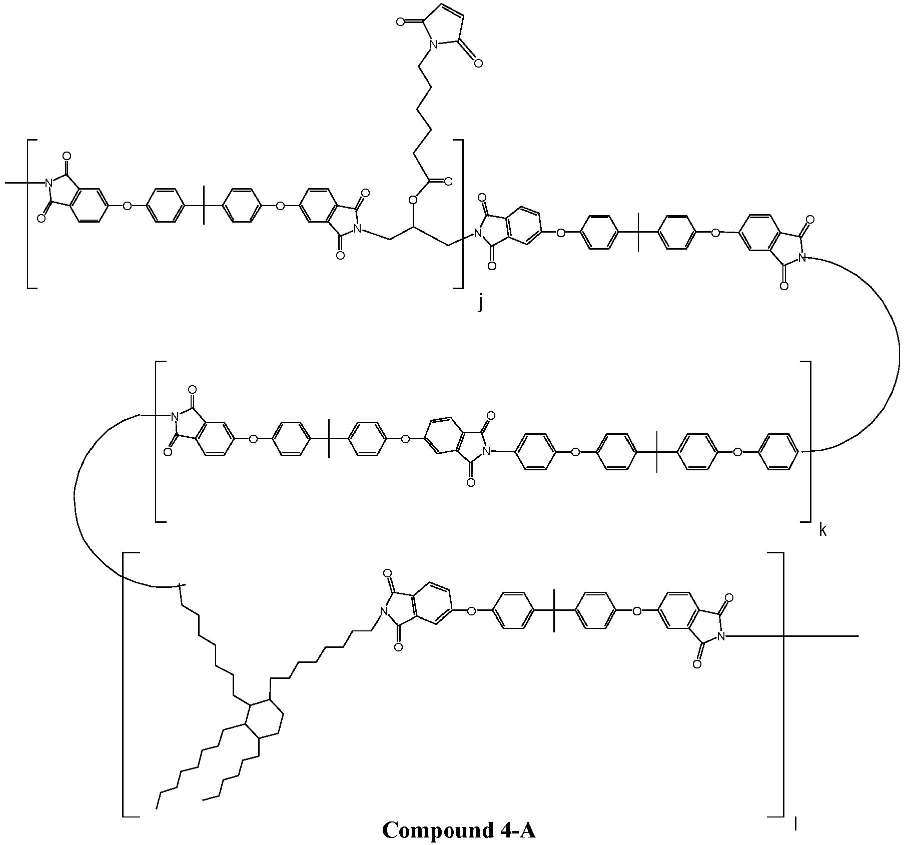

## Patentansprüche

1. Ein härtbares, funktionalisiertes Polyimid mit einer Struktur gemäß einer der Formeln **IA, IB, IC** und **ID:** 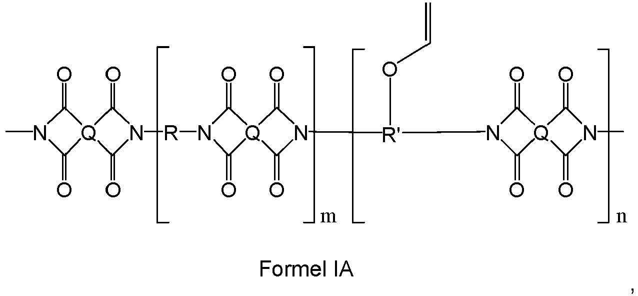 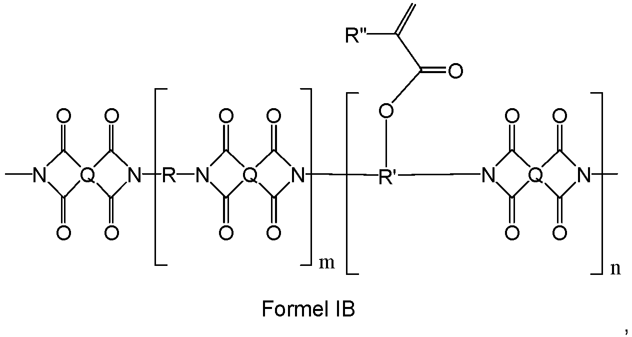 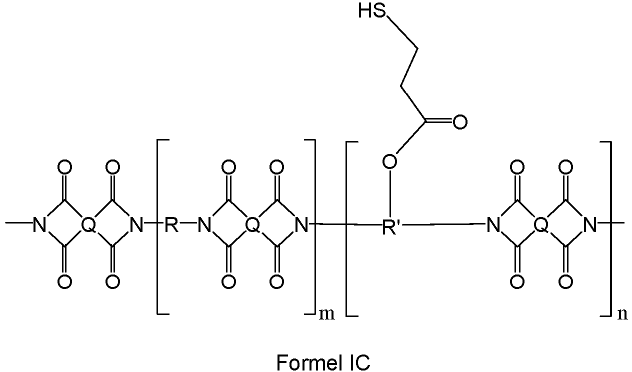 und 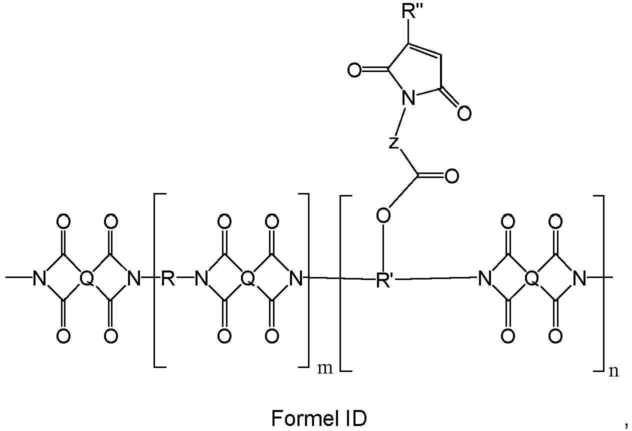 wobei:
R unabhängig ein substituierter oder nichtsubstituierter aliphatischer, cycloaliphatischer, Alkenyl-, Polyether-, Polyester-, Polyamid-, aromatischer, heteroaromatischer oder Siloxananteil ist;
R' unabhängig ein Diamin ist, das einen Alkoholanteil enthält;
jedes Q unabhängig ein substituierter oder nichtsubstituierter aliphatischer, cycloaliphatischer, Alkenyl-, Polyether-, Polyester-, Polyamid-, aromatischer, heteroaromatischer oder Siloxananteil ist;
jedes R" H oder Methyl ist;
z unabhängig ein substituierter oder nichtsubstituierter Alkyl- oder aromatischer Anteil ist; und
n und m ganze Zahlen mit einem Wert von 10 bis 100 sind, mit der Maßgabe, dass das mittlere Molekulargewicht des härtbaren Polyimids, bestimmt durch Gelpermeationschromatographie, größer als 20 000 Dalton ist,
wobei das härtbare, funktionalisierte Polyimid das Produkt von Folgendem ist: einer Kondensation mindestens eines Diamins, ausgewählt aus 1,3-Diamino-2-propanol und
3,5-Diaminobenzylalkohol, mit mindestens einem Dianhydrid, ausgewählt aus der Gruppe, bestehend aus: 4,4'-Bisphenol-A-dianhydrid; Pyromellithsäuredianhydrid;
3,3',4,4'-Benzophenontetracarbonsäuredianhydrid; und 4,4'-Oxydiphthalsäureanhydrid, was in der Bildung eines Seitengruppenalkohols resultiert, gefolgt vom Funktionalisieren der Alkoholseitengruppe.

2. Ein Verfahren zum Synthetisieren eines härtbaren, funktionalisierten Polyimids gemäß Anspruch 1, das die folgenden Schritte beinhaltet:
a) Auflösen mindestens eines Diamins in einem Lösungsmittel bei Raumtemperatur, wobei das mindestens eine Diamin aus 1,3-Diamino-2-propanol und 3,5-Diaminobenzylalkohol ausgewählt ist;
b) Zugeben mindestens eines Dianhydrids, wobei die Gesamtmenge des mindestens einen Dianhydrids ungefähr ein Moläquivalent der Gesamtmenge des mindestens einen Diamins beträgt und wobei das mindestens eine Dianhydrid ausgewählt ist aus der Gruppe, bestehend aus: 4,4'-Bisphenol-A-dianhydrid; Pyromellithsäuredianhydrid; 3,3',4,4'-Benzophenontetracarbonsäuredianhydrid; und 4,4'-Oxydiphthalsäureanhydrid;
c) langsames Erhitzen der Mischung über 1 Stunde zum Reflux, dadurch Produzieren von einem imidisierten Polymer und Wasser;
d) Refluxieren der Mischung, während das Wasser entfernt wird, über etwa eine bis etwa zwei Stunden oder bis alles produzierte Wasser entfernt worden ist, wobei das mittlere Molekulargewicht des Polyimids größer als 20 000 Dalton ist, wobei das Polyimid mindestens einen Seitengruppenalkoholanteil beinhaltet; und
e) Reagierenlassen des Seitengruppenalkohols, um ein funktionalisiertes Polyimid mit polymerisierbaren Seitengruppenanteilen zu produzieren.

3. Verfahren gemäß Anspruch 2, wobei das Lösungsmittel ein aromatisches Lösungsmittel ist.

4. Verfahren gemäß Anspruch 3, wobei das aromatische Lösungsmittel Anisol beinhaltet.

5. Verfahren gemäß Anspruch 2, wobei Schritt e), Reagierenlassen des Seitengruppenalkohols, Folgendes beinhaltet:
i) Katalysieren der Reaktion der Alkoholgruppen mit einem polymergebundenen Säurekatalysator und
ii) Entfernen des polymergebundenen Katalysators durch Filtration.

6. Eine Klebstoffformulierung, die ein härtbares, funktionalisiertes Polyimid gemäß Anspruch 1 beinhaltet.

7. Klebstoff gemäß Anspruch 6, wobei der Klebstoff entfernbar ist.

8. Ein Gegenstand, der auf mindestens einem Teil einer Oberfläche mit der Klebstoffformulierung gemäß Anspruch 6 beschichtet ist, wobei der Gegenstand optional ein abgedünnter oder nicht abgedünnter Wafer, ein strukturierter oder nicht strukturierter Chip oder eine Elektronikeinheit ist.

9. Eine Formulierung, die Folgendes beinhaltet:
a) mindestens ein härtbares, funktionalisiertes Polyimid gemäß Anspruch 1,
b) mindestens einen Reaktivverdünner;
c) ein Lösungsmittel, in dem das härtbare, funktionalisierte Polyimid lösbar ist; und optional mindestens einen Haftvermittler, mindestens ein Kopplungsmittel, mindestens einen UV-Initiator oder eine Kombination davon.

10. Formulierung gemäß Anspruch 9, wobei die Formulierung eine Beschichtung, eine Passivierungsschicht oder eine Umverteilungsschicht, die eine Metallisierung zwischen zwei Schichten der Formulierung beinhaltet, ist.

11. Ein Prepreg, das einen mit einer Formulierung gemäß Anspruch 10 imprägnierten Faserträger beinhaltet.

12. Ein kupferkaschiertes Laminat oder ein biegsames kupferkaschiertes Laminat, das Kupferfolie beinhaltet, die an eine Oberfläche oder beide Oberflächen des Prepregs gemäß Anspruch 11 laminiert ist, oder eine Leiterplatte, die das kupferkaschierte Laminat beinhaltet.

13. Eine UV-härtbare Zusammensetzung, die Folgendes beinhaltet:
a) mindestens ein härtbares, funktionalisiertes Polyimid gemäß Anspruch 1; und
b) mindestens einen Reaktivverdünner.

14. Härtbares, funktionalisiertes Polyimid gemäß Anspruch 1, ausgewählt aus der Gruppe, bestehend aus:

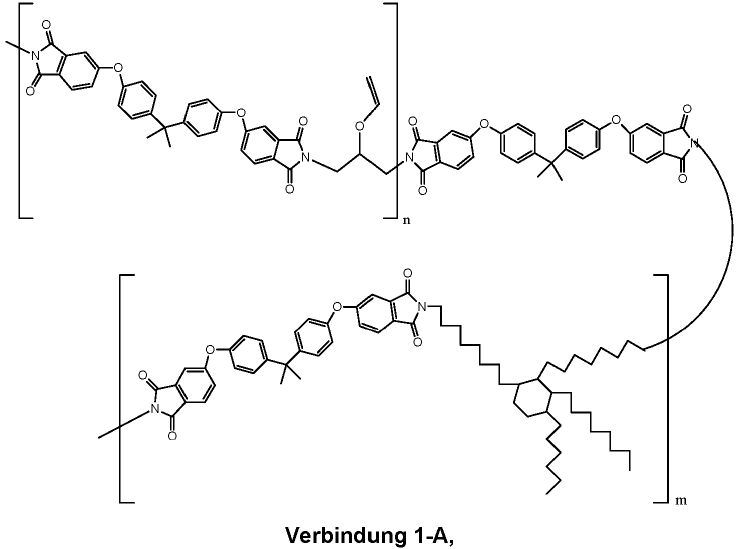

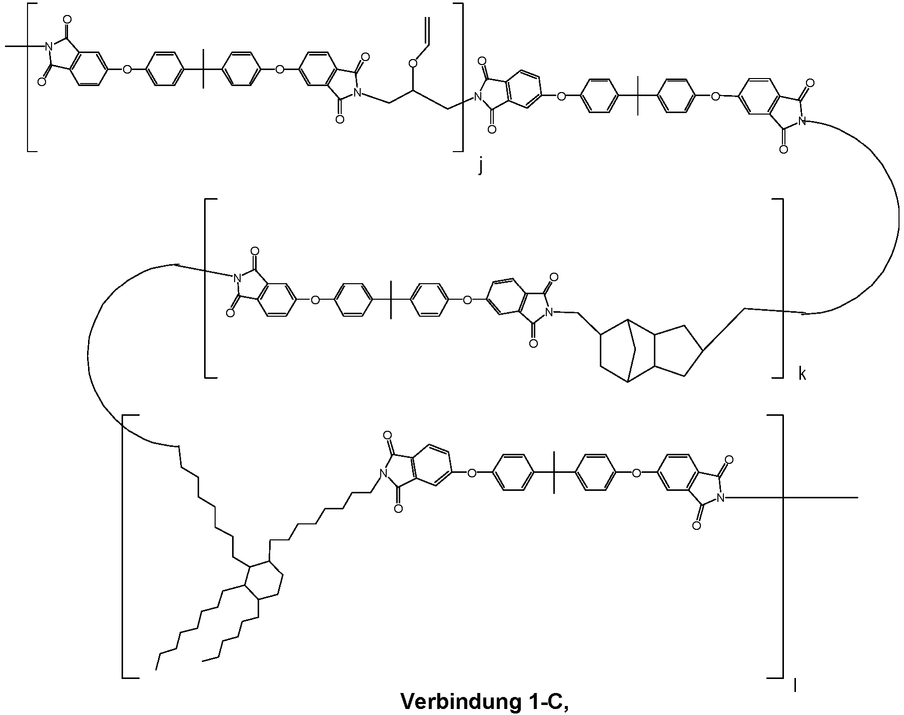

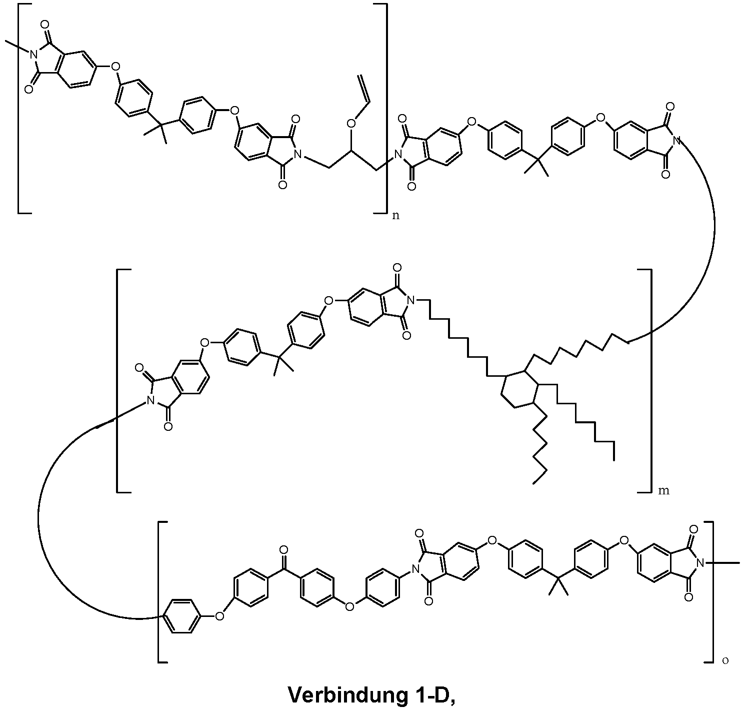

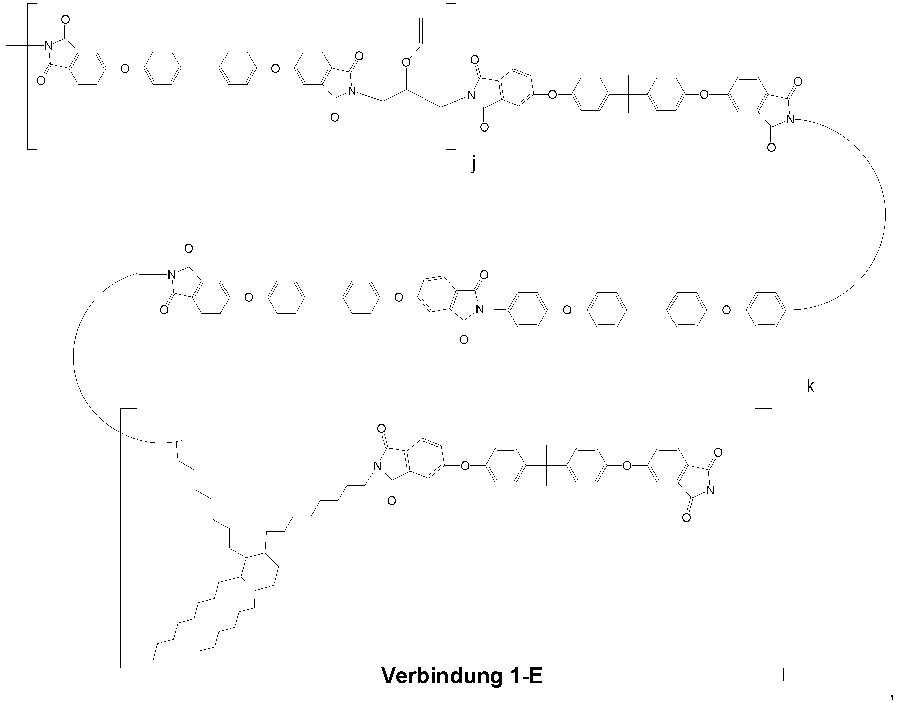

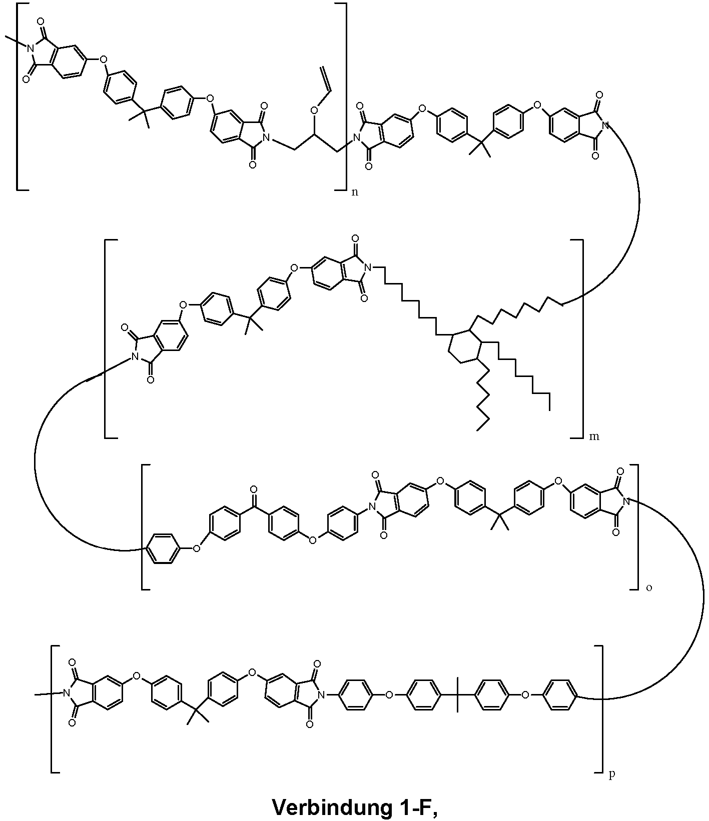

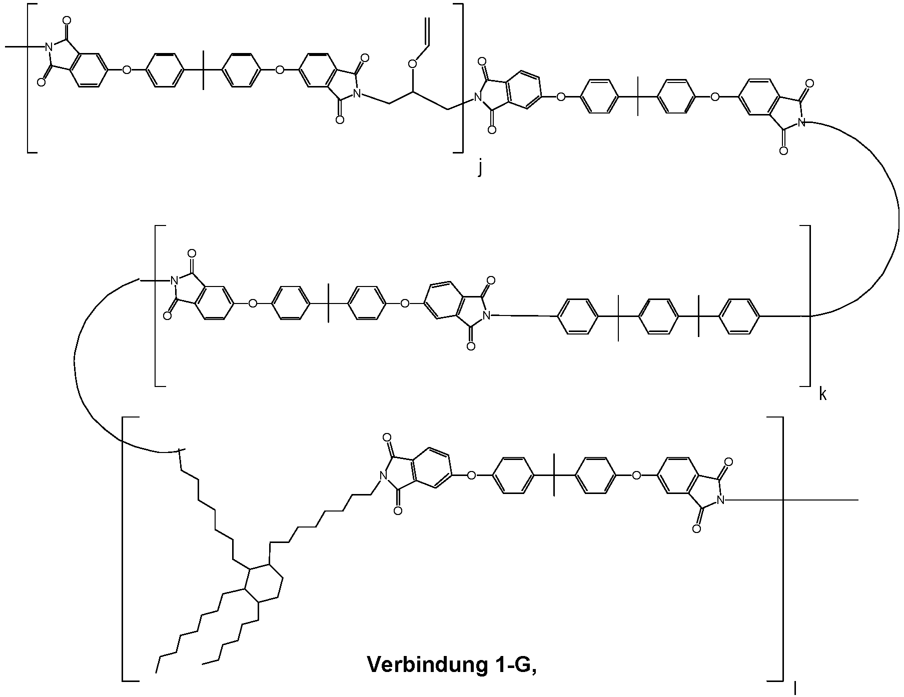

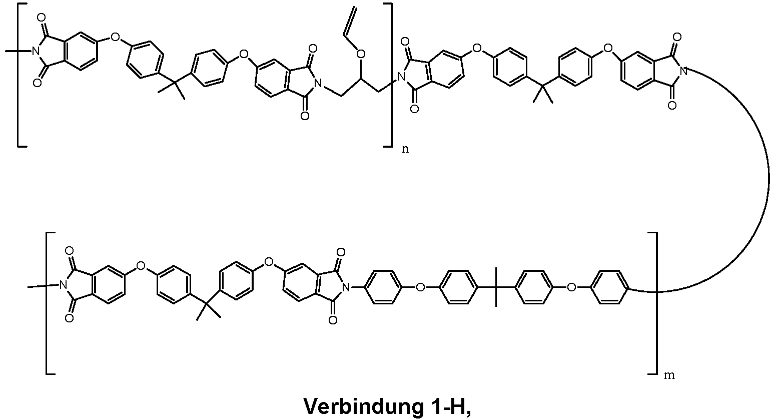

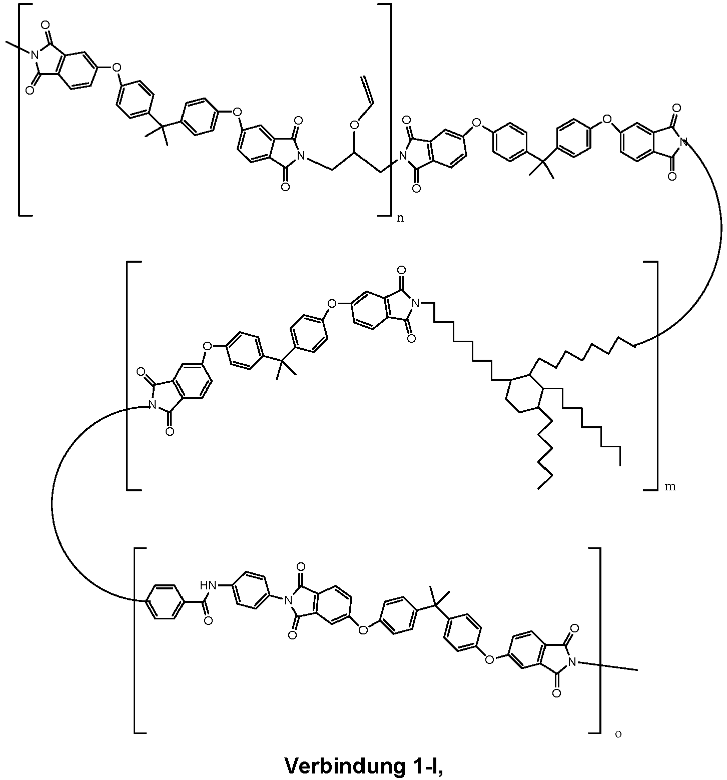

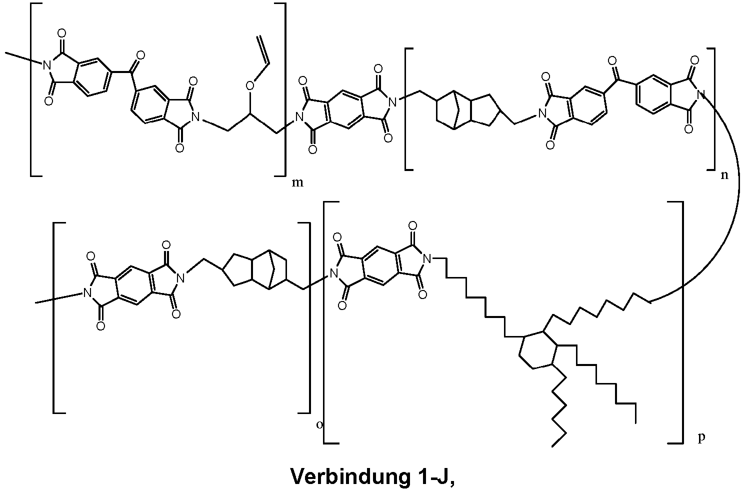

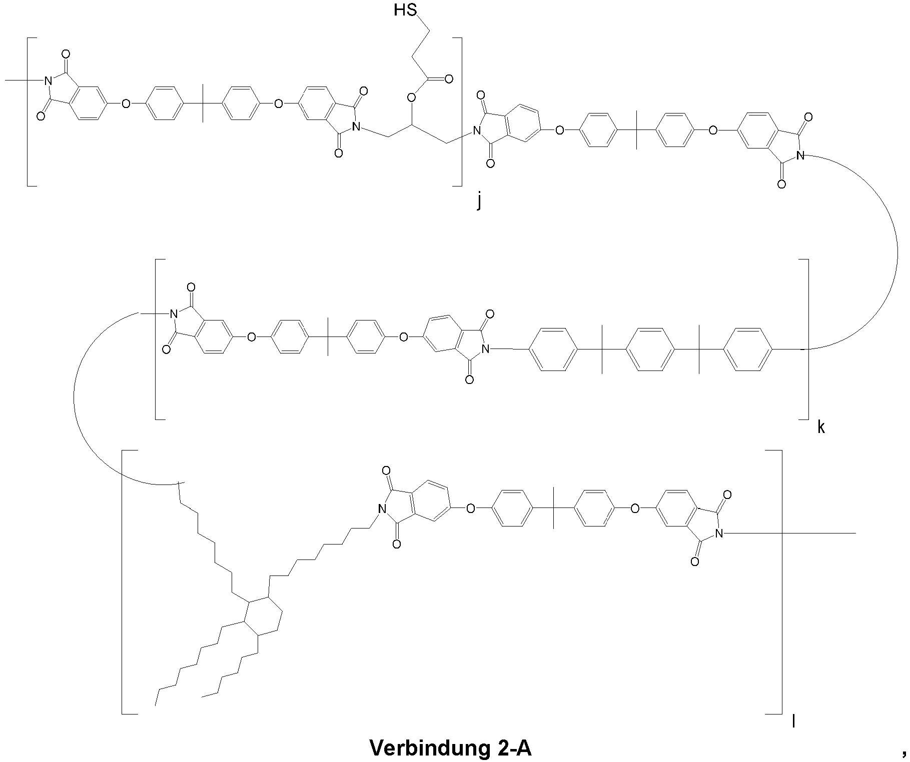

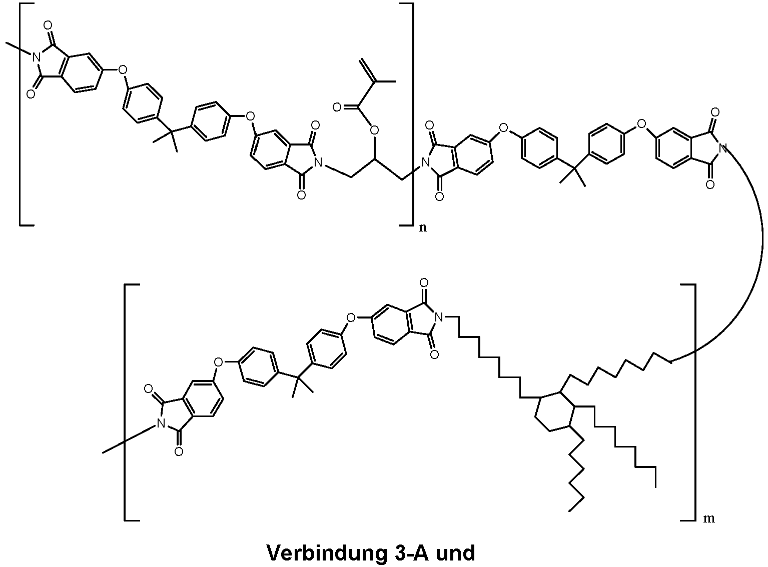

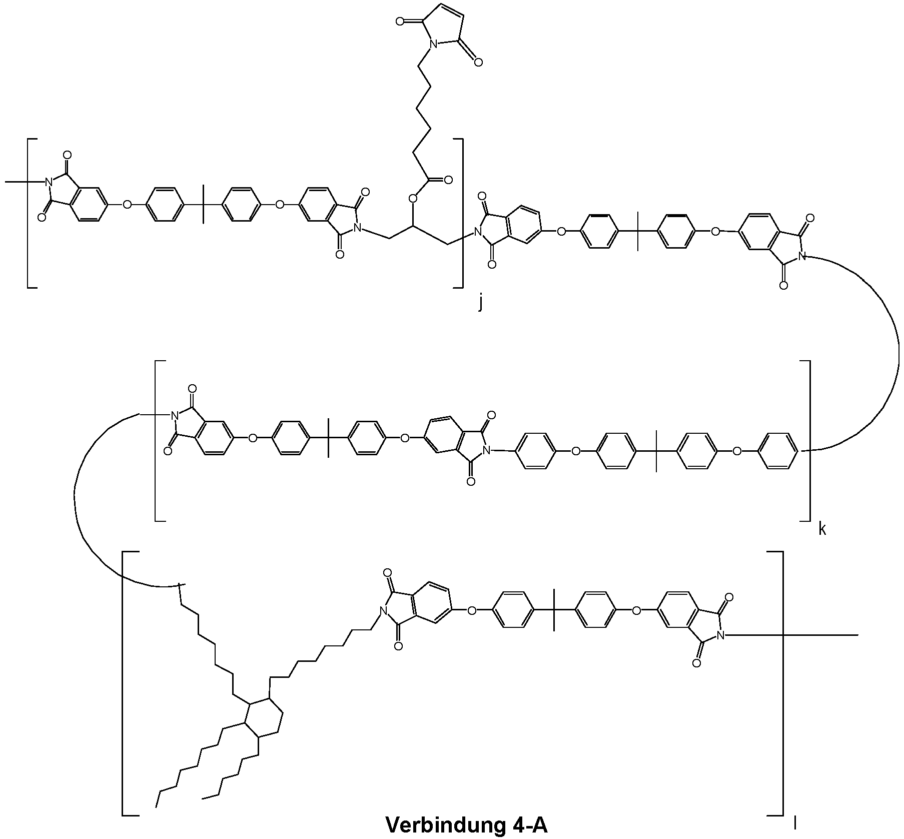

## Revendications

1. Un polyimide fonctionnalisé durcissable ayant une structure selon l'une quelconque des Formules **IA, IB, IC** et **ID** : 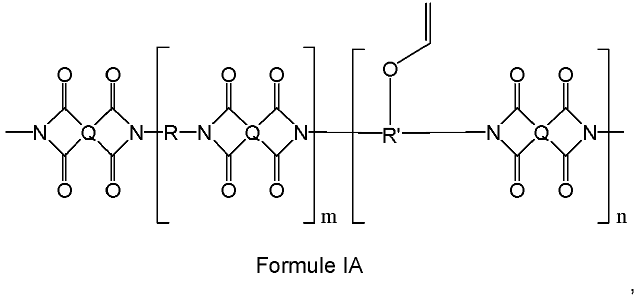 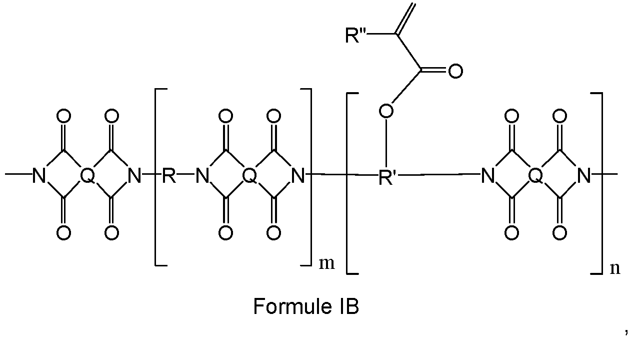 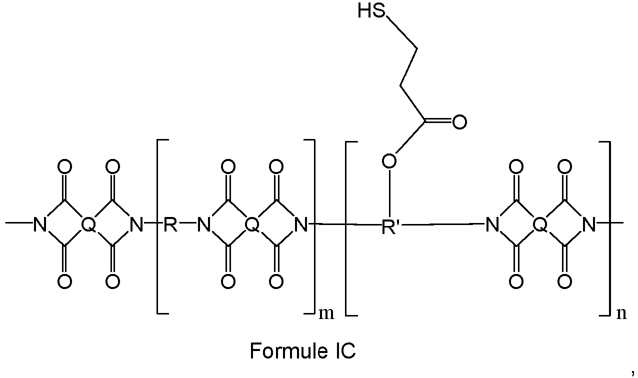 et 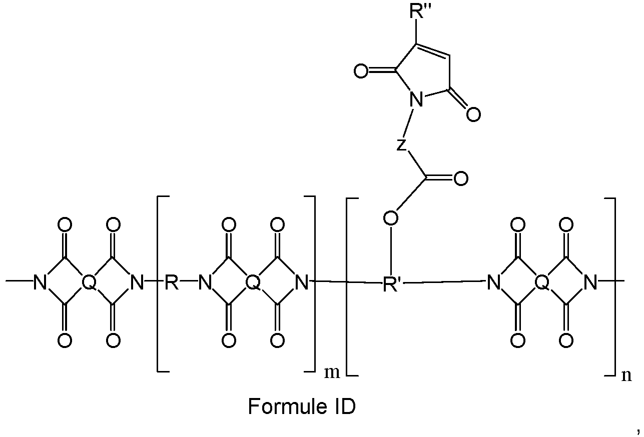 où :
R est indépendamment un groupement aliphatique, cycloaliphatique, alcényle, polyéther, polyester, polyamide, aromatique, hétéroaromatique, ou siloxane, substitué ou non substitué ;
R' est indépendamment une diamine qui contient un groupement alcool ;
chaque Q est indépendamment un groupement aliphatique, cycloaliphatique, alcényle, polyéther, polyester, polyamide, aromatique, hétéroaromatique, ou siloxane, substitué ou non substitué ;
chaque R" est H ou un méthyle ;
z est indépendamment un groupement alkyle ou aromatique substitué ou non substitué ; et
n et m sont des entiers ayant une valeur valant de 10 à 100, à la condition que le poids moléculaire moyen de polyimide durcissable soit supérieur à 20 000 Daltons déterminé par chromatographie par perméation sur gel,
le polyimide fonctionnalisé durcissable étant le produit d'une condensation d'au moins une diamine sélectionnée parmi le 1,3-diamino-2-propanol et le 3,5-alcool diaminobenzylique, avec au moins un dianhydride sélectionné dans le groupe constitué : du 4,4'-dianhydride bisphénol A ; du dianhydride pyromellitique ;
du 3,3',4,4'-dianhydride benzophénone tétracarboxylique ; et du 4,4'-anhydride oxydiphtalique, résultant en la formation d'un alcool latéral, suivi par le fait de fonctionnaliser le groupe alcool latéral.

2. Un procédé pour synthétiser un polyimide fonctionnalisé durcissable de la revendication 1, comprenant les étapes consistant à :
a) dissoudre au moins une diamine dans un solvant à température ambiante, l'au moins une diamine étant sélectionnée parmi le 1,3-diamino-2-propanol et le 3,5-alcool diaminobenzylique ;
b) ajouter au moins un dianhydride, où la quantité totale de l'au moins un dianhydride est approximativement un équivalent molaire de la quantité totale de l'au moins une diamine, et où l'au moins un dianhydride est sélectionné dans le groupe constitué : du 4,4'-dianhydride bisphénol A ; du dianhydride pyromellitique ; du 3,3',4,4'-dianhydride benzophénone tétracarboxylique ; et du 4,4'-anhydride oxydiphtalique ;
c) chauffer lentement pendant une heure le mélange jusqu'au reflux, produisant ainsi un polymère imidizé et de l'eau ;
d) faire refluer le mélange tout en retirant l'eau, pendant d'environ une à environ deux heures, ou jusqu'à ce que toute l'eau produite ait été retirée, où le poids moléculaire moyen du polyimide est supérieur à 20 000 Daltons, le polyimide comprenant au moins un groupement alcool latéral ; et
e) faire réagir l'alcool latéral afin de produire un polyimide fonctionnalisé avec des groupements latéraux polymérisables.

3. Un procédé selon la revendication 2, où le solvant est un solvant aromatique.

4. Un procédé selon la revendication 3, où le solvant aromatique comprend de l'anisole.

5. Le procédé selon la revendication 2, où l'étape e), consistant à faire réagir l'acool latéral, comprend le fait de :
i) catalyser la réaction des groupes alcool avec un catalyseur acide à liaison polymère, et
ii) retirer le catalyseur à liaison polymère par filtration.

6. Une formulation d'adhésif comprenant un polyimide fonctionnalisé durcissable selon la revendication 1.

7. Un adhésif selon la revendication 6, l'adhésif pouvant être retiré.

8. Un article revêtu sur au moins une partie d'une surface avec la formulation d'adhésif selon la revendication 6, l'article étant facultativement une plaquette amincie ou non amincie, une puce à motifs ou non à motifs, ou un bloc électronique.

9. Une formulation comprenant :
a) au moins un polyimide fonctionnalisé durcissable selon la revendication 1,
b) au moins un diluant réactif ;
c) un solvant dans lequel le polyimide fonctionnalisé durcissable est soluble ; et facultativement, au moins un promoteur d'adhérence, au moins un agent de couplage, au moins un initiateur UV, ou une combinaison de ceux-ci.

10. Une formulation selon la revendication 9, la formulation étant un revêtement, une couche de passivation, ou une couche de redistribution comprenant une métallisation entre deux couches de la formulation.

11. Un préimprégné comprenant un support à fibres imprégné avec une formulation de la revendication 10.

12. Un stratifié recouvert de cuivre ou un stratifié recouvert de cuivre souple comprenant une feuille de cuivre stratifiée sur une surface ou les deux surfaces du préimprégné selon la revendication 11 ou une carte de circuits imprimés comprenant le stratifié recouvert de cuivre.

13. Une composition durcissable par UV comprenant :
a) au moins un polyimide fonctionnalisé durcissable selon la revendication 1 ; et
b) au moins un diluant réactif.

14. Un polyimide fonctionnalisé durcissable selon la revendication 1, sélectionné dans le groupe constitué des :
